# EUROPEAN PATENT SPECIFICATION

(11) **EP 4 468 845 B1**
(45) Date of publication and mention of the grant of the patent: **26.11.2025**
(21) Application number: 23794754.4
(22) Date of filing: 01.03.2023
(51) Int. Cl.: H10K 59/121, G09G 3/3225, H10K 59/131, H10K 59/35, H10K 59/65

(54) **DISPLAY PANEL AND DISPLAY APPARATUS**
ANZEIGETAFEL UND ANZEIGEVORRICHTUNG
PANNEAU D'AFFICHAGE ET APPAREIL D'AFFICHAGE

(30) Priority: 29.04.2022 CN 202210468937
(43) Date of publication of application: 27.11.2024
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: LIU, Ke, Beijing 100176 (CN); FANG, Fei, Beijing 100176 (CN); SHI, Ling, Beijing 100176 (CN); GUO, Dan, Beijing 100176 (CN); DING, Xiaoqi, Beijing 100176 (CN)
(74) Representative: Hoffmann Eitle
(86) International application number: PCT/CN2023/078983
(87) International publication number: WO 2023/207318

(56) References cited:
- AU-A1- 2019 279 968
- CN-A- 112 673 475
- CN-A- 113 257 885
- CN-A- 113 674 693
- CN-A- 113 809 141
- CN-U- 217 606 820
- US-B2- 10 565 918

## Description

This application claims priority to Chinese Patent Application No. 202210468937.6, filed on April 29, 2022.

### TECHNICAL FIELD

The present disclosure relates to the field of display technologies, and in particular, to a display panel and a display apparatus.

### BACKGROUND

At present, organic light-emitting diode (OLED) display apparatuses have been widely used due to characteristics thereof such as self-luminescence, quick response, wide viewing angle, being capable of being manufactured on flexible substrates. The OLED display apparatus includes a plurality of pixels, each pixel includes a pixel driving circuit and a light-emitting device, and the light-emitting device is driven to emit light by the pixel driving circuit, thereby realizing the display. Document AU2019279968 (A1) discloses a display panel comprising plurality of pixels including a pixel driving circuit and a light-emitting device, wherein the pixel driving circuit includes a reset transistor.

### SUMMARY

In an aspect, a display panel is provided. The display panel includes a substrate and a plurality of first pixel units. The plurality of first pixel units are located on a side of the substrate and arranged in a plurality of rows and a plurality of columns. A first pixel unit includes a plurality of sub-pixel; a sub-pixel includes a pixel driving circuit and a light-emitting device, the light-emitting device is located on a side of the pixel driving circuit away from the substrate and is electrically connected to the pixel driving circuit; the pixel driving circuit includes a first reset transistor.

The plurality of sub-pixels include a first sub-pixel, a second sub-pixel and a third sub-pixel; an area of a light-emitting device of the first sub-pixel is greater than an area of a light-emitting device of the second sub-pixel and greater than an area of a light-emitting device of the third sub-pixel.

An orthographic projection of a first reset transistor of the second sub-pixel and/or a first reset transistor of the third sub-pixel on the substrate is located within an orthographic projection of the light-emitting device of the first sub-pixel on the substrate.

In some embodiments, orthographic projections of the first reset transistor of the first sub-pixel, the first reset transistor of the second sub-pixel and the first reset transistor of the third sub-pixel on the substrate are all located within the orthographic projection of the light-emitting device of the first sub-pixel on the substrate.

In some embodiments, at least two of the first reset transistor of the first sub-pixel, the first reset transistor of the second sub-pixel, and the first reset transistor of the third sub-pixel are a same transistor.

In some embodiments, the pixel driving circuit further includes a second reset transistor; a second reset transistor of the first sub-pixel, a second reset transistor of the second sub-pixel and a second reset transistor of the third sub-pixel are a same transistor; an orthographic projection of the second reset transistor on the substrate is located within the orthographic projection of the light-emitting device of the first sub-pixel on the substrate; the second reset transistor is connected to any first reset transistor in series.

The display panel further includes a reset signal line and an initialization signal line; a control electrode of each first reset transistor and a control electrode of the second reset transistor are all electrically connected to the reset signal line; a first electrode of the second reset transistor is electrically connected to the initialization signal line, and a second electrode of the second reset transistor is electrically connected to the first electrode of each first reset transistor.

The pixel driving circuit further includes a driving transistor, and a control electrode of a driving transistor of each pixel driving circuit is electrically connected to a second electrode of each first reset transistor.

In some embodiments, the light-emitting device of the second sub-pixel and the light-emitting device of the third sub-pixel are arranged spaced apart in a column direction; the light-emitting device of the first sub-pixel is located in a column adjacent to a column where the light-emitting device of the second sub-pixel and the light-emitting device of the third sub-pixel are located, and the light-emitting device of the first sub-pixel spans a gap region between the light-emitting device of the second sub-pixel and the light-emitting device of the third sub-pixel.

The pixel driving circuit further includes a circuit body, the circuit body includes the driving transistor; an orthographic projection of a circuit body of the first sub-pixel on the substrate is located within the orthographic projection of the light-emitting device of the first sub-pixel on the substrate, an orthographic projection of a circuit body of the second sub-pixel on the substrate is located within an orthographic projection of the light-emitting device of the second sub-pixel on the substrate, and an orthographic projection of a circuit body of the third sub-pixel on the substrate is within an orthographic projection of the light-emitting device of the third sub-pixel on the substrate.

In some embodiments, the second reset transistor, the first reset transistor of the third sub-pixel and the first reset transistor of the second sub-pixel are located on a side of the first reset transistor of the first sub-pixel proximate to the circuit body of the third sub-pixel, and are arranged in sequence away from the circuit body of the third sub-pixel.

In some embodiments, the reset signal line extends in a row direction, and the reset signal line is electrically connected to control electrodes of second reset transistors and control electrodes of first reset transistors in a row of first pixel units. The initialization signal line extends in the row direction, and the initialization signal line is electrically connected to first electrodes of the second reset transistors in the row of first pixel units.

In some embodiments, orthographic projections of the second reset transistor and each first reset transistor on the substrate are located between an orthographic projection of the initialization signal line electrically connected to the second reset transistor on the substrate and the orthographic projection of the circuit body of the first sub-pixel on the substrate; an orthographic projection of the reset signal line on the substrate is located between the orthographic projection of the initialization signal line on the substrate and the orthographic projection of the circuit body of the first sub-pixel on the substrate.

In some embodiments, the substrate includes a first display region, and the plurality of first pixel units are located in the first display region.

The display panel further includes a plurality of signal lines located between the substrate and the light-emitting device, and a portion of at least one signal line located in the first display region includes a metal line and a transparent connection line that are electrically connected to each other; at least part of an orthographic projection of the metal line on the substrate is located within an orthographic projection of the light-emitting device on the substrate.

In some embodiments, the display panel includes a first gate metal layer and a first transparent wiring layer both located between the substrate and the light-emitting device, and the first transparent wiring layer is located on a side of the first gate metal layer away from the substrate.

The at least one signal line includes the reset signal line, the reset signal line extends in the row direction, and the reset signal line is electrically connected to control electrodes of second reset transistors and control electrodes of first reset transistors in a row of first pixel units.

In some embodiments, a metal line of the reset signal line is located in the first gate metal layer, and at least part of an orthographic projection of the metal line of the reset signal line on the substrate is located within the orthographic projection of the light-emitting device of the first sub-pixel on the substrate. A transparent connection line of the reset signal line is located in the first transparent line layer; an orthographic projection of the transparent connection line of the reset signal line on the substrate is located outside the orthographic projection of the light-emitting device of the second sub-pixel on the substrate, and outside the orthographic projection of the light-emitting device of the third sub-pixel on the substrate; the transparent connection line of the reset signal line is connected to the metal line of the reset signal line through a via hole.

In some embodiments, the circuit body of the pixel driving circuit further includes a writing transistor, a compensation transistor and a third reset transistor. The at least one signal line further includes a scan signal line, and the scan signal line is connected to control electrodes of writing transistors, control electrodes of compensation transistors and control electrodes of third reset transistors of all sub-pixels in the row of first pixel units.

A metal line of the scan signal line is located in the first gate metal layer, and at least part of an orthographic projection of the metal line of the scan signal line on the substrate is located within an orthographic projection of the light-emitting device on the substrate. A transparent connection line of the scan signal line is located in the first transparent wiring layer, and the transparent connection line of the scan signal line is connected to the metal line of the scan signal line through a via hole.

In some embodiments, the circuit body of the pixel driving circuit further includes a first light-emitting control transistor and a second light-emitting control transistor. The at least one signal line further includes a light-emitting control signal line, and the light-emitting control signal line is connected to control electrodes of first light-emitting control transistors and control electrodes of second light-emitting control transistors of all the sub-pixels in the row of first pixel units.

A metal line of the light-emitting control signal line is located in the first gate metal layer, and at least part of an orthographic projection of the metal line of the light-emitting control signal line on the substrate is located within the orthographic projection of the light-emitting device on the substrate. A transparent connection line of the light-emitting control signal line is located in the first transparent wiring layer, and the transparent connection line of the light-emitting control signal line is connected to the metal line of the light-emitting control signal line through a via hole.

In some embodiments, the display panel includes a first gate metal layer and a first transparent wiring layer both located between the substrate and the light-emitting device; the first transparent wiring layer being located on a side of the first gate metal layer away from the substrate.

The at least one signal line includes an initialization signal line, the initialization signal line is electrically connected to first electrodes of second reset transistors in a row of first pixel units. A metal line of the initialization signal line is located in the first source-drain metal layer, and at least part of an orthographic projection of the metal line of the initialization signal line on the substrate is located within the orthographic projection of the light-emitting device of the first sub-pixel on the substrate. A transparent connection line of the initialization signal line is located in the first transparent wiring layer; an orthographic projection of the transparent connection line of the initialization signal line on the substrate is located outside the orthographic projection of the light-emitting device of the second sub-pixel on the substrate and outside the orthographic projection of the light-emitting device of the third sub-pixel on the substrate; the transparent connection line of the initialization signal line is connected to the metal line of the initialization signal line through a via hole.

In some embodiments, the display panel includes a second gate metal layer, a second source-drain metal layer and a second transparent wiring layer located between the substrate and the light-emitting device; the second source-drain metal layer is located on a side of the second gate metal layer away from the substrate, and the second transparent wiring layer is located on a side of the second source-drain metal layer away from the second gate metal layer. The circuit body of the pixel driving circuit further includes a capacitor, and a first plate of the capacitor is located in the second gate metal layer.

The at least one signal line includes a first power signal line, the first power signal line extends in the column direction, and the first power signal line is connected to first plates of capacitors of second sub-pixels and first plates of capacitors of third sub-pixels in a column of first pixel units.

Metal lines of the first power signal line are located in the second source-drain metal layer, and at least part of orthographic projections of the metal lines of the first power signal line on the substrate is located within the orthographic projections of the light-emitting device of the second sub-pixel and the light-emitting device of the third sub-pixel on the substrate. A transparent connection line of the first power signal line is located in the second transparent wiring layer, and the transparent connection line of the first power signal line is connected to the metal lines of the first power signal line through via holes.

In some embodiments, the at least one signal line further includes a second power signal line, the second power signal line extends in the column direction, and the second power signal lines is connected to first plates of capacitors of first sub-pixels in the column of first pixel units.

A metal line of the second power signal line is located in the second source-drain metal layer, and an orthographic projection of the metal line of the second power signal line on the substrate is at least partially located within the orthographic projection of the light-emitting device of the first sub-pixel on the substrate. A transparent connection line of the second power signal line is located in the second transparent wiring layer, and the transparent connection line of the second power signal line is connected to the metal line of the second power signal line through a via hole.

In some embodiments, the display panel further includes a plurality of data lines each extending in the column direction; orthographic projections of portions of the plurality of data lines located in the first display region on the substrate are located outside an orthographic projection of a light-emitting device of any sub-pixel on the substrate, and a portion of at least one data line located in the first display region is located in the second transparent wiring layer.

The circuit body of the pixel driving circuit further includes a writing transistor; in the first pixel unit, a first electrode of a writing transistor of the first sub-pixel, a first electrode of a writing transistor of the second sub-pixel, and a first electrode of a writing transistor of the third sub-pixel are respectively connected to different data lines.

In some embodiments, the portion of the at least one data line located in the first display region is a transparent line segment.

In a same column of first pixel units, an orthographic projection of a transparent line segment of a data line electrically connected to a writing transistor of a first sub-pixel on the substrate is located on a side of an orthographic projection of a circuit body of the first sub-pixel on the substrate away form an orthographic projection of a circuit body of a second sub-pixel on the substrate, and an orthographic projection of a light-emitting device of the second sub-pixel on the substrate and an orthographic projection of a light-emitting device of a third sub-pixel on the substrate are located between an orthographic projection of a transparent line segment of a data line electrically connected to a writing transistor of the second sub-pixel on the substrate and an orthographic projection of a transparent line segment of a data line electrically connected to a writing transistor of the third sub-pixel on the substrate.

In some embodiments, the circuit body of the pixel driving circuit further includes a compensation transistor and a third reset transistor.

In the first pixel unit, a third reset transistor, a compensation transistor and a writing transistor of the first sub-pixel are sequentially away from a circuit body of the second sub-pixel; a writing transistor, a compensation transistor and a third reset transistor of the second sub-pixel are sequentially arranged in a first set direction; a writing transistor, a compensation transistor and a third reset transistor of the third sub-pixel are sequentially arranged in an opposite direction of the first set direction.

In some embodiments, the light-emitting device includes an anode, a light-emitting layer and a cathode, the anode is electrically connected to the pixel driving circuit, the light-emitting layer is located on a side of the anode away from the substrate, and the cathode is located on a side of the anode away from the substrate. The orthographic projection of the first reset transistor of the second sub-pixel and/or the first reset transistor of the third sub-pixel on the substrate is located within an orthographic projection of an anode of the first sub-pixel on the substrate.

In some embodiments, the display panel includes a first display region and a second display region, and the first display region is provided with the first pixel units. The second display region is provided with a plurality of second pixel units, the plurality of second pixel units are arranged in a plurality of rows and a plurality of columns; a second pixel unit includes a plurality of sub-pixels, and density of sub-pixels in the first display region is equal to density of sub-pixels in the second display region. An area of a light-emitting device of a sub-pixel in the first display region is 0.4 to 0.6 times an area of a light-emitting device of a sub-pixel of a same color in the second display region.

In another aspect, a display apparatus is provided. The display apparatus includes the display panel as described in any one of the above embodiments.

### BRIEF DESCRIPTION OF THE DRAWINGS

In order to describe technical solutions in the present disclosure more clearly, the accompanying drawings to be used in some embodiments of the present disclosure will be introduced briefly. Obviously, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1A is a structural diagram of a display apparatus, in accordance with some embodiments;
FIG. 1B is a structural diagram of a display apparatus, in accordance with some embodiments;
FIG. 2A is a structural diagram of a display apparatus, in accordance with some embodiments;
FIG. 2B is a structural diagram of a display panel, in accordance with some embodiments;
FIG. 3A is a structural diagram of a display panel, in accordance with some embodiments;
FIG. 3B is a structural diagram of a display panel, in accordance with some embodiments;
FIG. 4A is a structural diagram of a pixel driving unit, in accordance with some embodiments;
FIG. 4B is a timing diagram of a pixel driving unit, in accordance with some embodiments;
FIG. 4C is a structural diagram of a pixel driving unit, in accordance with some embodiments;
FIG. 4D is a structural diagram of a pixel driving unit, in accordance with some embodiments;
FIG. 4E is a structural diagram of a pixel driving unit, in accordance with some embodiments;
FIG. 4F is a structural diagram of a pixel driving unit, in accordance with some embodiments;
FIG. 5A is a structural diagram of a display panel, in accordance with some embodiments;
FIG. 5B is a structural diagram of a display panel, in accordance with some embodiments;
FIG. 5C is a structural diagram of a display panel, in accordance with some embodiments;
FIG. 5D is a structural diagram of a display panel, in accordance with some embodiments;
FIG. 6A is a structural diagram of a display panel, in accordance with some embodiments;
FIG. 6B is a structural diagram of a display panel, in accordance with some embodiments;
FIG. 7A is a structural diagram of a display panel, in accordance with some embodiments;
FIG. 7B is a structural diagram of a display panel, in accordance with some embodiments;
FIG. 7C is a structural diagram of a display panel, in accordance with some embodiments;
FIG. 8A is a structural diagram of a display panel, in accordance with some embodiments;
FIG. 8B is a structural diagram of a display panel, in accordance with some embodiments;
FIG. 9A is a structural diagram of a display panel, in accordance with some embodiments;
FIG. 9B is a structural diagram of a display panel, in accordance with some embodiments;
FIG. 9C is a structural diagram of a display panel, in accordance with some embodiments;
FIG. 10A is a structural diagram of a display panel, in accordance with some embodiments;
FIG. 10B is a structural diagram of a display panel, in accordance with some embodiments;
FIG. 11A is a structural diagram of a display panel, in accordance with some embodiments;
FIG. 11B is a structural diagram of a display panel, in accordance with some embodiments;
FIG. 11C is a structural diagram of a display panel, in accordance with some embodiments;
FIG. 11D is a structural diagram of a display panel, in accordance with some embodiments;
FIG. 11E is a structural diagram of a display panel, in accordance with some embodiments;
FIG. 12A is a structural diagram of a display panel, in accordance with some embodiments;
FIG. 12B is a structural diagram of a display panel, in accordance with some embodiments;
FIG. 12C is a structural diagram of a display panel, in accordance with some embodiments;
FIG. 13A is a structural diagram of a display panel, in accordance with some embodiments;
FIG. 13B is a structural diagram of a display panel, in accordance with some embodiments; and
FIG. 14 is a structural diagram of a display panel, in accordance with some embodiments.

### DETAILED DESCRIPTION

The technical solutions in embodiments of the present disclosure will be described clearly and completely with reference to the accompanying drawings. Obviously, the described embodiments are merely some but not all of embodiments of the present disclosure. All other embodiments obtained on the basis of the embodiments of the present disclosure by a person of ordinary skill in the art shall be included in the protection scope of the present disclosure.

Unless the context requires otherwise, throughout the description and claims, the term "comprise" and other forms thereof such as the third-person singular form "comprises" and the present participle form "comprising" are construed as an open and inclusive meaning, i.e., "included, but not limited to". In the description of the specification, the terms such as "some embodiments", "example", or "some examples" are intended to indicate that specific features, structures, materials or characteristics related to the embodiment(s) or example(s) are included in at least one embodiment or example of the present disclosure. Schematic representations of the above term do not necessarily refer to the same embodiment(s) or example(s). In addition, specific features, structures, materials or characteristics may be included in any one or more embodiments or examples in any suitable manner.

Hereinafter, the terms "first" and "second" are only used for descriptive purposes, and are not to be construed as indicating or implying relative importance or implicitly indicating the number of indicated technical features. Thus, a feature defined with "first" or "second" may explicitly or implicitly include one or more of the features. In the description of the embodiments of the present disclosure, the term "a plurality of" or "the plurality of" means two or more unless otherwise specified.

Some embodiments may be described using the term "connected" and its derivatives. For example, the term "connected" may be used in the description of some embodiments to indicate that two or more components are in direct physical or electrical contact with each other.

The phrase "A and/or B" includes the following three combinations: only A, only B, and a combination of A and B.

As used herein, the term "if" is optionally construed as "when" or "in a case where".

The phrase "configured to" used herein means an open and inclusive expression, which does not exclude devices that are applicable to or configured to perform additional tasks or steps.

In addition, the use of the phrase "based on" means openness and inclusiveness, since a process, step, calculation or other action that is "based on" one or more of the stated conditions or values may, in practice, be based on additional conditions or values exceeding those stated.

In the description of some embodiments, the expressions "'a certain structure" is disposed under the anode', or "'a certain structure" is located under the anode', or "'a certain structure" is hidden under the anode' may be used, which means that an orthographic projection of a certain structure on the substrate is within an orthographic projection of the anode on the substrate.

In the description of some embodiments, the expression "area of a certain structure" may be used, which refers to an area of an orthographic projection of the certain structure on the substrate.

The term such as "substantially" or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular" or "equal" as used herein includes a stated case and a case similar to the stated case within an acceptable range of deviation determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, that a difference between two equals is less than or equal to 5% of either of the two equals.

**It** will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views as idealized exemplary drawings. **In** the drawings, thicknesses of layers and sizes of regions are enlarged for clarity. Variations in shapes relative to the accompanying drawings due to, for example, manufacturing technologies and/or tolerances may be envisaged. Therefore, the exemplary embodiments should not be construed to be limited to the shapes of regions shown herein, but to include deviations in the shapes due to, for example, manufacturing. For example, an etched region shown in a rectangular shape generally has a feature of being curved. Therefore, the regions shown in the accompanying drawings are schematic in nature, and their shapes are not intended to show actual shapes of regions in a device, and are not intended to limit the scope of the exemplary embodiments.

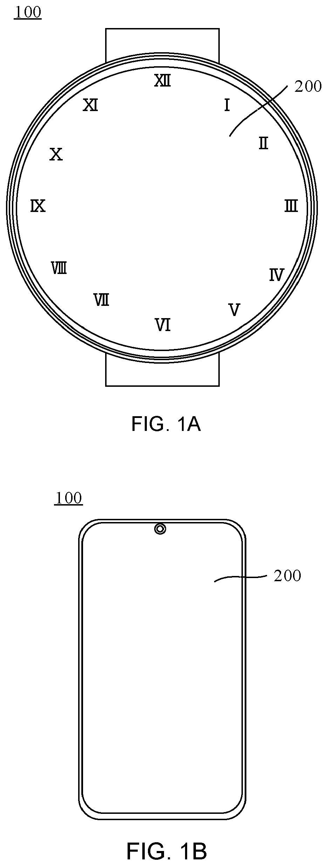

Some embodiments of the present disclosure provide a display apparatus. FIGS. 1A and 1B are each a structural diagram of a display apparatus, in accordance with some embodiments. Referring to FIGS. 1A and **1B****,** the display apparatus 100 is a product having a function of displaying images (including an image in stationary or an image in motion (which may be a video)). For example, the display apparatus 100 may be any one of a watch, a display, a television, a billboard, a digital photo frame, a laser printer having a display function, a telephone, a mobile phone, a personal digital assistant (PDA), a digital camera, a portable camcorder, a view finder, a navigator, a vehicle, a large-area wall, a household appliance, an information inquiry device (e.g., a business inquiry device for a department of e-government, bank, hospital, electricity or the like) and a monitor.

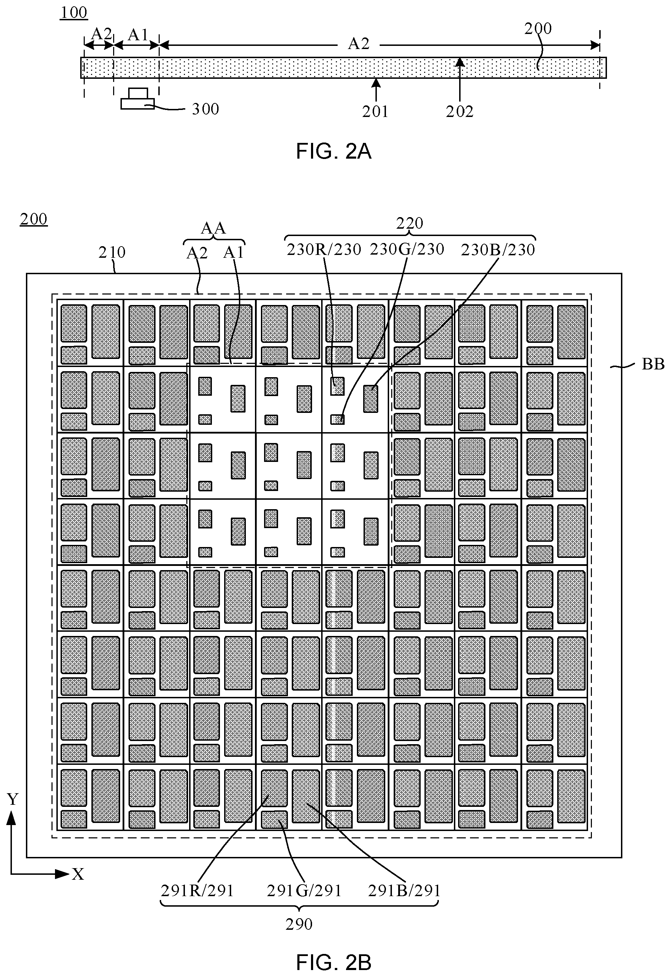

Referring to FIG. 2A, the display apparatus 100 includes a display panel 200 and a sensor 300.

Some embodiments of the present disclosure provide a display panel 200, and FIG. 2B is a structural diagram of the display panel in accordance with some embodiments. Referring to FIG. 2B, the display panel 200 includes a display region AA and a peripheral region BB located on at least one side of the display region AA. The display region AA is used for displaying pictures. In some examples, the peripheral region BB may be located on one side or more sides of the display region AA. In some other examples, the peripheral region BB is arranged around the display region AA.

The display panel 200 may be an organic light-emitting diode (OLED) display panel. OLED display panels have the advantages of wide viewing angle, high contrast, fast response, low power consumption, foldability, and flexibility.

Referring to FIG. 2B, the display panel 200 includes a substrate 210 and a plurality of first pixel units 220. The plurality of first pixel units 220 are disposed on a side of the substrate 210, and are arranged in a plurality of rows and a plurality of columns. The first pixel unit 220 includes a plurality of sub-pixel 230. The sub-pixel 230 is the smallest unit of the display panel 200 for image display. Each sub-pixel 230 may display a single color, such as red, green or blue. By adjusting the luminance (gray scale) of sub-pixels of different colors, color combination and superposition may realize display of multiple colors, thereby realizing full-color display of the display panel 200.

In some embodiments, referring to FIG. 2B, the display region AA includes a first display region A1, and multiple first pixel units 220 are disposed in the first display region A1. Referring to FIG. 2A, the display panel 200 includes a backlight side 201 and a display side 202 arranged oppositely, and the display side 202 is used for displaying images. The sensor 300 is disposed on the backlight side 201 of the display panel 200, and is located in the first display region A1 of the display panel 200.

The sensor 300 is, for example, an imaging sensor or infrared sensor. The sensor 300 is configured to receive light from the display side 202 of the display panel 200, so that operations such as image capturing, distance sensing, and light intensity sensing may be performed. The light may transmit the first display region A1 and then illuminate the sensor 300, thereby being sensed by the sensor 300.

By arranging the sensor 300 in the first display region A1 of the display panel 200 and on the backlight side 201 of the display panel, it is possible to avoid digging holes in the display screen to increase the screen-to-body ratio, thereby providing a good visual experience.

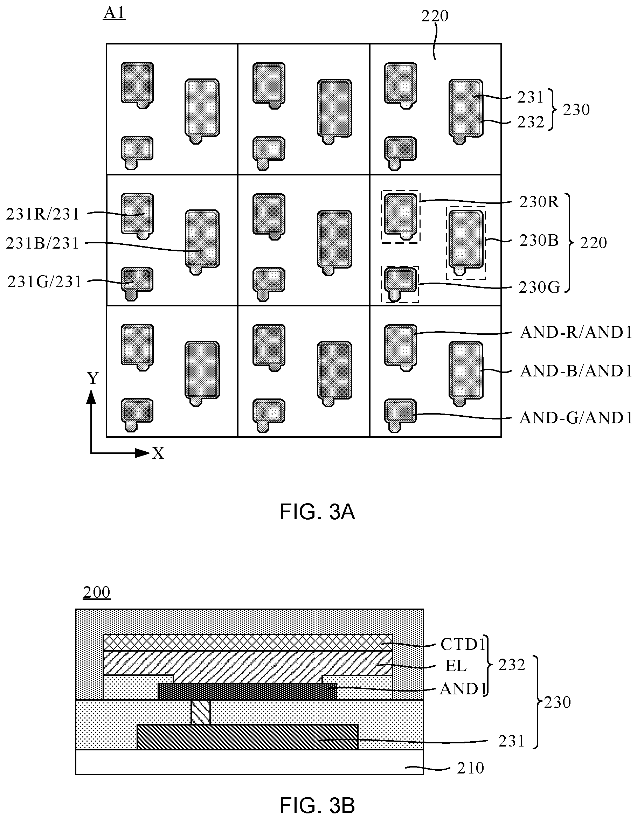

FIG. 3A is a structural diagram of the display panel in the first display region A1, in accordance with some embodiments. Referring to FIG. 3A, the sub-pixel 230 includes a pixel driving circuit 231 and a light-emitting device 232. The light-emitting device 232 is located on a side of the pixel driving circuit 231 away from the substrate 210, and is electrically connected to the pixel driving circuit 231. The pixel driving circuit 231 is used to drive the light-emitting device 232 to emit light.

FIG. 3B is a structural diagram of the display panel, in accordance with some embodiments, and a structure of a sub-pixel is shown in FIG. 3B. Referring to FIG. 3B, the light-emitting device 232 includes an anode AND1, a light-emitting layer EL and a cathode CTD1. The anode AND1 is located on a side of the pixel driving circuit 231 away from the substrate 210, and is electrically connected to the pixel driving circuit 231. The light-emitting layer EL is located on a side of the anode AND1 away from the substrate 210, and the cathode CTD1 is located on a side of the light-emitting layer EL away from the substrate 210. In some embodiments, the light-emitting device 232 further includes one or more of an electron transporting layer (ETL), an electron injection layer (EIL), a hole transporting layer (HTL) and a hole injection layer (HIL).

In some examples, an orthographic projection of the anode AND1 on the substrate 210, an orthographic projection of the light-emitting layer EL on the substrate 210, and an orthographic projection of the cathode CTD1 on the substrate 210 at least partially coincide with one other.

Referring to FIG. 3A, multiple sub-pixels 230 in a single first pixel unit 220 include a first sub-pixel 230B, a second sub-pixel 230G and a third sub-pixel 230R.

In a single first pixel unit 220, an area of the light-emitting device 232 of the first sub-pixel 230B is greater than an area of the light-emitting device 232 of the second sub-pixel 230G, and is greater than an area of the light-emitting device 232 of the third sub-pixel 230R. Correspondingly, referring to FIG. 3A, in a single first pixel unit 220, an area of the anode AND-B of the first sub-pixel 230B is greater than an area of the anode AND-G of the second sub-pixel 230G, and is greater than an area of the anode AND-R of the third sub-pixel 230R. Correspondingly, in a single first pixel unit 220, an area of the light-emitting layer EL of the first sub-pixel 230B is greater than an area of the light-emitting layer EL of the second sub-pixel 230G, and greater than an area of the light-emitting layer EL of the third sub-pixel 230R. Correspondingly, in a single first pixel unit 220, an area of the cathode CTD1 of the first sub-pixel 230B is greater than an area of the cathode CTD1 of the second sub-pixel 230G, and is greater than an area of the cathode CTD1 of the third sub-pixel 230R.

The anode AND1 is in a shape of a block, and the anodes AND1 of different sub-pixels 230 are separated from each other. The light-emitting layer EL is in a shape of a block, and the light-emitting layers EL of different sub-pixels 230 are separated from each other.

In some examples, cathodes CTD1 of the plurality of sub-pixels 230 in the display panel 200 are connected to each other, and the cathodes CTD1 of the multiple sub-pixels 230 constitute a whole-layer structure. In these examples, the area of the cathode CTD1 of one sub-pixel 230 is equal to the area of the light-emitting layer EL or the area of the anode AND1. Furthermore, in these examples, an area of one, whose area is greater, of the light-emitting layer EL and the anode AND1 is the area of the light-emitting device 232. For example, if the area of the orthographic projection of the anode AND1 on the substrate 210 is greater than the area of the orthographic projection of the light-emitting layer EL on the substrate 210, the area of the light-emitting device 232 is the area of the anode AND1. For example, if the area of the orthographic projection of the light-emitting layer EL on the substrate 210 is greater than the area of the orthographic projection of the anode AND1 on the substrate 210, the area of the light-emitting device 232 is the area of the light-emitting layer EL.

In some other examples, the cathode CTD1 is in a shape of a block, and cathodes CTD1 of multiple sub-pixels 230 in the display panel 200 are separated from each other. In this case, an area of one, whose area is the largest, of the cathode CTD1, the light-emitting layer EL and the anode AND1 is the area of the light-emitting device 232. For example, among the cathode CTD1, the light-emitting layer EL and the anode AND1 of the sub-pixel 230, if the area of the cathode CTD1 is the largest, then the area of the light-emitting device 232 is the area of the cathode CTD1; if the area of the anode AND1 is the largest, then the area of the light emitting device 232 is the area of the anode AND1; if the area of the light-emitting layer EL is the largest, then the area of the light-emitting device 232 is the area of the light-emitting layer EL.

For example, in the first pixel unit 220, the first sub-pixel 230B is a blue sub-pixel, the second sub-pixel 230G is a green sub-pixel, and the third sub-pixel 230R is a red sub-pixel.

The light-emitting layer EL includes an effective light-emitting region. In some examples, in the first pixel unit 220, the area of the light-emitting device 232 of the first sub-pixel 230B is greater than the area of the light-emitting device 232 of the second sub-pixel 230G, and is greater than the area of the light-emitting device 232 of the third sub-pixel 230R. Correspondingly, an area of the effective light-emitting region of the first sub-pixel 230B is greater than an area of the effective light-emitting region of the second sub-pixel 230G, and is greater than an area of the effective light-emitting area of the third sub-pixel 230R. The light-emitting layer EL in the light-emitting device 232 includes a light-emitting material. The light-emitting material of the blue sub-pixel has low luminous efficiency. By making the area of the effective light-emitting region of the blue sub-pixel to be largest, the problem of color shift caused by different luminous efficiencies of the red, green and blue sub-pixels may be reduced.

In an implementation, by reducing the area of the light-emitting device 232 of the sub-pixel 230 and hiding the pixel driving circuit 231 under the light-emitting device 232, an area occupied by the sub-pixel 230 in the display panel 200 may be reduced, so that an area of a light-transmissive region may be increased, and the light transmittance of the first display region A1 may be improved. It will be noted that the area of the light-emitting device 232 refers to an area covered by the orthographic projection of the light-emitting device 232 on the substrate 210. The fact that the pixel driving circuit 231 is hidden under the light-emitting device 232 means that the pixel driving circuit 231 is located on a side of the light-emitting device 232 proximate to the substrate 210, and an orthographic projection of the pixel driving circuit 231 on the substrate 210 is located within the orthographic projection of the light-emitting device 232 on substrate 210.

However, since the area of the light-emitting device 232 of the second sub-pixel 230G and the area of the light-emitting device 232 of the third sub-pixel 230R are small, it is difficult to hide the pixel driving circuit 231G of the second sub-pixel 230G under the light-emitting device 232 of the second sub-pixel 230G, and it is difficult to hide the pixel driving circuit 231R of the third sub-pixel 230R under the light-emitting device 232 of the third sub-pixel 230R. If the pixel driving circuit 231 is exposed outside the light-emitting device 232, the light transmittance of the first display region A1 will be reduced and diffraction will be aggravated, which is not conducive to imaging.

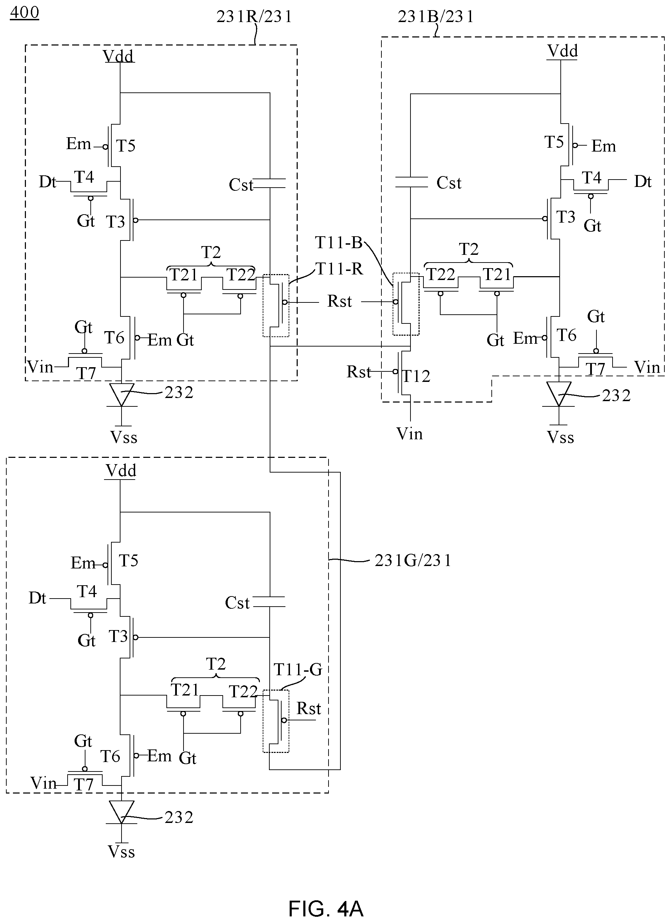

Based on this, the present disclosure provides a pixel driving unit 400. Referring to FIG. 4A, the pixel driving unit 400 includes a plurality of pixel driving circuits 231.

In some embodiments, a structure of the pixel driving circuit in the present disclosure varies, which may be set according to actual needs. For example, the pixel driving circuit 231 may be of a structure with "6T1C", "7T1C", "6T2C", "7T2C" or the like. Here, "T" represents a thin film transistor, a number before "T" represents the number of thin film transistors, "C" represents a storage capacitor, and a number before "C" represents the number of storage capacitors. The following will be described by considering the pixel driving circuit having the structure of 7T1C as an example.

Referring to FIG. 4A, the pixel driving circuit 231 includes a driving transistor T3 and a second reset transistor T12. The second reset transistor T12 is electrically connected to a reset signal terminal Rst, an initialization signal terminal Vin and a control electrode of the driving transistor T3. The second reset transistor T12 is configured to transmit, in response to a reset signal received at the reset signal terminal Rst, an initialization signal received at the initialization signal terminal Vin to the control electrode of the driving transistor T3 to reset the control electrode of the driving transistor T3.

For example, of the second reset transistor T12, a control electrode is electrically connected to the reset signal line Rst, a first electrode is electrically connected to the initialization signal terminal Vin, and a second electrode is electrically connected to the control electrode of the driving transistor T3.

Referring to FIG. 4A, in addition to the second reset transistor T12 and the driving transistor T3, the pixel driving circuit 231 further includes a compensation transistor T2, a writing transistor T4, a first light-emitting control transistor T5, a second light-emitting control transistor T6, a third reset transistor T7 and a capacitor Cst.

A control electrode of the compensation transistor T2 is electrically connected to a scan signal terminal Gt, a first electrode of the compensation transistor T2 is electrically connected to a second electrode of the driving transistor T3, and a second electrode of the compensation transistor T2 is electrically connected to the control electrode of the driving transistor T3.

A control electrode of the writing transistor T4 is electrically connected to the scan signal terminal Gt, a first electrode of the writing transistor T4 is electrically connected to a data signal terminal Dt, and a second electrode of the writing transistor T4 is electrically connected to the first electrode of the driving transistor T3.

A control electrode of the first light-emitting control transistor T5 is electrically connected to a light-emitting control signal terminal Em, a first electrode of the first light-emitting control transistor T5 is electrically connected to a first-type power signal terminal Vdd, and a second electrode of the first light-emitting control transistor T5 is electrically connected to a first electrode of the driving transistor T3.

A control electrode of the second light-emitting control transistor T6 is electrically connected to the light-emitting control signal terminal Em, a first electrode of the second light-emitting control transistor T6 is electrically connected to the second electrode of the driving transistor T3, and a second electrode of the second light-emitting control transistor T6 is electrically connected to the anode of the light-emitting device 232. The cathode of the light-emitting device 232 is electrically connected to a second-type power signal terminal Vss. A voltage of a first-type power signal received at the first-type power signal terminal Vdd is greater than a voltage of a second-type power signal received at the second-type power signal terminal Vss.

A control electrode of the third reset transistor T7 is electrically connected to the scan signal terminal Gt, a first electrode of the third reset transistor T7 is electrically connected to the initialization signal terminal Vin, and a second electrode of the third reset transistor T7 is electrically connected to the anode of the light-emitting device 232.

A first plate of the capacitor Cst is electrically connected to the first-type power signal terminal Vdd, and a second plate of the capacitor Cst is electrically connected to the control electrode of the driving transistor T3.

In some examples, the second reset transistor T12, the compensation transistor T2, the driving transistor T3, the writing transistor T4, the first light-emitting control transistor T5, the second light-emitting control transistor T6, and the third reset transistor T7 are all P-type transistors or N-type transistors. The N-type transistor is turned on when receiving a high voltage signal at the gate, and the P-type transistor is turned on when receiving a low voltage signal at the gate. It will be noted that, the "high voltage signal" and "low voltage signal" mentioned above are common terms. Generally, the conduction condition of the N-type transistor is that a gate-source voltage difference is greater than a threshold voltage thereof, i.e., a gate voltage of the N-type transistor is greater than a sum of a source voltage thereof and the threshold voltage thereof, the threshold voltage of the N-type transistor is positive, then a gate voltage signal that turns on the N-type transistor is referred to as a high-voltage signal; the conduction condition of the P-type transistor is that an absolute value of a gate-source voltage difference is greater than a threshold voltage thereof, and the threshold voltage of the P-type transistor is negative, i.e., a gate voltage of the P-type transistor is less than a sum of a source voltage thereof and the threshold voltage thereof, then a gate voltage signal that turns on the P-type transistor is referred to as a low voltage signal. "High" in the "high voltage signal" and "low" in the "low voltage signal" are relative to the source voltage.

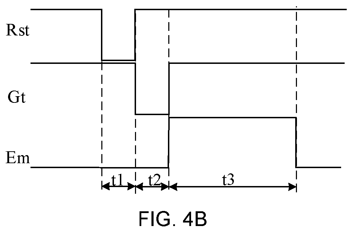

In some examples, referring to FIG. 4A, the second reset transistor T12, the compensation transistor T2, the driving transistor T3, the writing transistor T4, the first light-emitting control transistor T5, the second light-emitting control transistor T6, and the third reset transistor T7 are all P-type transistors. In this case, the timing diagram of the pixel driving circuit 231 is as shown in FIG. 4B.

The driving process of the pixel driving circuit 231 will be described based on the fact that the transistors in the pixel driving circuit 231 are all P-type transistors.

The driving process of the pixel driving circuit is as following: a frame phase including a reset period t1, a data refresh and compensation period t2, and a light-emitting period t3.

In the reset period t1, the reset signal is a low voltage. In this case, the second reset transistor T12 is turned on, and the second reset transistor T12 transmits the initialization signal to the control electrode of the driving transistor T3 to reset the control electrode of the driving transistor T3; in this case, the driving transistor T3 is turned on, and the compensation transistor T2, the writing transistor T4, the first light-emitting control transistor T5, the second light-emitting control transistor T6, and the third reset transistor T7 are all in a turn-off state, and the light-emitting device 232 does not emit light.

In the data refresh and compensation period t2, the reset signal received at the reset signal terminal Rst is a high voltage, so that the second reset transistor T12 is turned off. The scan signal received at the scan signal terminal Gt is a low voltage, so that the third reset transistor T7 is turned on under the control of the scan signal, and writes the initialization signal received at the initialization signal terminal Vin to the anode of the light emitting device 232, so as to reset the anode of the light-emitting device 232.

Moreover, under the control of the scan signal, the writing transistor T4 and the compensation transistor T2 are turned on, and the driving transistor T3 remains in a turn-on state, so that the data signal received at the data signal terminal Dt may be transmitted to the control electrode of the driving transistor T3 via the writing transistor T4, the driving transistor T3 and the compensation transistor T2 in sequence to change the voltage of the control electrode of the driving transistor T3 until the voltage of the control electrode of the driving transistor T3 reaches a sum of the threshold voltage of the driving transistor T3 and the voltage of the data signal, and thus the driving transistor T3 is turned off.

In the data refresh and compensation period t2, the threshold voltage of the driving transistor T3 may be written to the control electrode of the driving transistor T3 to compensate for the threshold voltage drift of the driving transistor T3, thereby reducing the impact on the luminous intensity of the light-emitting device 232. In this period, the first light-emitting control transistor T5 and the second light-emitting control transistor T6 are in a turn-off state under the control of the light-emitting control signal.

In the light-emitting period t3, the second reset transistor T12, the compensation transistor T2, the writing transistor T4 and the third reset transistor T7 are turned off. The capacitor Cst fixes the voltage of the control electrode of the driving transistor T3 to maintain the control electrode of the driving transistor T3 at the voltage in the data refresh and compensation period t2. In this case, the light-emitting control signal is a low voltage, and the first light-emitting control transistor T5 and the second light-emitting control transistor T6 are turned on under the control of the light-emitting control signal, so that the first-type power signal received at the first-type power signal terminal Vdd is written into the first electrode of the driving transistor T3 to turn on the driving transistor T3. Thus, a path is formed between the first-type power signal terminal and the light-emitting device 232, so that the light-emitting device 232 may emit light.

In the pixel driving unit 400 provided by some embodiments of the present disclosure, referring to FIG. 4A, second reset transistors T12 of at least two pixel driving circuits 231 are the same transistor, which may reduce the area of the pixel driving unit 400 and help to hid the pixel driving circuit 231 in the pixel driving unit 400 under the light-emitting device 232.

In some examples, second reset transistors T12 of all pixel driving circuits 231 in one pixel driving unit 400 are the same transistor.

In some examples, in one pixel driving unit 400, the plurality of pixel driving circuits 231 include a first pixel driving circuit 231B, a second pixel driving circuit 231G, and a third pixel driving circuit 231R. The second reset transistor T12 of the first pixel driving circuit 231B, the second reset transistor T12 of the second pixel driving circuit 231G, and the second reset transistor T12 of the third pixel driving circuit 231R are the same transistor.

The first pixel driving circuit 231B, the second pixel driving circuit 231G and the third pixel driving circuit 231R share the second reset transistor T12, and one second reset transistor T12 may reset the control electrodes of the driving transistors T3 of all the pixel driving circuits 231B, 231G and 231R at the same time.

By sharing the second reset transistor T12, it is possible to reduce the number of transistors in one pixel driving unit 400. Therefore, the area of the pixel driving unit 400 may be reduced, which helps to hid the pixel driving circuit 231 in the pixel driving unit 400 under the light-emitting device 232.

In some examples, referring to FIG. 3A, the first sub-pixel 230B includes a first pixel driving circuit 231B and an anode AND-B, and in this case, the first pixel driving circuit 231B is electrically connected to the anode AND-B. The second sub-pixel 230G includes a second pixel driving circuit 231G and an anode AND-G, and in this case, the second pixel driving circuit 231G is electrically connected to the anode AND-G. The third sub-pixel 230R includes a third pixel driving circuit 231R and an anode AND-R, and in this case, the third pixel driving circuit 231R is electrically connected to the anode AND-R.

In some embodiments, referring to FIG. 4A, the pixel driving circuit 231 further includes a first reset transistor T11; in a same pixel driving circuit 231, the first reset transistor T11 is connected in series between the second reset transistor T12 and the control electrode of the driving transistor T3.

A control electrode of the first reset transistor T11 is electrically connected to the reset signal terminal Rst, and the first reset transistor T11 and the second reset transistor T12 jointly reset the control electrode of the driving transistor T3, which may play an effect of anti-leakage.

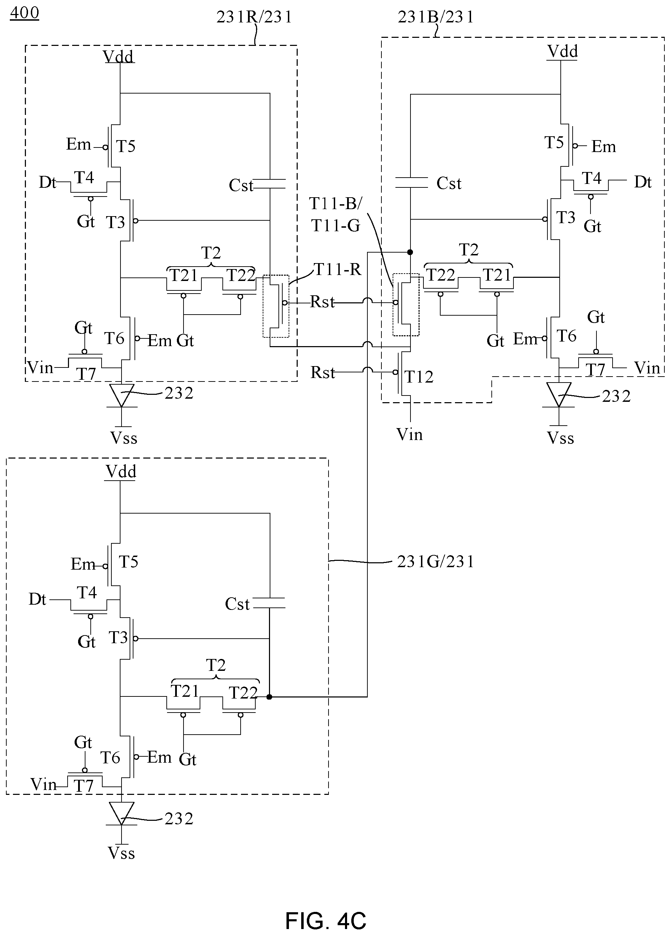

In some examples, referring to FIGS. 4C to 4F, in a single pixel driving unit 400, the first reset transistors T11 of at least two pixel driving circuits 231 are the same transistor.

Based on the above embodiments of the plurality of pixel driving circuits 231 including the first pixel driving circuit 231B, the second pixel driving circuit 231G and the third pixel driving circuit 231R. In some embodiments, referring to FIGS. 4C to 4F, at least two of the first reset transistor T11-B of the first pixel driving circuit 231B, the first reset transistor T11-G of the second pixel driving circuit 231G and the first reset transistor T11-R of the third pixel driving circuit 231 R are the same transistor.

In some examples, referring to FIG. 4C, the first reset transistor T11-B of the first pixel driving circuit 231B and the first reset transistor T11-G of the second pixel driving circuit 231G are the same transistor.

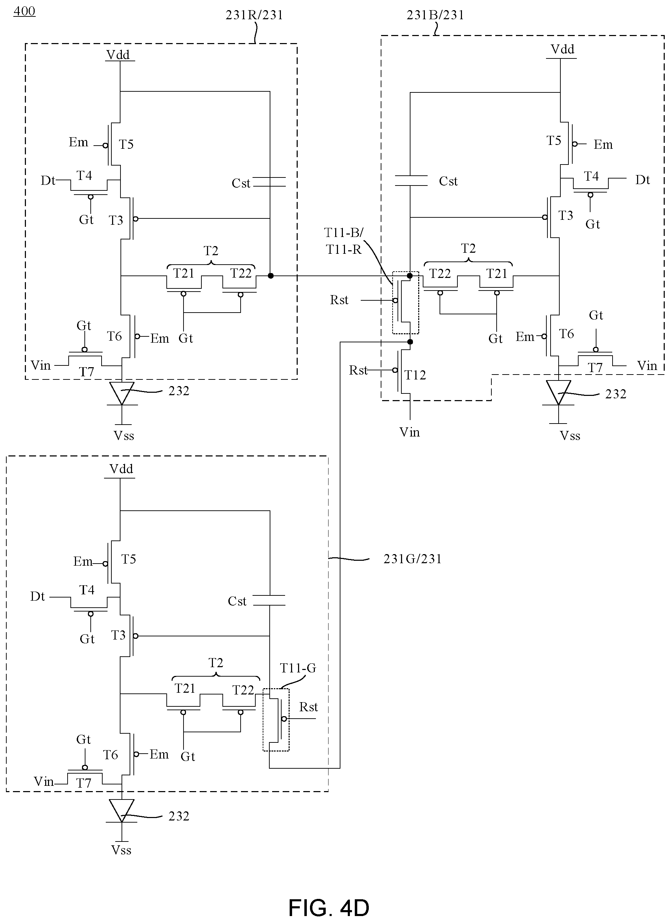

In some examples, referring to FIG. 4D, the first reset transistor T11-B of the first pixel driving circuit 231B and the first reset transistor T11-R of the third pixel driving circuit 231R are the same transistor.

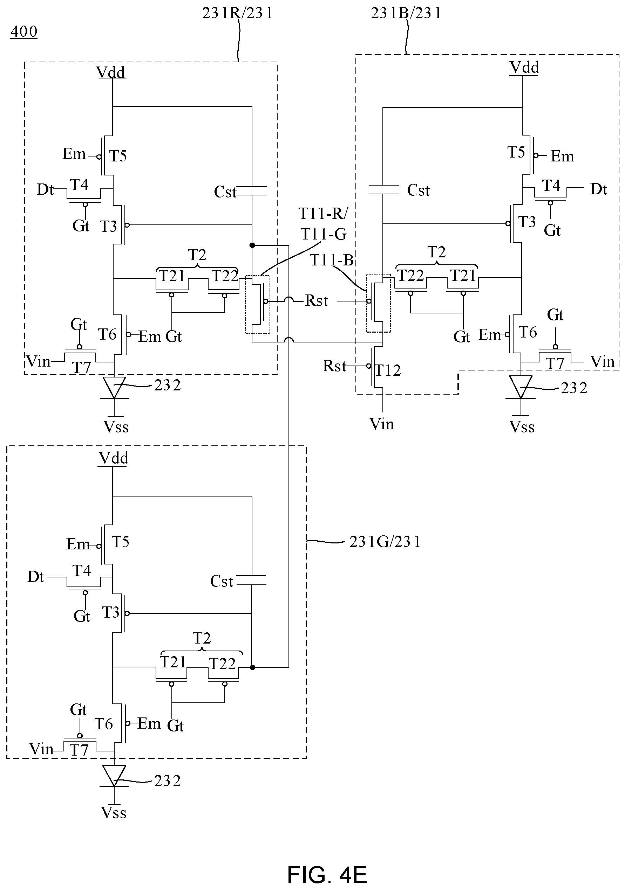

In some examples, referring to FIG. 4E, the first reset transistor T11-G of the second pixel driving circuit 231G and the first reset transistor T11-R of the third pixel driving circuit 231R are the same transistor.

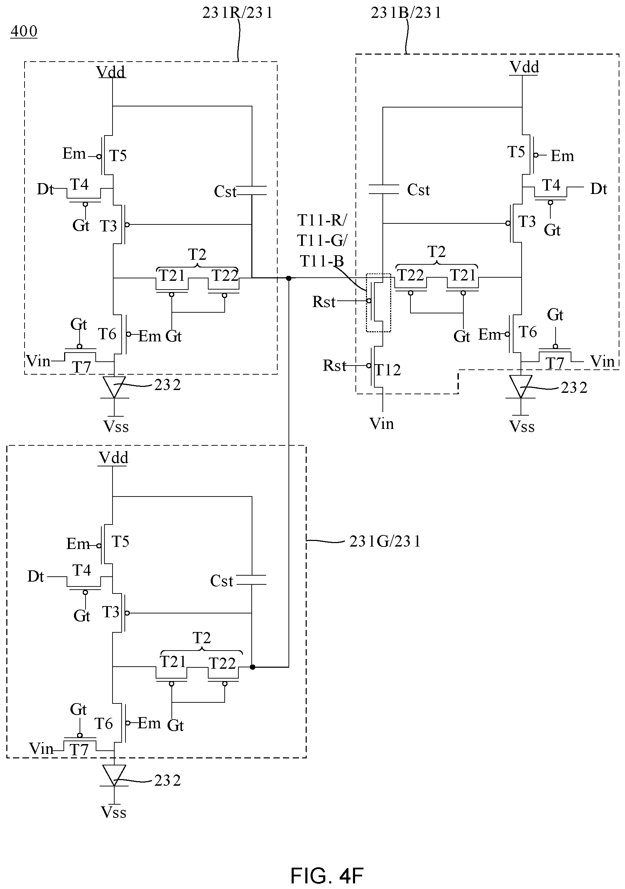

In some examples, referring to FIG. 4F, in a single pixel driving unit 400, the first reset transistors T11 of the plurality of pixel driving circuits 231 (i.e., all pixel driving circuits 231) are the same transistor. Based on the above embodiments of the plurality of pixel driving circuits 231 including the first pixel driving circuit 231B, the second pixel driving circuit 231G and the third pixel driving circuit 231R, in this case, the first reset transistor T11-B of the first pixel driving circuit 231B, the first reset transistor T11-G of the second pixel driving circuit 231G and the first reset transistor T11-R of the third pixel driving circuit 231R are the same transistor.

At least two of the plurality of pixel driving circuits 231 in a single pixel driving unit 400 share the first reset transistor T11. Thus, it is possible to reduce the number of transistors in one pixel driving unit 400, and thereby reduce the area of the pixel driving circuit 231 in the pixel driving unit 400, which helps to hide the pixel driving circuit 231 in the pixel driving unit 400 under the light-emitting device 232.

In addition, in some other embodiments, referring to FIG. 4A, the first reset transistor T11-B of the first pixel driving circuit 231B, the first reset transistor T11-G of the second pixel driving circuit 231G and the first reset transistors T11-R of the third pixel driving circuit 231R are all different transistors.

By providing a first reset transistor T11 for each pixel driving circuit 231, in different pixel driving circuits 231, the control electrode of the driving transistor T3 is reset by a different first reset transistor T11, thereby ensuring the reset effect of the control electrode of the driving transistor T3.

The display apparatus 100 provided in some embodiments of the present disclosure includes the pixel driving unit 400 as described in any one of the above embodiments. Therefore, the display apparatus 100 provided in some embodiments of the present disclosure has all the beneficial effects achieved by the pixel driving unit 400 provided by some embodiments above, which will not be repeated here.

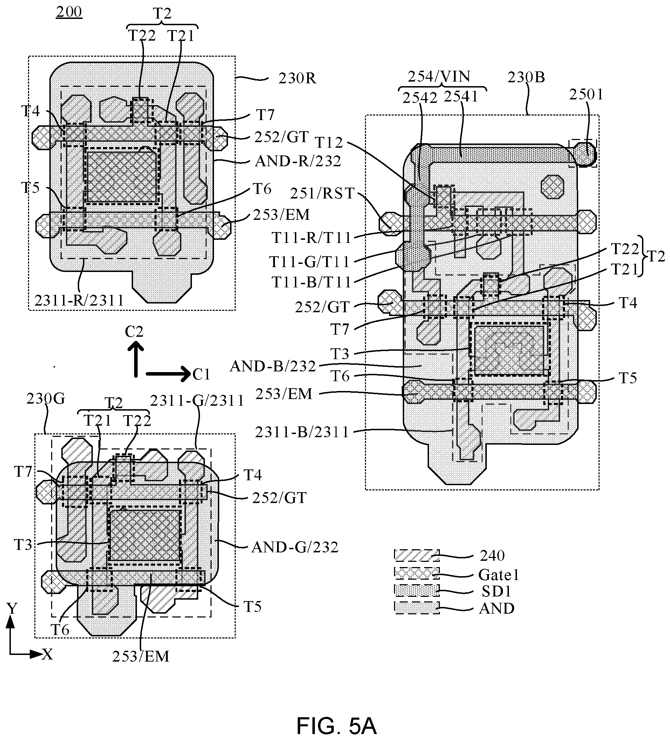

Some embodiments of the present disclosure provide a display panel 200, referring to FIG. 5A, in the display panel 200, an orthographic projection of the first reset transistor T11-G in the second sub-pixel 230G and/or the first reset transistor T11-R in the third sub-pixel 230R on the substrate 210 is located within an orthographic projection of the light-emitting device 232 of the first sub-pixel 230B on the substrate 210.

It will be noted that in a case where the area of the light-emitting device 232 is the area of the anode AND1, the orthographic projection of the light-emitting device 232 on the substrate 210 coincides with the orthographic projection of the anode AND1 on the substrate 210; in a case where the area of the light-emitting device 232 is the area of the light-emitting layer EL, the orthographic projection of the light-emitting device 232 on the substrate 210 coincides with the orthographic projection of the light-emitting layer EL on the substrate 210; in a case where the area of the light-emitting device 232 is the area of the cathode CTD1, the orthographic projection of the light-emitting device 232 on the substrate 210 coincides with the orthographic projection of the cathode CTD1 on the substrate 210.

In some examples, in a single first pixel unit 220, the area of the light-emitting device 232 of the first sub-pixel 230B is the largest, while the area of the light-emitting device 232 of the second sub-pixel 230G and the area of the light-emitting device 232 of the third sub-pixel 230R are relatively small. Thus, the first reset transistor T11-G in the second sub-pixel 230G and/or the first reset transistor T11-R in the third sub-pixel 230R is hidden under the light-emitting device 232 of the first sub-pixel 230B, so that the first reset transistor T11-G in the second sub-pixel 230G and/or the first reset transistor T11-R in the third sub-pixel 230R may be blocked. Moreover, since the area of the light-emitting device 232 of the first sub-pixel 230B is large, the structure of the pixel driving circuit 231 under the light-emitting device 232 of the first sub-pixel 230B will not be too compact. Thus, the space under the light-emitting device 232 of the first sub-pixel 230B may be rationally utilized.

In some examples, only the orthographic projection of the first reset transistor T11-G in the second sub-pixel 230G on the substrate 210 may be located within the orthographic projection of the light-emitting device 232 of the first sub-pixel 230B on the substrate 210. In a single first pixel unit 220, the area of the light-emitting device 232 of the second sub-pixel 230G is small, and the first reset transistor T11-G in the second sub-pixel 230G is disposed under the light-emitting device 232 of the first sub-pixel 230B. Thus, it is possible to reduce the number of transistors in the pixel driving circuit 231 under the light-emitting device 232 of the second sub-pixel 230G, and thereby reduce the area of the pixel driving circuit 231 under the light-emitting device 232 of the second sub-pixel 230G, which is beneficial for the light-emitting device 232 of the second sub-pixel 230G to block the pixel driving circuit 231 located thereunder.

In some other examples, only the orthographic projection of the first reset transistor T11-R in the third sub-pixel 230R on the substrate 210 is located within the orthographic projection of the light-emitting device 232 of the first sub-pixel 230B on the substrate 210. The first reset transistor T11-R in the third sub-pixel 230R is disposed under the light-emitting device 232 of the first sub-pixel 230B. Thus, it is possible to reduce the number of transistors in the pixel driving circuit 231 under the light-emitting device 232 of the third sub-pixel 230R, and thereby reduce the area of the pixel driving circuit 231 under the light-emitting device 232 of the third sub-pixel 230R, which is beneficial for the light-emitting device 232 of the third sub-pixel 230R to block the pixel driving circuit 231 located thereunder.

In some other embodiments, referring to FIG. 5A, orthographic projections of the first reset transistor T11-B of the first sub-pixel 230B, the first reset transistor T11-G of the second sub-pixel 230G, and the first reset transistor T11-R of the third sub-pixel 230R on the substrate 210 are all located within the orthographic projection of the light-emitting device 232 of the first sub-pixel 230B on the substrate 210.

The first reset transistor T11-G of the second sub-pixel 230G and the first reset transistor T11-R of the third sub-pixel 230R are both arranged under the light-emitting device 232 of the first sub-pixel 230B, which may not only reduce the area of the pixel driving circuit 231 under the light-emitting device 232 of the second sub-pixel 230G, but also reduce the area of the pixel driving circuit 231 under the light-emitting device 232 of the third sub-pixel 230R, so that it is beneficial to block the pixel driving circuit 231 in the second sub-pixel 230G and the pixel driving circuit 231 in the third sub-pixel 230R to reduce the diffraction phenomenon. Moreover, the first reset transistor T11-B of the first sub-pixel 230B is located under the light-emitting device 232 of the first sub-pixel 230B, which prevents the first reset transistor T11-B from occupying other space, thereby improving the light transmittance.

In some embodiments, referring to FIGS. 4C to 4F, at least two of the first reset transistor T11-B of the first sub-pixel 230B, the first reset transistor T11-G of the second sub-pixel 230G, and the first reset transistor T11-R of the third sub-pixel 230R are the same transistor.

In a single first pixel unit 220, the first reset transistors T11 of at least two sub-pixels 230 are the same transistor, which may reduce the number of the first reset transistors T11 in the first pixel unit 220. In a case where the first reset transistor T11-B of the first sub-pixel 230B, the first reset transistor T11-G of the second sub-pixel 230G, and the first reset transistor T11-R of the third sub-pixel 230R are all arranged under the light-emitting device 232 of the first sub-pixel 230B, the number of the first reset transistor T11 is reduced, so that the area of the pixel driving circuit 231 under the light-emitting device 232 of the first sub-pixel 230B may be reduced, and thus, the area of the light-emitting device 232 of the first sub-pixel 230B is reduced to increase the light transmittance of the first display region A1.

In some examples, the material of the anode AND1 includes a transparent conductive oxide material and a metal material; the transparent conductive oxide material is, for example, indium tin oxide (ITO) and indium zinc oxide (IZO), and the metal material is, for example, gold (Au), silver (Ag), nickel (Ni), and platinum (Pt). For example, the anode layer AND is of a stacked composite structure including a layer of transparent conductive oxide, a layer of metal and a layer of transparent conductive oxide, and this structure may be denoted by transparent conductive oxide/metal/transparent conductive oxide. For example, the structure of the anode layer AND is ITO/Ag/ITO. The anode AND1 has a poor light transmittance or is opaque.

In some embodiments, referring to FIG. 5A, an orthographic projection of the first reset transistor T11-G in the second sub-pixel 230G and/or the first reset transistor T11-R in the third sub-pixel 230R on the substrate 210 is within an orthographic projection of the anode AND-B of the first sub-pixel 230B on the substrate 210. It will be noted that, in this case, the areas of the light-emitting device 232 and the anode AND1 may be equal or different, which may be understood that the orthographic projection of the light-emitting device 232 on the substrate 210 completely or partially coincides with the orthographic projection of the anode AND1 on the substrate 210.

The anode AND1 has poor light transmittance or is opaque, so that the anode AND1 may block the pixel drive circuit 231 and signal lines located under the anode AND1, thereby reducing the exposure of the pixel drive circuit 231 and signal lines. As a result, the diffraction of the sensor 300 when taking pictures through the first display region A1 is reduced, and the light transmittance of the first display region A1 is increased.

In some examples, the orthographic projections of the first reset transistor T11-B in the first sub-pixel 230B, the first reset transistor T11-G in the second sub-pixel 230G, and the first reset transistor T11-R in the third sub-pixel 230R on the substrate 210 are all located within the orthographic projection of the anode AND-B of the first sub-pixel 230B on the substrate 210.

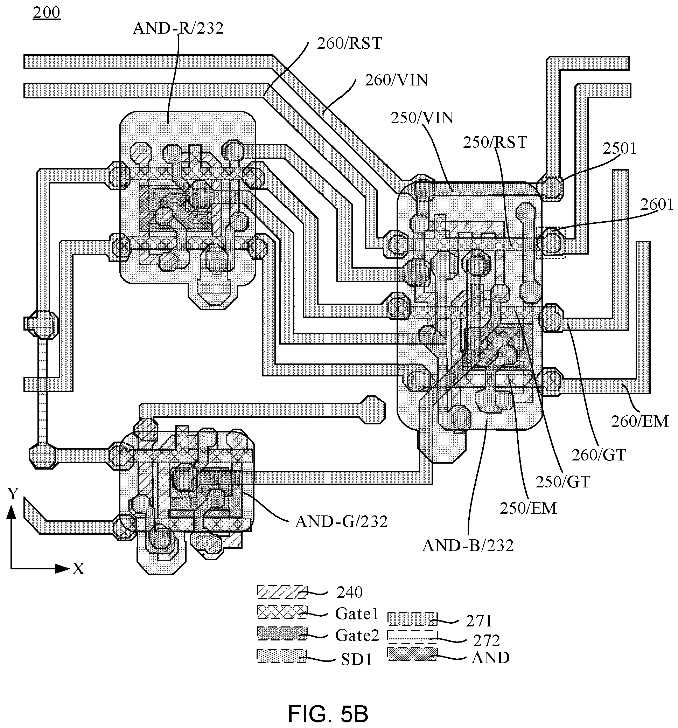

In some embodiments, referring to FIGS. 5A and 5B, the display panel 200 further includes a reset signal line RST and an initialization signal line VIN.

Referring to FIG. 5A, the pixel driving circuit 231 further includes a second reset transistor T12, and the second reset transistor T12 is connected in series to any first reset transistor T11. With reference to FIG. 5B, a control electrode of each first reset transistor T11 and a control electrode of each second reset transistor T12 are all electrically connected to a reset signal line RST, a first electrode of the second reset transistor T12 is electrically connected to the initialization signal line VIN, and a second electrode of the second reset transistor T12 is electrically connected to a first electrode of each first reset transistor T11. The pixel driving circuit 231 further includes a driving transistor T3, and the control electrode of the driving transistor T3 of each pixel driving circuit 231 is electrically connected to the second electrode of the respective first reset transistor T11.

The reset signal line RST is used to transmit the reset signal, and the initialization signal line VIN is used to transmit the initialization signal. In a case where the first reset transistor T11 and the second reset transistor T12 are both P-type transistors, and the reset signal is a low-voltage signal, the first reset transistor T11 and the second reset transistor T12 are turned on, and the first reset transistor T11 and the second reset transistor T12 may transmit the initialization signal to the control electrode of the driving transistor T3 to reset the control electrode of the driving transistor T3. It is possible to reset the control electrode of the driving transistor T3 via two transistors, which may play an effect of anti-leakage.

In some embodiments, referring to FIG. 5A, the second reset transistor T12 of the first sub-pixel 230B, the second reset transistor T12 of the second sub-pixel 230G, and the second reset transistor T12 of the third sub-pixel 230R are the same transistor; an orthographic projection of the second reset transistor T12 on the substrate 210 is located within an orthographic projection of the light-emitting device 232 of the first sub-pixel 230B on the substrate 210.

As shown in FIG. 5A, the second reset transistor T12 of the first sub-pixel 230B, the second reset transistor T12 of the second sub-pixel 230G and the second reset transistor T12 of the third sub-pixel 230R are the same transistor. Thus, it is possible to reduce the number of transistors arranged under the light-emitting device 232 of the first sub-pixel 230B, and thereby reduce the area of the pixel driving circuit 231 under the light-emitting device 232 of the first sub-pixel 230B, which is beneficial for the light-emitting device 232 of the first sub-pixel 230B to block the pixel driving circuit 231 thereunder to avoid the exposure of the pixel drive circuit 231, so that the diffraction phenomenon id reduced.

In this case, in a case where the number of transistors under the light-emitting device 232 of the first sub-pixel 230B is small, it is possible to reduce the area of the light-emitting device 232 of the first sub-pixel 230B, thereby increasing the light transmittance.

In some other examples, referring to FIG. 5A, the orthographic projection of the second reset transistor T12 on the substrate 210 is located within the orthographic projection of the anode AND-B of the first sub-pixel 230B on the substrate 210. The anode AND-B of the first sub-pixel 230B is opaque and has a good blocking effect on the second reset transistor T12, thereby reducing the diffraction phenomenon when the sensor 300 taking pictures through the first display region A1.

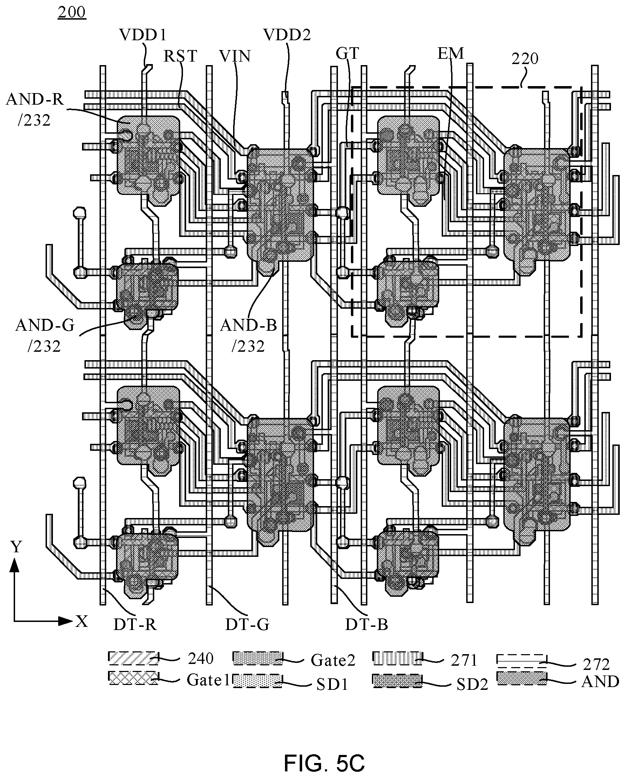

In some embodiments, referring to FIG. 5C, the light-emitting device 232 of the second sub-pixel 230G and the light-emitting device 232 of the third sub-pixel 230R are arranged spaced apart in a column direction Y. For example, the direction indicated by the arrow Y is the column direction Y. The light-emitting device 232 of the second sub-pixel 230G and the light-emitting device 232 of the third sub-pixel 230R are sequentially arranged in the column direction Y, so that light-emitting devices 232 of second sub-pixels 230G and light-emitting devices 232 of third sub-pixels 230R in a column of first pixel units 220 are arranged in a column. Light-emitting devices 232 of first sub-pixels 230B in a column of first pixel units 220 are arranged in a column. Referring to FIGS. 5B and 5C, the light-emitting device 232 of the first sub-pixel 230B is located in a column adjacent to the column where the light-emitting device 232 of the second sub-pixel 230G and the light-emitting device 232 of the third sub-pixel 230R are located, and the light-emitting device 232 of the first sub-pixel 230B spans a gap region between the light-emitting device 232 of the second sub-pixel 230G and the light-emitting device 232 of the third sub-pixel 230R.

It will be noted that, referring to FIGS. 5B and 5C, the direction indicated by the arrow X is a row direction X. In some examples, the row direction X is perpendicular to the column direction Y. Light-emitting devices 232 of third sub-pixels 230R in a row of first pixel units 220 are arranged in a row. Light-emitting devices 232 of second sub-pixels 230G in a row of first pixel units 220 are arranged in a row. Light-emitting devices 232 of first sub-pixels 230B in a row of first pixel units 220 are arranged in a row. The gap region between the light-emitting device 232 of the second sub-pixel 230G and the light-emitting device 232 of the third sub-pixel 230R refers to a gap region between the light-emitting devices 232 of a row of third sub-pixels 230R and the light emitting devices 232 of an adjacent row of second sub-pixels 230G.

The description of "the light-emitting device 232 of the first sub-pixel 230B spans the gap region between the light-emitting device 232 of the second sub-pixel 230G and the light-emitting device 232 of the third sub-pixel 230R" may be understood that a projection of the light-emitting device 232 of the first sub-pixel 230B in the row direction X overlaps with both the light-emitting device 232 of the second sub-pixel 230G and the light-emitting device 232 of the third sub-pixel 230R.

The arrangement of the sub-pixels 230 disclosed in some of the above embodiments may be referred to as a "REAL pixel arrangement". By using the REAL pixel arrangement, the graininess is reduced and the display effect is improved in a case where the pixels per inch (PPI) of the display panel 200 is low (e.g., less than 400). The display panel 200 may be applied to watch devices.

In some embodiments, referring to FIG. 5A, the pixel driving circuit 231 further includes a circuit body 2311. For example, the circuit body 2311 of each sub-pixel 230 includes a compensation transistor T2, a driving transistor T3, a writing transistor T4, a first light-emitting control transistor T5, a second light-emitting control transistor T6, a third reset transistor T7 and a capacitor Cst.

An orthographic projection of the circuit body 2311-B of the first sub-pixel 230B on the substrate 210 is located within an orthographic projection of the light-emitting device 232 of the first sub-pixel 230B on the substrate 210, and an orthographic projection of the circuit body 2311-G of the second sub-pixel 230G on the substrate 210 is located within an orthographic projection of the light-emitting device 232 of the second sub-pixel 230G on the substrate 210, and an orthographic projection of the circuit body 2311-R of the third sub-pixel 230R on the substrate 210 is located within an orthographic projection of the light-emitting device 232 of the third sub-pixel 230R on the substrate 210.

In a single sub-pixel 230, the light-emitting device 232 blocks the circuit body 2311 electrically connected thereto, so as to prevent the circuit body 2311 from being exposed to the light-emitting device 232 to reduce the diffraction phenomenon. Moreover, the light transmittance of the first display region A1 may also be improved.

In some other examples, referring to FIG. 5A, the orthographic projection of the circuit body 2311 of each sub-pixel 230 on the substrate 210 is located within the orthographic projection of the anode AND1 of the sub-pixel 230B on the substrate 210. For example, the orthographic projection of the circuit body 2311-B of the first sub-pixel 230B on the substrate 210 is located within the orthographic projection of the anode AND-B of the first sub-pixel 230B on the substrate 210, the orthographic projection of the circuit body 2311-G of the second sub-pixel 230G on the substrate 210 is located within the orthographic projection of the anode AND-G of the second sub-pixel 230G on the substrate 210, and the orthographic projection of the circuit body 2311-R of the third sub-pixel 230R on the substrate 210 is within the orthographic projection of the anode AND-R of the third sub-pixel 230R on the substrate 210. The anode AND1 of the sub-pixel 230 is opaque and has a good blocking effect on each circuit body 2311, thereby reducing the diffraction phenomenon when the sensor 300 taking pictures through the first display region A1.

In some examples, referring to FIG. 5A, a direction from the second sub-pixel 230G to the third sub-pixel 230R is a second designated direction C2, the direction indicated by the arrow C2 is the second designated direction C2, and the second designated direction C2 is parallel to the column direction Y.

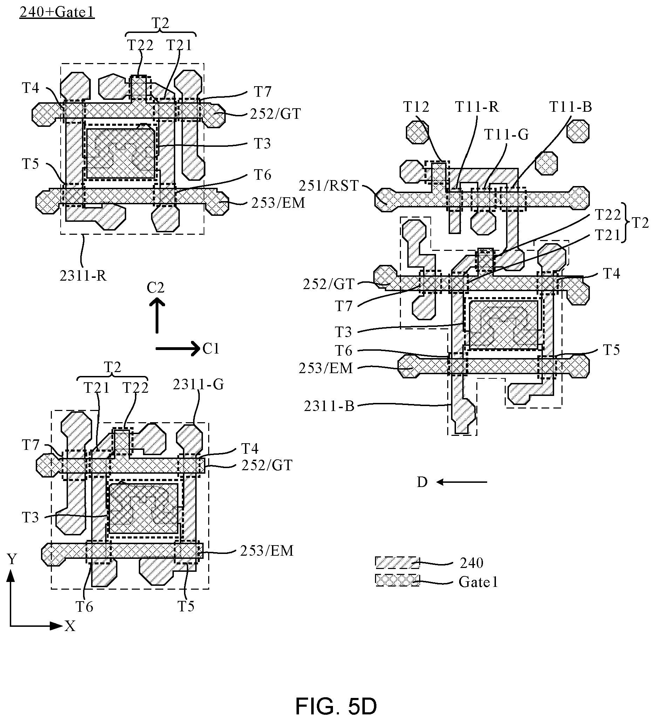

In some embodiments, referring to FIG. 5D, in a row of first pixel units 220, the second reset transistor T12 and multiple first reset transistors T11 are located in a side of the circuit body 2311-B of the first sub-pixel 230B away from the row where the light-emitting device 232 of the second sub-pixel 230G is located; in this case, a direction from the circuit body 2311-B of the first sub-pixel 230B to the second reset transistor T12 and the multiple first reset transistors T11 is the second designated direction C2.

In some embodiments, referring to FIG. 5D, the second reset transistor T12, the first reset transistor T11-R of the third sub-pixel 230R, and the first reset transistor T11-G of the second sub-pixel 230G are located in a side of the first reset transistor T11-B of the first sub-pixel 230B proximate to the circuit body 2311-R of the third sub-pixel 230R, and are sequentially away from the circuit body 2311-R of the third sub-pixel 230R.

In some examples, in a single first pixel unit 220, a direction from the third sub-pixel 230R to the first sub-pixel 230B is a first designated direction C1, the direction denoted by the arrow C1 is the first designated direction C1, and the first designated direction C1 is parallel to the first designated direction C1.

The second reset transistor T12, the first reset transistor T11-R of the third sub-pixel 230R, the first reset transistor T11-G of the second sub-pixel 230G and the first reset transistor T11-B of the first sub-pixel 230B are arranged in the first designated directions C1 in sequence, so as to facilitate the electrical connection between the first reset transistor T11-R of the third sub-pixel 230R and the driving transistor T3 of the third sub-pixel 230R, and facilitate the electrical connection between the first reset transistor T11-G of the second sub-pixel 230G and the driving transistor T3 of the second sub-pixel 230G.

In some embodiments, referring to FIGS. 5B and 5C, the reset signal line RST extends in the row direction X, and a reset signal line RST is electrically connected to the control electrode of the second reset transistor T12 and the control electrode of each first reset transistor T11 that are in a row of first pixel units 220. The second reset transistor T12 is not shown in FIGS. 5B and 5C, and may be reference to FIG. 5A.

A pattern of the reset signal line RST may be a straight line pattern or a substantially straight line pattern. The above reset signal line RST "extends in the row direction X" means that the main pattern of the reset signal line RST tends to extend in a certain row direction X.

In a row of first pixel units 220, the second reset transistors T12, the first reset transistors T11-B of the first sub-pixels 230B, the first reset transistors T11-G of the second sub-pixels 230G, and the first reset transistors T11-R of the third sub-pixels 230R receive the same reset signal. Therefore, the control electrodes of the driving transistors T3 in all the sub-pixels 230 in a row of first pixel units 220 are reset simultaneously.

Referring to FIG. 5B, the initialization signal line VIN extends in the row direction X, and one initialization signal line VIN is electrically connected to the first electrodes of the second reset transistors T12 in a row of first pixel units 220. The second reset transistor T12 is not shown in FIG. 5B, and may be reference to FIG. 5A.

The pattern of the initialization signal line VIN may be a straight line pattern or a substantially straight line pattern. The above initialization signal line VIN "extends in the row direction X" means that the main pattern of the initialization signal line VIN tends to extend in a certain row direction X.

The initialization signal line VIN is used to transmit an initialization signal. The initialization signal is transmitted to each first reset transistor T11 through the second reset transistor T12, and then transmitted to the control electrode of the driving transistor T3 of each sub-pixel 230 to reset the control electrode of the driving transistor T3.

Referring to FIG. 5A, orthographic projections of the second reset transistor T12 and each first reset transistor T11 on the substrate 210 are located between an orthographic projection of the initialization signal line VIN electrically connected to the second reset transistor T12 on the substrate 210 and an orthographic projection of the circuit body 2311-B of the first sub-pixel 230B on the substrate 210; an orthographic projection of the reset signal line RST on the substrate 210 is located between the orthogonal projection of the initialization signal line VIN on the substrate 210 and the orthographic projection of the circuit body 2311-B of the first sub-pixel 230B on the substrate 210.

For convenience of description, the second reset transistor T12 and each first reset transistor T11 are defined as a first-type reset transistor.

Referring to FIG. 5A, the circuit body 2311-G of the second sub-pixel 230G, the first-type reset transistor and the initialization signal line VIN are sequentially arranged in the second designated direction C2.

In a row of first pixel units 220, the second reset transistor T12 and the control electrodes of all the first reset transistors T11 are located on the reset signal line RST.

The position of the control electrode of the first reset transistor T11 will be described in combination with the multiple film layers in the display panel 200.

In some examples, referring to FIG. 5D, the display panel 200 includes an active film layer 240 and a first gate metal layer Gate1 disposed on a side of the substrate 210; the active film layer 240 and the first gate metal layer Gate1 are both located between the substrate 210 and the light-emitting devices 232, and the first gate metal layer Gate1 is located on a side of the active film layer 240 away from the substrate 210. In some examples, a first gate insulating layer is provided between the active film layer 240 and the first gate metal layer Gate1.

The active film layer 240 includes an active layer of each transistor in the pixel driving circuit 231, and the active layer of the transistor includes a first electrode region, a second electrode region, and a channel region connecting the first electrode region and the second electrode region.

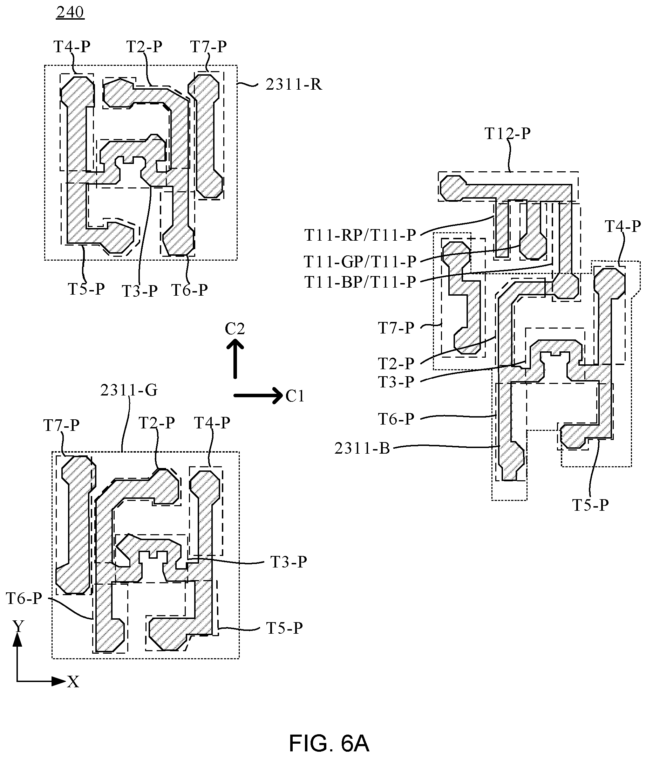

For example, referring to FIG. 6A, the active film layer 240 includes an active layer T12-P of the second reset transistor T12 and an active layer T11-P of each first reset transistor T11.

Referring to FIG. 6A, the active layer T12-P of the second reset transistor T12 extends in the row direction X, and the active layer T11-P of each first reset transistor T11 extends in the column direction Y. An end of the active layer T12-P of the second reset transistor T12 away from the circuit body 2311-R of the third sub-pixel 230R is connected to an end of the active layer T11-P of each first reset transistor T11 away from the circuit body 2311-B of the first sub-pixel 230B.

The active layer T11-RP of the first reset transistor T11-R of the third sub-pixel 230R, the active layer T11-GP of the first reset transistor T11-G of the second sub-pixel 230G, and the active layer T11-BP of the first reset transistor T11-B of the second sub-pixel 230B are sequentially arranged in the first designated direction C1.

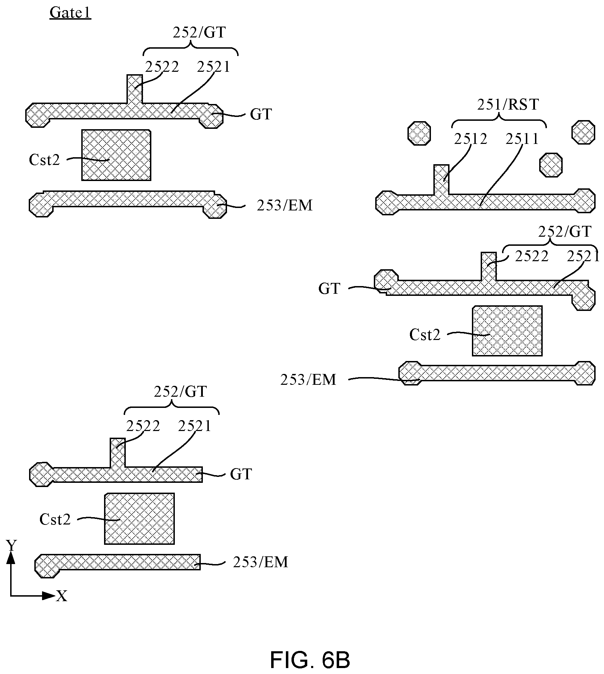

Referring to FIG. 6B, the first gate metal layer Gate1 includes the reset signal line RST. The reset signal line RST is disposed on a side of the active film layer 240 away from the substrate 210. Referring to FIG. 5D, overlapping portions of the reset signal line RST and the active layer T12-P of the second reset transistor T12 and the active layer T11-P of each first reset transistor T11 are also used as the control electrode of the second reset transistor T12 and the control electrode of each first reset transistor T11.

In some embodiments, referring to FIG. 2B, the substrate 210 includes a first display region A1, and a plurality of first pixel units 220 are located in the first display region A1; the display panel 200 further includes a plurality of signal lines located between the substrate 210 and the light-emitting devices 232. It will be noted that the first display region A1 in the substrate 210 and the first display region A1 in the display panel 200 are the same region. The light-emitting devices 232 are not shown in FIG. 2B, and may be reference to FIGS. 3A, 5A and 5B.

Referring to FIG. 5B, a portion of at least one signal line located in the first display region A1 includes a metal line 250 and a transparent connection line 260 that are electrically connected to each other. An orthographic projection of at least part of the metal line 250 on the substrate 210 is located within the orthographic projection of the light-emitting device 232 on the substrate 210. For example, referring to FIG. 5C, the plurality of signal lines in the display panel 200 include reset signal lines RST, scan signal lines GT, light-emitting control signal lines EM, initialization signal lines VIN, first power signal lines VDD1 and second power signal lines VDD2.

In some examples, orthographic projections of all the metal lines 250 on the substrate 210 are within the orthographic projection of the light-emitting device 232 on the substrate 210.

In some other examples, referring to FIG. 5B, the orthographic projection of part of the metal lines 250 on the substrate 210 is located within the orthographic projection of the light-emitting device 232 on the substrate 210, and an orthographic projection of the rest of the metal lines 250 on the substrate is located outside of the orthographic projection of the light-emitting device 232 on the substrate 210.

For example, referring to FIGS. 5A and 5B, an end of the metal line 250 is provided with a metal connection portion 2501. Referring to FIG. 5B, an end of the transparent connection line 260 is provided with a transparent connection portion 2601; an orthographic projection of the metal connection portion 2501 on the substrate 210 at least partially coincides with an orthographic projection of the transparent connection portion 2601 on the substrate 210. In some examples, the orthographic projection of the metal connection portion 2501 on the substrate 210 is at least partially located within the orthographic projection of the light-emitting device 232 on the substrate 210. In some other examples, the orthographic projection of the metal connection portion 2501 on the substrate 210 is all outside the orthographic projection of the light-emitting device 232 on the substrate 210.

The metal lines 250 in a signal line may be connected by transparent connection lines 260, at least part of the transparent connection lines 260 is exposed outside the light-emitting device 232, and the transparent connection lines 260 are transparent lines and are able to transmit light. Therefore, the metal lines 250 are connected by the transparent connection lines 260, so that the light transmittance of the first display region A1 may be improved.

In some other examples, referring to FIG. 5B, the orthographic projection of at least part of the metal lines 250 on the substrate 210 is located within the orthographic projection of the anode AND1 of the sub-pixel 230 on the substrate 210.

The reset signal line RST, the scan signal line GT, the light-emitting control signal line EM, the initialization signal line VIN, the first power signal line VDD1 and the second power signal line VDD2 will be described in sequence below.

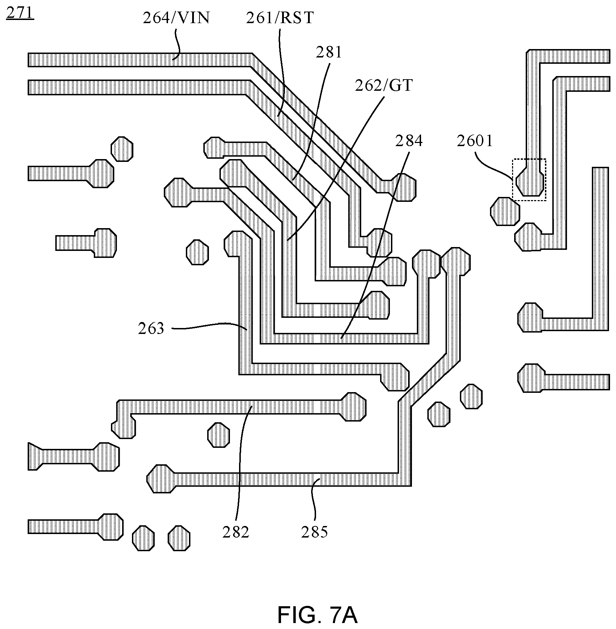

In some embodiments, referring to FIG. 7A, the display panel 200 includes a first transparent wiring layer 271. The first transparent wiring layer 271 is located between the substrate 210 and the light-emitting devices 232, and the first transparent wiring layer 271 is located on a side of the first gate metal layer Gate1 away from the substrate 210.

In some examples, a material of the first gate metal layer Gate1 is metal, such as Al, Ag, Cu, or Cr. A material of the first transparent wiring layer 271 is a transparent conductive oxide material, such as ITO or IZO.

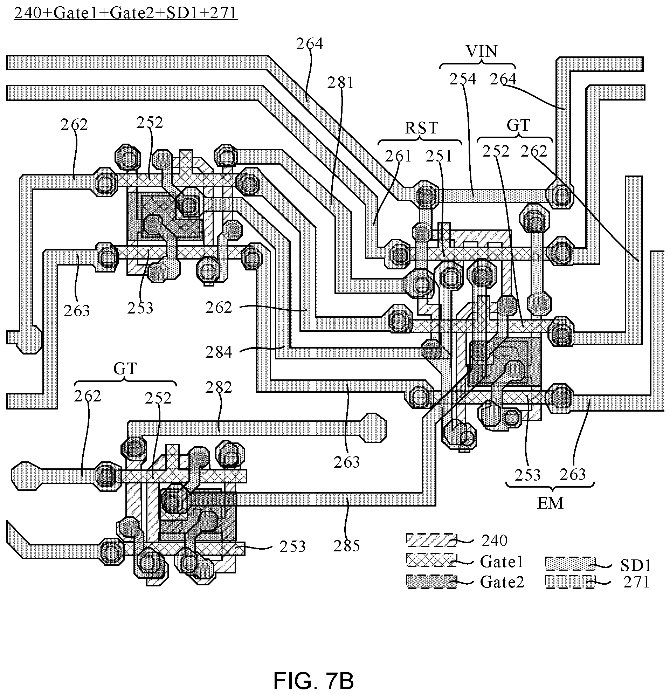

Referring to FIG. 7B, at least one signal line includes a reset signal line RST. The reset signal line RST includes a metal line 251 and a transparent connection line 261. The metal line 251 of the reset signal line RST is located in the first gate metal layer Gate1, and at least part of the orthographic projection of the metal line 251 of the reset signal line RST on the substrate 210 is located within the orthographic projection of the light-emitting device 232 of the first sub-pixel 230B on substrate 210. The light-emitting device 232 of the first sub-pixel 230B is not shown in FIG. 7B, and may be reference to FIG. 5B.

A reset signal line RST includes a plurality of metal lines 251, and at least part of the metal line 251 is located under the light-emitting device 232 of the first sub-pixel 230B. In some examples, an entirety of a metal line 251 is located under a light-emitting device 232 of a single first sub-pixel 230B. In some other examples, a portion of a metal line 251 is located under a light-emitting device 232 of a single first sub-pixel 230B.

Referring to FIG. 6B, the metal lines 251 in the reset signal line RST include a main line segment 2511 and a connection line segment 2512. The main line segment 2511 extends in the row direction X, and the main line segment 2511 overlaps, on the substrate 210, with the active layer T11-P of each first reset transistor T11, and the control electrode of the first reset transistor T11 is located on the main line segment 2511. The connection line segment 2512 extends in the column direction Y, and overlaps with the active layer T12-P of the second reset transistor T12. A portion of the connection line section 2512 overlapping with the active layer T12-P of the second reset transistor T12 is the control electrode of the second reset transistor T12, that is, the control electrode of the second reset transistor T12 is located on the connection line section 2512. The active layer T12-P of the second reset transistor T12 is not shown in FIG. 6B, and may be reference to FIGS. 5D and 6A.

Referring to FIG. 7B, the transparent connection line 261 of the reset signal line RST is located in the first transparent line layer 271, and the transparent connection line 261 of the reset signal line RST is connected to the metal line 251 of the reset signal line RST through a via hole.

The orthographic projection of the transparent connection line 261 of the reset signal line RST on the substrate 210 is located outside the orthographic projection of the light-emitting device 232 of the second sub-pixel 230G on the substrate 210, and is located outside the orthographic projection of the light-emitting device 232 of the third sub-pixel 230R. Therefore, the transparent connection line 261 of the reset signal line RST will not occupy the space under the light-emitting device 232 of the second sub-pixel 230G and the light-emitting device 232 of the third sub-pixel 230R, thereby increasing an area of the pixel driving circuits 231 under the light-emitting device 232 of the second sub-pixel 230G and the light-emitting device 232 of the third sub-pixel 230R. As a result, it is possible to avoid the coupling caused by a fact that the structure of the pixel driving circuits 231 under the light-emitting device 232 of the second sub-pixel 230G and the light-emitting device 232 of the third sub-pixel 230R is too compact. The light-emitting device 232 of the third sub-pixel 230R is not shown in FIG. 7B, and may be reference to FIGS. 5A and 5B.

In some other examples, referring to FIG. 7B, at least part of the orthographic projection of the metal line 251 of the reset signal line RST on the substrate 210 is located within the orthographic projection of the anode AND-B of the first sub-pixel 230B on the substrate 210. The orthographic projection of the transparent connection line 261 of the reset signal line RST on the substrate 210 is located outside the orthographic projection of the anode AND-G of the second sub-pixel 230G on the substrate 210 and is located outside the orthographic projection of the anode AND-R of the third sub-pixel 230R on substrate 210. The anode AND1 of each sub-pixel 230 is not shown in FIG. 7B, and may be reference to FIG. 5B.

In some embodiments, referring to FIG. 5D, the circuit body 2311 of the pixel driving circuit 231 includes a writing transistor T4, a compensation transistor T2, and a third reset transistor T7.

At least one signal line further includes a scan signal line GT, and the scan signal line GT is connected to the control electrodes of the writing transistors T4, the control electrodes of the compensation transistors T2 and the control electrodes of the third reset transistors T7 of all sub-pixels 230 in a row of first pixel units 220.

The scan signal line GT is used to transmit a scan signal, and all the sub-pixels 230 in a row of first pixel units 220 receive the same scan signal. In the first pixel units 220 in a row, the writing transistors T4, the compensation transistors T2 and the third reset transistors T7 are turned on simultaneously.

Referring to FIG. 7B, the metal line 252 of the scan signal line GT is located in the first gate metal layer Gate1, and at least part of the orthographic projection of the metal line 252 of the scan signal line GT on the substrate 210 is located within the orthographic projection of the light-emitting device 232 on the substrate 210. The transparent connection line 262 of the scan signal line GT is located in the first transparent wiring layer 271, and the transparent connection line 262 of the scan signal line GT is connected to the metal line 252 of the scan signal line GT through a via hole.

Referring to FIG. 7B, the scan signal line GT includes a plurality of metal lines 252, and the orthographic projection of a metal line 252 on the substrate 210 is at least partially located within the orthographic projection of a light-emitting device 232 on the substrate 210. In some examples, an entirety of each metal line 252 is disposed under the light-emitting device 232. In some other examples, a portion of each metal line 252 is disposed under the light-emitting device 232.

In some other examples, referring to FIG. 7B, at least part of the orthographic projection of the metal line 252 of the scan signal line GT on the substrate 210 is located within the orthographic projection of the anode AND1 of the sub-pixel 230 on the substrate 210.

In some examples, referring to FIG. 5D, the metal line 252 of the scan signal line GT is electrically connected to the control electrode of the writing transistor T4, the control electrode of the compensation transistor T2 and the control electrode of the third reset transistor T7 in one sub-pixel 230.

In some examples, referring to FIG. 6A, the active film layer 240 includes an active layer T4-P of the writing transistor T4, an active layer T2-P of the compensation transistor T2, and an active layer T7-P of the third reset transistor T7.

Referring to FIG. 5D, a portion of the metal line 252 overlapping with the active layer T4-P of the writing transistor T4 is also used as the control electrode of the writing transistor T4. A portion of the metal line 252 overlapping with the active layer T2-P of the compensation transistor T2 is also used as the control electrode of the compensation transistor T2. A portion of the metal line 252 overlapping with the active layer T7-P of the third reset transistor T7 is also used as the control electrode of the third reset transistor T7. That is, the control electrode of the writing transistor T4, the control electrode of the compensation transistor T2, and the control electrode of the third reset transistor T7 in one sub-pixel 230 are located on the metal line 252.

In some examples, referring to FIGS. 4A and 5D, the compensation transistor T2 of each sub-pixel 230 includes a first compensation transistor T21 and a second compensation transistor T22. The first compensation transistor T21 and the second compensation transistor T22 are connected in series.

A control electrode of the first compensation transistor T21 is electrically connected to the scan signal line GT, a first electrode of the first compensation transistor T21 is electrically connected to the second electrode of the driving transistor T3 and a first electrode of the second light-emitting control transistor T6, and a second electrode of the first compensation transistor T21 is electrically connected to a first electrode of the second compensation transistor T22.

A control electrode of the second compensation transistor T22 is electrically connected to the scan signal line GT, and a second electrode of the second compensation transistor T22 is electrically connected to the second electrode of the first reset transistor T11 and the control electrode of the driving transistor T3.

By providing the compensation transistor T2 as the first compensation transistor T21 and the second compensation transistor T22 connected in series, the effect of preventing current leakage may be achieved.

Based on the examples that the compensation transistor T2 includes the first compensation transistor T21 and the second compensation transistor T22, referring to FIG. 6B, the metal line 252 of the scan signal line GT includes a main line segment 2521 and a connection line segment 2522. The main line segment 2521 extends in the row direction X, the connection line segment 2522 extends in the column direction, and an end of the connection line segment 2522 is connected to the main line segment 2521. A portion of the connection line segment 2522 overlapping with the active layer T2-P of the compensation transistor T2 is also used as the control electrode of the second compensation transistor T22. Overlapping portions of the main line segment 2521 and the active layer T4-P of the writing transistor T4, the active layer T2-P of the compensation transistor T2, and the active layer T7-P of the third reset transistor T7 are also used as the control electrode of the writing transistor T4, the control electrode of the first compensation transistor T21 and the control electrode of the third reset transistor T7, respectively. The active layer of each transistor are not shown in FIG. 6B, and may be reference to FIGS. 5D and 6A.

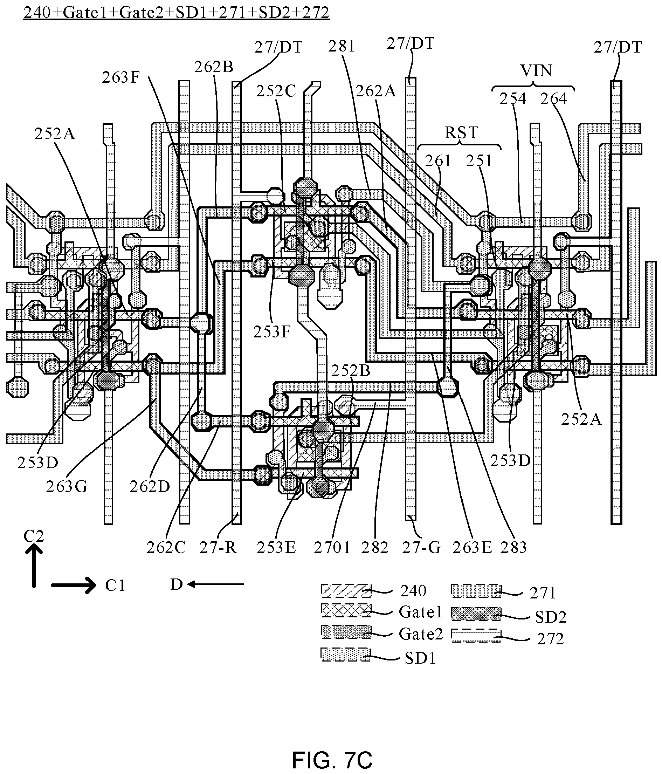

In some examples, referring to FIG. 7C, one scan signal line GT includes a plurality of metal lines 252 and a plurality of transparent connection lines 262. The plurality of metal lines 252 include a first metal line segment 252A, a second metal line segment 252B and a third metal line segment 252C. The metal lines 252 and the plurality of transparent connection lines 262 are not shown in FIG. 7C, and may be reference to FIG. 7B.

An orthographic projection of the first metal line segment 252A on the substrate 210 is at least partially located within the orthographic projection of the light-emitting device 232 of the first sub-pixel 230B on the substrate 210.

An orthographic projection of the second metal line segment 252B on the substrate 210 is at least partially located within the orthographic projection of the light-emitting device 232 of the second sub-pixel 230G on the substrate 210.

An orthographic projection of the third metal line segment 252C on the substrate 210 is at least partially located within the orthographic projection of the light-emitting device 232 of the third sub-pixel 230R on the substrate 210.

In some examples, referring to FIG. 7C, the display panel 200 further includes a second transparent wiring layer 272. The second transparent wiring layer 272 is located on a side of the first transparent wiring layer 271 away from the substrate 210 or facing the substrate 210.

The plurality of transparent connection lines 262 in one scan signal line GT include a first transparent connection line segment 262A, a second transparent connection line segment 262B, a third transparent connection line segment 262C and a fourth transparent connection line segment 262D. The first transparent connection line segment 262A, the second transparent connection line segment 262B and the third transparent connection line segment 262C are located in the first transparent wiring layer 271, and the fourth transparent connection line segment 262D is located in the second transparent wiring layer 272.

In each first pixel unit 220, the first metal line segment 252A electrically connected to the first sub-pixel 230B is electrically connected to the third metal line segment 252C electrically connected to the third sub-pixel 230R by the first transparent connection line segment 262A.

A first metal line segment 252A electrically connected to the first sub-pixel 230B in a first pixel unit 220 is electrically connected to a third metal line segment 252C electrically connected to the third sub-pixel 230R in an adjacent first pixel unit 220 in the row direction X by a second transparent connection line segment 262B.

An end of the third transparent connection line segment 262C is electrically connected to an end of the second metal line segment 252B away from the first sub-pixel 230B, and the other end of the third transparent connection line segment 262C is electrically connected to the fourth transparent connection line segment 262D. An end of the fourth transparent connection line segment 262D away from the third transparent connection line segment 262C is electrically connected to the second transparent connection line segment 262B.

In some embodiments, referring to FIG. 5D, the circuit body 2311 of the pixel driving circuit 231 further includes a first light-emitting control transistor T5 and a second light-emitting control transistor T6. At least one signal line further includes a light-emitting control signal line EM. A light-emitting control signal line EM is electrically connected to the control electrodes of the first light-emitting control transistors T5 and the control electrodes of the second light-emitting control transistors T6 of all sub-pixels 230 in a row of first pixel units 220.

The light-emitting control signal line EM is used to transmit a light-emitting control signal, and all the sub-pixels 230 in a row of first pixel units 220 receive the same light-emitting control signal. The first light-emitting control transistors T5 and the second light-emitting control transistors T6 in a row of first pixel units 220 are turned on simultaneously.

Referring to FIGS. 7B and 7C, the metal lines 253 of the light-emitting control signal line EM are located in the first gate metal layer Gate1. At least part of an orthographic projection of the metal line 253 of the light-emitting control signal line EM on the substrate 210 is located within the orthographic projection of the light-emitting device 232 on the substrate 210. The transparent connection lines 263 of the light-emitting control signal line EM are located in the first transparent wiring layer 271. The transparent connection line 263 of the light-emitting control signal line EM is connected to the metal line 253 of the light-emitting control signal line EM through a via hole. The light-emitting device 232 is not shown in FIGS. 7B and 7C, and may be reference to FIG. 5A.

In some other examples, referring to FIG. 5A, at least part of the orthographic projection of the metal line 253 of the light-emitting control signal line EM on the substrate 210 is located within the orthographic projection of the anode AND1 of the sub-pixel 230 on the substrate 210.

Referring to FIGS. 7B and 7C, the light-emitting control signal line EM includes a plurality of metal lines 253. An orthographic projection of a metal line 253 on the substrate 210 is at least partially located within an orthographic projection of a light-emitting device 232 on the substrate 210. In some examples, the entirety of each metal line 253 is disposed under the light-emitting device 232. In some other examples, a portion of each metal line 253 is disposed under the light-emitting device 232.

In some examples, referring to FIG. 5A, the metal line 253 of the light-emitting control signal line EM is electrically connected to the control electrode of the first light-emitting control transistor T5 and the control electrode of the second light-emitting control transistor T6 in one sub-pixel 230.

In some examples, referring to FIG. 6A, the active film layer 240 includes an active layer T5-P of the first light-emitting control transistor T5 and an active layer T6-P of the second light-emitting control transistor T6.

Referring to FIG. 5D, a portion of the metal line 253 overlapping with the active layer T5-P of the first light-emitting control transistor T5 is also used as the control electrode of the first light-emitting control transistor T5. A portion of the metal line 253 overlapping with the active layer T6-P of the second light-emitting control transistor T6 is also used as the control electrode of the second light-emitting control transistor T6. That is, the control electrode of the first light-emitting control transistor T5 and the control electrode of the second light-emitting control transistor T6 in one sub-pixel 230 are located on a metal line 252.

In some examples, referring to FIG. 6A, the active film layer 240 further includes an active layer T3-P of the driving transistor T3. Referring to FIG. 6B, the first gate metal layer Gate1 further includes a second plate Cst2 of the capacitor Cst. Referring to FIG. 5D, an orthographic projection of the second plate Cst2 on the substrate 210 partially overlaps with an orthographic projection of the active layer T3-P of the driving transistor T3 on the substrate 210, and a portion of the second plate Cst2 overlapping with the active layer T3-P of the driving transistor T3 serves as the control electrode of the driving transistor T3.

In some examples, referring to FIG. 7C, a light-emitting control signal line EM includes a plurality of metal lines 253 and a plurality of transparent connection lines 263. The plurality of metal lines 253 include a fourth metal line segment 253D, a fifth metal line segment 253E and a sixth metal line segment 253F. The light-emitting control signal line EM, the metal line 253 and the transparent connection line 263 are not shown in FIG. 7C, and may be reference to FIG. 7B.

An orthographic projection of the fourth metal line segment 253D on the substrate 210 is at least partially located within the orthographic projection of the light-emitting device 232 of the first sub-pixel 230B on the substrate 210.

An orthographic projection of the fifth metal line segment 253E on the substrate 210 is at least partially located within the orthographic projection of the light-emitting device 232 of the second sub-pixel 230G on the substrate 210.

An orthographic projection of the sixth metal line segment 253F on the substrate 210 is at least partially located within the orthographic projection of the light-emitting device 232 of the third sub-pixel 230R on the substrate 210.

Referring to FIG. 7C, the plurality of transparent connection lines 263 in a light-emitting control signal line EM include a fifth transparent connection line segment 263E, a sixth transparent connection line segment 263F and a seventh transparent connection line segment 263G, which are all located in the first transparent wiring layer 271.

Referring to FIG. 7C, in a first pixel unit 220, the fourth metal line segment 253D electrically connected to the first sub-pixel 230B is electrically connected to the sixth metal line segment 253F electrically connected to the third sub-pixel 230R by the fifth transparent connection line segment 263E.

The fourth metal line segment 253D electrically connected to the first sub-pixel 230B in a first pixel unit 220 is electrically connected to the sixth metal line segment 253F electrically connected to the third sub-pixel 230R in an adjacent first pixel unit 220 in the first designated direction C1 by the sixth transparent connection line segment 263F.

An end of the seventh transparent connection line segment 263G is electrically connected to an end of the fifth metal line segment 253E electrically connected to the second sub-pixel 230G away from the first sub-pixel 230B, and the other end of the seventh transparent connection line segment 263G is electrically connected to the sixth transparent connection line segment 263F.

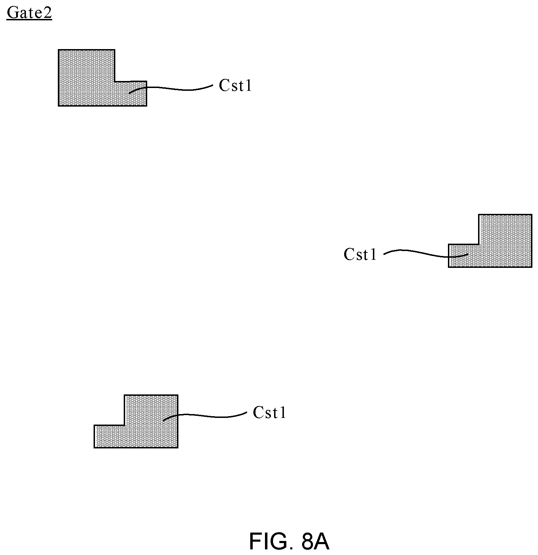

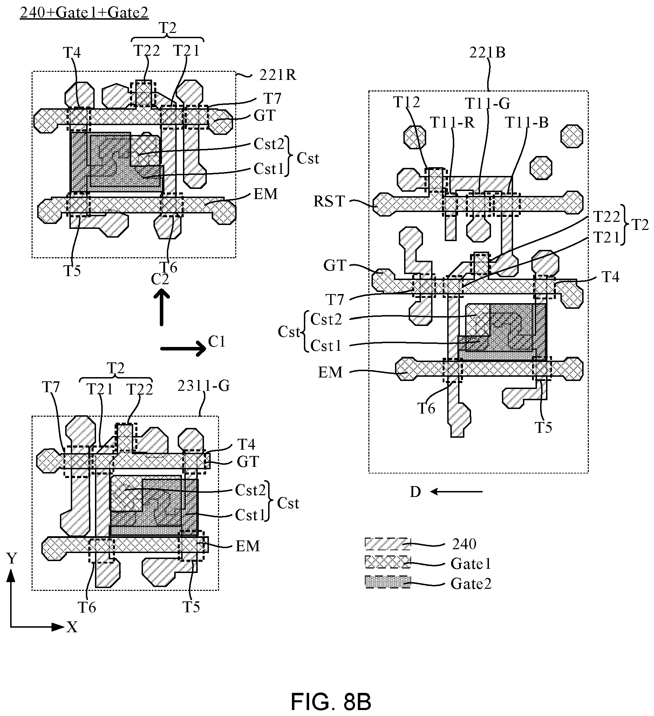

In addition to the first gate metal layer Gate1, in some embodiments, referring to FIGS. 8A and 8B, the display panel 200 further includes a second gate metal layer Gate2, and the second gate metal layer Gate2 is located between the active film layer 240 and the light-emitting devices 232.

In some examples, a material of the second gate metal layer Gate2 is metal, such as Al, Ag, Cu or Cr.

Referring to FIGS. 8A and 8B, the circuit body 2311 of the pixel driving circuit 231 further includes a capacitor Cst, and the first plate Cst1 of the capacitor Cst is located in the second gate metal layer Gate2.

In some examples, referring to FIG. 8B, the second gate metal layer Gate2 is located on a side of the first gate metal layer Gate1 away from the substrate 210. For the capacitor Cst, an orthographic projection of the first plate Cst1 on the substrate 210 at least partially overlaps with an orthographic projection of the second plate Cst2 on the substrate 210.

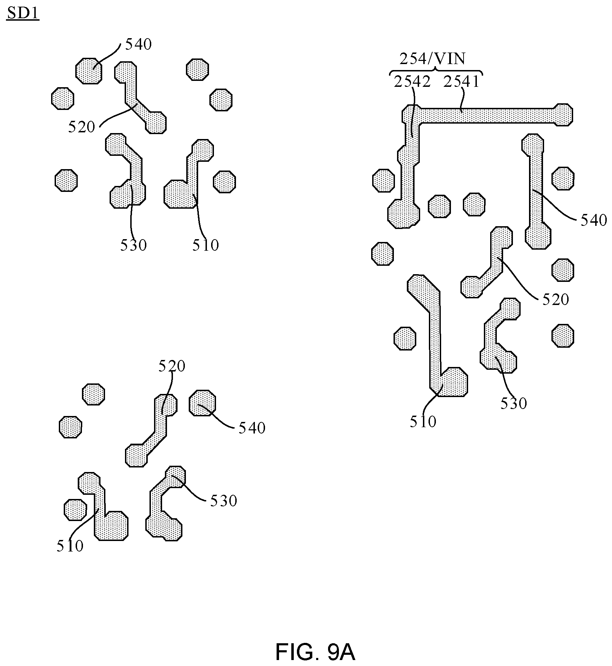

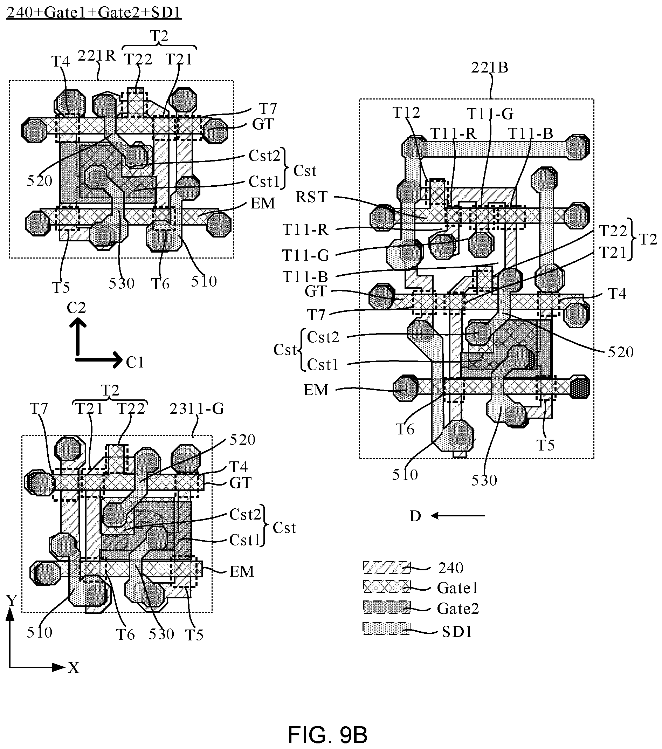

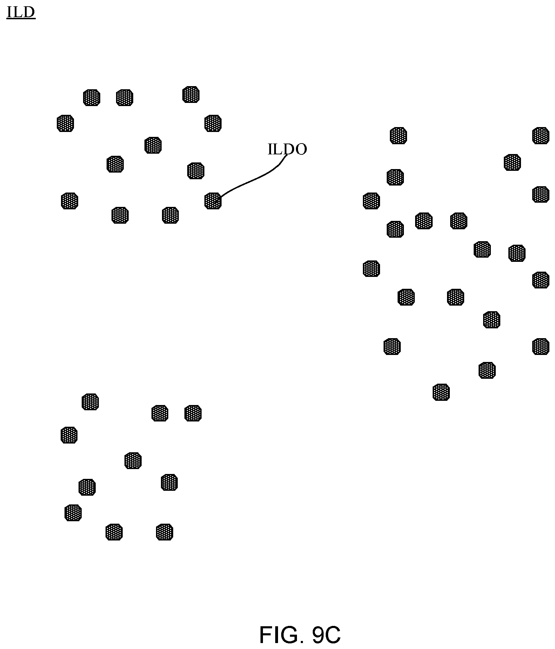

In some embodiments, referring to FIGS. 9A and 9B, the display panel 200 includes a first source-drain metal layer SD1, and the first source-drain metal layer SD1 is located between the substrate 210 and the light-emitting device 232. The first source-drain metal layer SD1 is located on a side of the second gate metal layer Gate1 away from the substrate 210, the first transparent wiring layer 271 is located on a side of the first source-drain metal layer SD1 away from the substrate 210, and the first transparent wiring layer 271 is located between the first source-drain metal layer SD1 and the light-emitting devices 232. Referring to FIG. 9C, an interlayer dielectric layer ILD is provided between the second gate metal layer Gate1 and the first source-drain metal layer SD1, and the interlayer dielectric layer ILD is provided with a plurality of via holes ILDO therein. The positions of the plurality of via holes in the interlayer dielectric layer ILD are shown in FIG. 9C.

In some examples, a material of the first source-drain metal layer SD1 is metal, such as Al, Ag, Cu or Cr.

Referring to FIGS. 7B and 7C, at least one signal line further includes an initialization signal line VIN. An initialization signal line VIN is electrically connected to first electrodes of the second reset transistors T12 in a row of first pixel units 220. The metal lines 254 of the initialization signal line VIN are located in the first source-drain metal layer SD1. Referring to FIG. 5A, at least part of the orthographic projection of the metal line 254 of the initialization signal line VIN on the substrate 210 is located within the orthographic projection of the light-emitting device 232 of the first sub-pixel 230B on the substrate 210.

In some examples, an initialization signal line VIN includes a plurality of metal lines 254. A metal line 254 overlaps with a light-emitting device 232 of a first sub-pixel 230B.

In some examples, an entirety of the metal line 254 of the initialization signal line VIN is disposed under the light-emitting device 232 of the first sub-pixel 230B.

In some other examples, part of the metal line 254 of the initialization signal line VIN is disposed under the light-emitting device 232 of the first sub-pixel 230B. In this case, the transparent connection line 264 of the initialization signal line VIN is partially located under the light-emitting device 232 of the first sub-pixel 230B.

Referring to FIG. 7B, the transparent connection lines 264 of the initialization signal line VIN are located in the first transparent wiring layer 271; the transparent connection line 264 of the initialization signal line VIN is connected to the metal line 254 of the initialization signal line VIN through a via hole. An orthographic projection of the transparent connection line 264 of the initialization signal line VIN on the substrate 210 is located outside the orthographic projection of the light-emitting device 232 of the second sub-pixel 230G on the substrate 210 and is located outside the orthographic projection of the light-emitting device 232 of the third sub-pixel 230R on substrate 210. Therefore, the transparent connection line 264 of the initialization signal line VIN will not occupy the space under the light-emitting device 232 of the second sub-pixel 230G and the light-emitting device 232 of the third sub-pixel 230R, thereby increasing an area of the pixel driving circuits 231 under the light-emitting device 232 of the second sub-pixel 230G and the light-emitting device 232 of the third sub-pixel 230R. As a result, it is possible to avoid the coupling caused by a fact that the structure of the pixel driving circuits 231 under the light-emitting device 232 of the second sub-pixel 230G and the light-emitting device 232 of the third sub-pixel 230R is too compact. The light-emitting device 232 of the second sub-pixel 230G and the light-emitting device 232 of the third sub-pixel 230R are not shown in FIG. 7B, and may be reference to FIG. 5B.

In some other examples, referring to FIG. 5A, at least part of the orthographic projection of the metal line 254 of the initialization signal line VIN on the substrate 210 is located within the orthographic projection of the anode AND-B of the first sub-pixel 230B on the substrate 210. The orthographic projection of the transparent connection line 264 of the initialization signal line VIN on the substrate 210 is located outside the orthographic projection of the anode AND-G of the second sub-pixel 230G on the substrate 210 and is located outside the orthographic projection of the anode AND-R of the third sub-pixel 230R on substrate 210.

In some examples, referring to FIGS. 5A and 9A, the metal line 254 of the initialization signal line VIN includes a main line segment 2541 and a connection line segment 2542. The main line segment 2541 extends in the row direction X, and the connection line segment 2542 extends in the column direction Y, and an end of the main line segment 2541 proximate to the third sub-pixel 230R is connected to the connection line segment 2542.

Referring to FIG. 5A, an end of the active layer T12-P of the second reset transistor T12 proximate to the third sub-pixel 230R is connected to the middle of the connection line segment 2542 through a via hole, and an end of the connection line segment 2542 away from the main line segment 2541 is connected to the active layer T7-P of the third reset transistor T7 in the first sub-pixel 230B through a via hole.

In some examples, referring to FIG. 7B, the display panel 200 further includes a first transparent connection line 281, and the first transparent connection line 281 is located in the first transparent wiring layer 271; an end of the first transparent connection line 281 is connected to an end of the connection line segment 2542 away from the main line segment 2541, and the other end of the first transparent connection line 281 is electrically connected to the active layer T7-P of the third reset transistor T7 in the third sub-pixel 230R.

In some examples, referring to FIG. 7C, the display panel 200 further includes a second transparent connection line 282 and a third transparent connection line 283, the second transparent connection line 282 is located in the first transparent wiring layer 271, and the third transparent connection line 283 is located in the second transparent wiring layer 272. An end of the second transparent connection line 282 is electrically connected to the active layer T7-P of the third reset transistor T7 in the second sub-pixel 230G, and the other end of the second transparent connection line 282 is electrically connected to the third transparent connection line 283, and an end of the third transparent connection line 283 away from the second transparent connection line 282 is connected to the end of the first transparent connection 281 connected to the connection line segment 2542 through a via hole.

Referring to FIG. 7B, the display panel 200 further includes a fourth transparent connection line 284 and a fifth transparent connection line 285, and both the fourth transparent connection line 284 and the fifth transparent connection line 285 are located in the first transparent wiring layer 271.

An end of the fifth transparent connection line 285 is electrically connected to the active layer T11-GP of the first reset transistor T11-G in the second sub-pixel 230G, and the other end of the fifth transparent connection line 285 is electrically connected to the control electrode of the driving transistor T3 in the second sub-pixel 230G, i.e., the second plate Cst2 of the capacitor Cst.

An end of the fourth transparent connection line 284 is electrically connected to the active layer T11-RP of the first reset transistor T11-R in the third sub-pixel 230R, and the other end of the fourth transparent connection line 284 is electrically connected to the control electrode of the driving transistor T3 in the third sub-pixel 230R, i.e., the second plate Cst2 of the capacitor Cst.

In addition to the metal lines 254 of the initialization signal line VIN, the first source-drain metal layer SD1 further includes a plurality of bridge patterns. The bridge patterns are connected to the active film layer 240, the first gate metal layer Gate1 and the second gate metal layer Gate2 through via holes.

In some examples, referring to FIGS. 9A and 9B, the plurality of bridge patterns include first bridge patterns 510; an end of the first bridge pattern 510 is connected to the active layer T6-P of the second light-emitting control transistor T6 through a via hole, and the other end of the first bridge pattern 510 is connected to the active layer T7-P of the third reset transistor T7 through a via hole.

In some examples, referring to FIGS. 9A and 9B, the plurality of bridge patterns include second bridge patterns 520; an end of the second bridge pattern 520 is connected to the control electrode of the driving transistor T3, i.e., the second plate Cst2 of the capacitor Cst, through a via hole, and the other end of the second bridge pattern 520 is connected to the active layer T2-P of the compensation transistor T2 through a via hole.

In some examples, referring to FIGS. 9A and 9B, the plurality of bridge patterns include third bridge patterns 530; an end of the third bridge pattern 530 is connected to the first plate Cst1 of the capacitor Cst through a via hole, and the other end of the third bridge pattern 530 is connected to the active layer T5-P of the first light-emitting control transistor T5 through a via hole.

In some other examples, orthographic projections of the plurality of bridge patterns on the substrate 210 are located within orthographic projections of the anodes AND1 on the substrate 210.

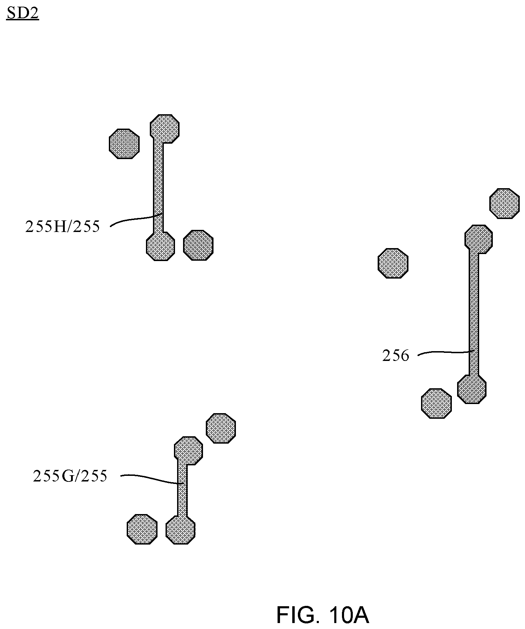

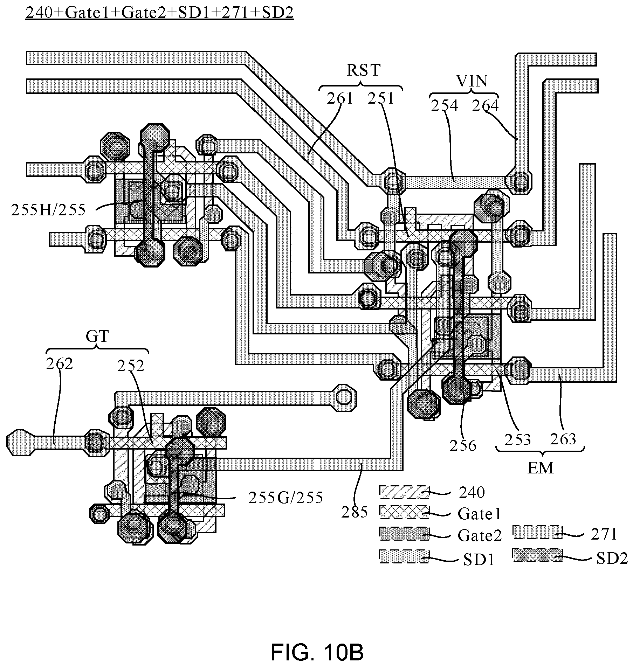

In some embodiments, referring to FIGS. 10A and 10B, the display panel 200 includes a second source-drain metal layer SD2, the second source-drain metal layer SD2 is located between the substrate 210 and the light-emitting devices 232, and the second source-drain metal layer SD2 is located on a side of the second gate metal layer Gate2 away from the substrate 210.

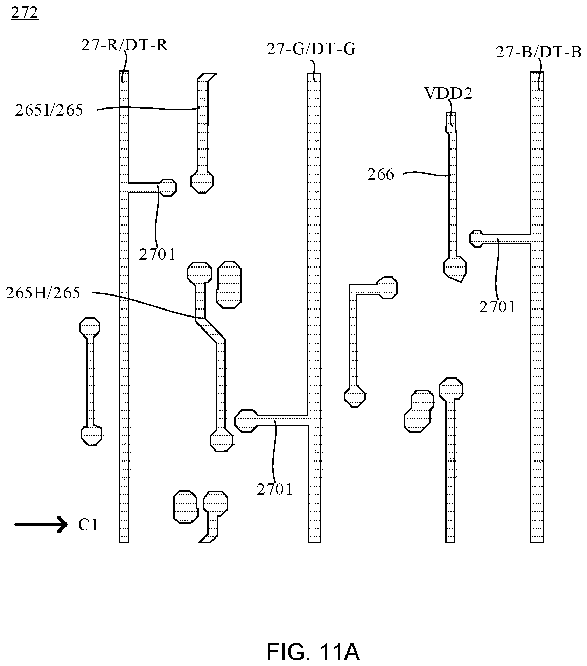

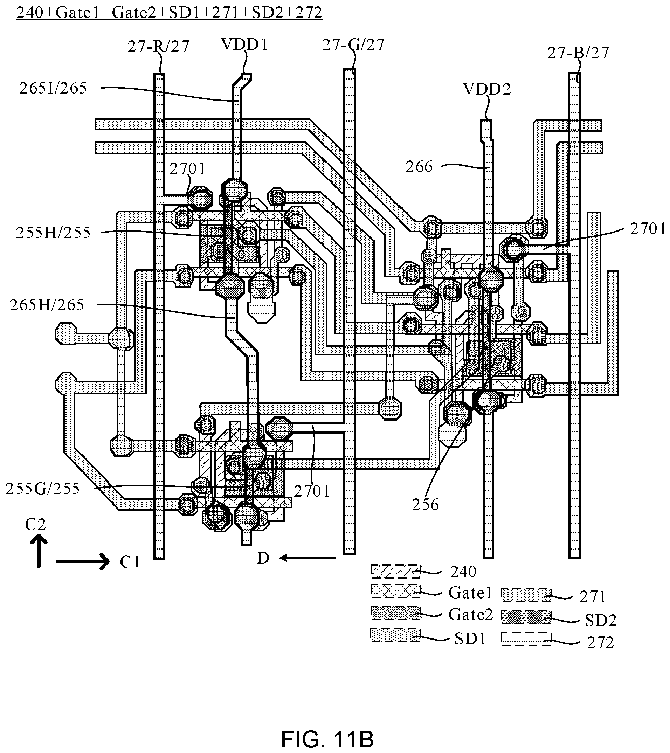

Referring to FIGS. 11A and 11B, the display panel 200 further includes a second transparent wiring layer 272, the second transparent wiring layer 272 is located between the substrate 210 and the light-emitting devices 232, and the second transparent wiring layer 272 is located on a side of the second source-drain metal layer SD2 away from the second gate metal layer Gate2.

In some examples, the second source-drain metal layer SD2 is located on a side of the first source-drain metal layer SD1 away from the substrate 210. A material of the second source-drain metal layer SD2 is metal, such as Al, Ag, Cu, or Cr. A material of the second transparent wiring layer 272 is a transparent conductive oxide material, such as ITO or IZO.

In a case where the display panel 200 further includes a first source-drain metal layer SD1 and a first transparent wiring layer 271, in some examples, the first source-drain metal layer SD1, the second source-drain metal layer SD2, the first transparent wiring layer 271 and the second transparent wiring layer 272 are sequentially disposed on a side of the second gate metal layer Gate2 away from the substrate 210.

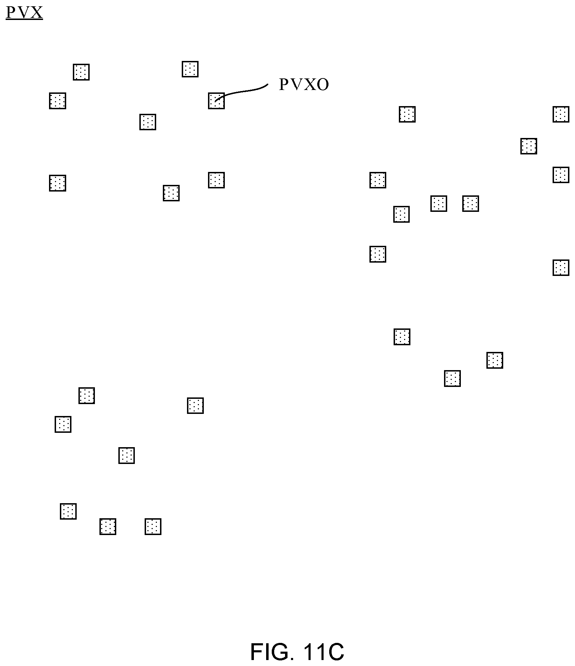

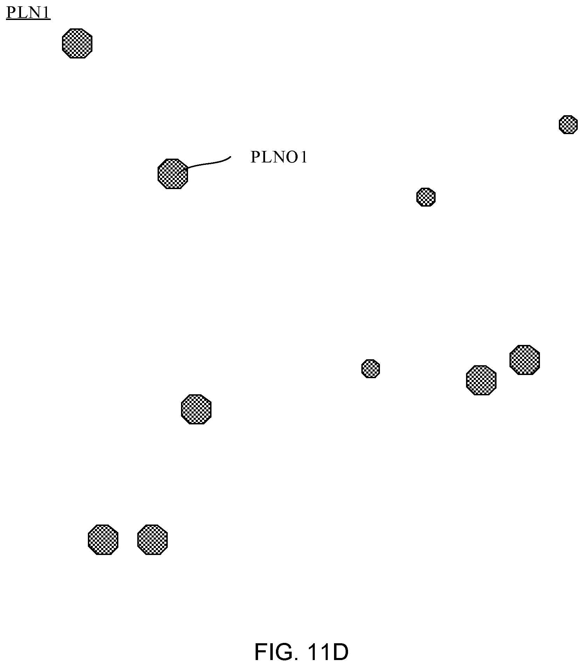

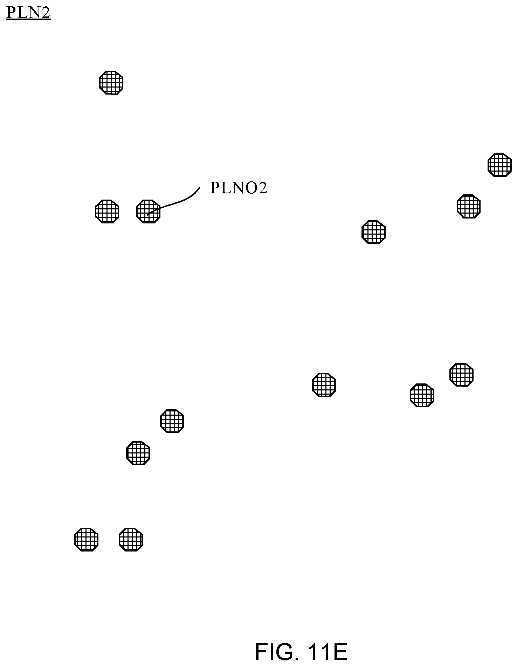

In some other examples, the first source-drain metal layer SD1, the first transparent wiring layer 271, the second source-drain metal layer SD2 and the second transparent wiring layer 272 are sequentially disposed on a side of the second gate metal layer Gate2 away from the substrate 210. Referring to FIG. 11C, a passivation layer PVX is provided between the first source-drain metal layer SD1 and the first transparent wiring layer 271, and the passivation layer PVX is provided with a plurality of via holes PVXO therein. Referring to FIG. 11D, a first planarization layer PLN1 is provided between the first transparent wiring layer 271 and the second source-drain metal layer SD2, and the first planarization layer PLN1 is provided with a plurality of via holes PLNO1 therein. Referring to FIG. 11E, a second planarization layer PLN2 is provided between the second source-drain metal layer SD2 and the second transparent wiring layer 272, and the second planarization layer PLN2 is provided with a plurality of via holes PLNO2 therein.

Referring to FIG. 11B, at least one signal line further includes a first power signal line VDD1, and the first power signal line VDD1 extends in the column direction Y. A first power signal line VDD1 is electrically connected to first plates Cst1 of capacitors Cst in second sub-pixels 230G and first plates Cst1 of capacitors Cst in third sub-pixels 230R in a column of first pixel units 220.

The first power signal line VDD1 extends in the column direction Y, which means that the main pattern of the first power signal line VDD1 tends to extend in a certain column direction Y. The pattern of the first power signal line VDD1 may be a straight line pattern or a substantially straight line pattern.

The first power signal line VDD1 is used to transmit the first-type power signal. The first power signal line VDD1 is electrically connected to the first plate Cst1 of the capacitor Cst, thereby transmitting the first-type power signal to the first plate Cst1.

Referring to FIG. 11B, the metal lines 255 of the first power signal line VDD1 are located in the second source-drain metal layer SD2. At least part of orthographic projections of the metal lines 255 of the first power signal line VDD1 on the substrate 210 is located within the orthographic projection of the light-emitting device 232 of the second sub-pixel 230G and the orthographic projection of the light-emitting device 232 of the third sub-pixel 230R on the substrate 210. The transparent connection lines 265 of the first power signal line VDD1 are located in the second transparent line layer 272. The transparent connection line 265 of the first power signal line VDD1 is connected to the metal line 255 of the first power signal line VDD1 through a via hole. The light-emitting device 232 of the second sub-pixel 230G and the light-emitting device 232 of the third sub-pixel 230R are not shown in FIG. 11B, and may be reference to FIG. 5C.

In some other examples, referring to FIG. 11B, at least part of the orthographic projections of the metal lines 255 of the first power signal line VDD1 on the substrate 210 is located within the orthographic projections of the anode AND-G of the second sub-pixel 230G and the anode AND-R of the third sub-pixel 230R on the substrate 210. The anode AND-G of the second sub-pixel 230G and the anode AND-R of the third sub-pixel 230R are not shown in FIG. 11B, and may be reference to FIG. 5C.

In some examples, referring to FIG. 11B, the first power signal line VDD1 includes a plurality of metal lines 255, and the plurality of metal lines 255 of the first power signal line VDD1 include a seventh metal line segment 255G and an eighth metal line segment 255H.

In some examples, an entirety of an orthographic projection of the seventh metal line segment 255G on the substrate 210 is located within the orthographic projection of the light-emitting device 232 of the second sub-pixel 230G on the substrate 210. An entirety of an orthographic projection of the eighth metal line segment 255H on the substrate 210 is located within the orthographic projection of the light-emitting device 232 of the third sub-pixel 230R on the substrate 210. In this case, the seventh metal line segment 255G is electrically connected to the eighth metal line segment 255H through a transparent connection line 265. The transparent connection line 265 extend to be under the light-emitting device 232 of the third sub-pixel 230R and to be under the light-emitting device 232 of the second sub-pixel 230G.

In some other examples, part of the orthographic projection of the seventh metal line segment 255G on the substrate 210 is located within the orthographic projection of the light-emitting device 232 of the second sub-pixel 230G on the substrate 210, and the remaining part is located outside the orthographic projection of light-emitting device 232 of the second sub-pixel 230G on the substrate 210. Part of the orthographic projection of the eighth metal line segment 255H on the substrate 210 is located within the orthographic projection of the light-emitting device 232 of the third sub-pixel 230R on the substrate 210, and the remaining part is located outside the orthographic projection of the light-emitting device 232 of the third sub-pixel 230R on the substrate 210.

In some examples, referring to FIG. 11B, the first power signal line VDD1 includes a plurality of transparent connection lines 265, and the plurality of transparent connection lines 265 include an eighth transparent connection line segment 265H and a ninth transparent connection line segment 265I.

In a single first pixel unit 220, a seventh metal line segment 255G electrically connected to the second sub-pixel 230G is electrically connected to an eighth metal line segment 255H electrically connected to the third sub-pixel 230R by an eighth transparent connection line 265H.

An eighth metal line segment 255H electrically connected to a third sub-pixel 230R in a first pixel unit 220 is electrically connected to a seven metal line segment 255G electrically connected to a second sub-pixel 230G in an adjacent first pixel unit 220 in the second designated direction C2 by a ninth transparent connection line segment 265I.

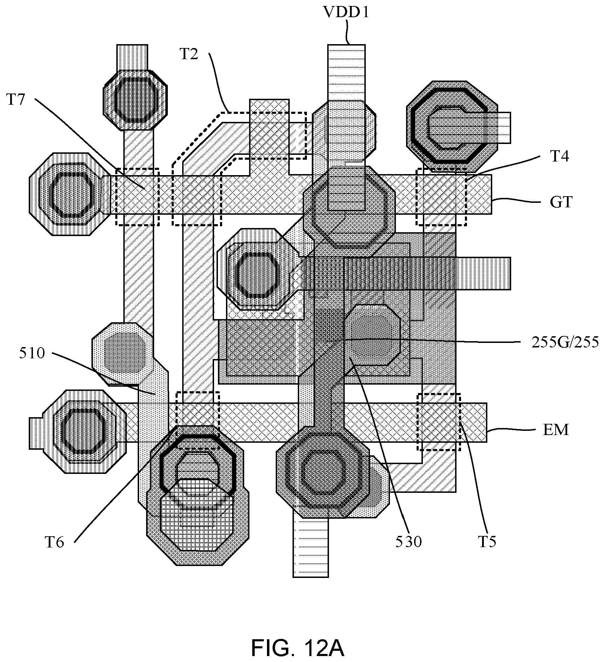

In some examples, referring to FIG. 12A, the seventh metal line segment 255G of the first power signal line VDD1 is connected to the third bridge pattern 530 located under the light-emitting device 232 of the second sub-pixel 230G through a via hole, so that the first-type power signal is transmitted to the first plate Cst1 of the capacitor Cst and the active layer T5-P of the first light-emitting control transistor T5 in the second sub-pixel 230G through the third bridge pattern 530.

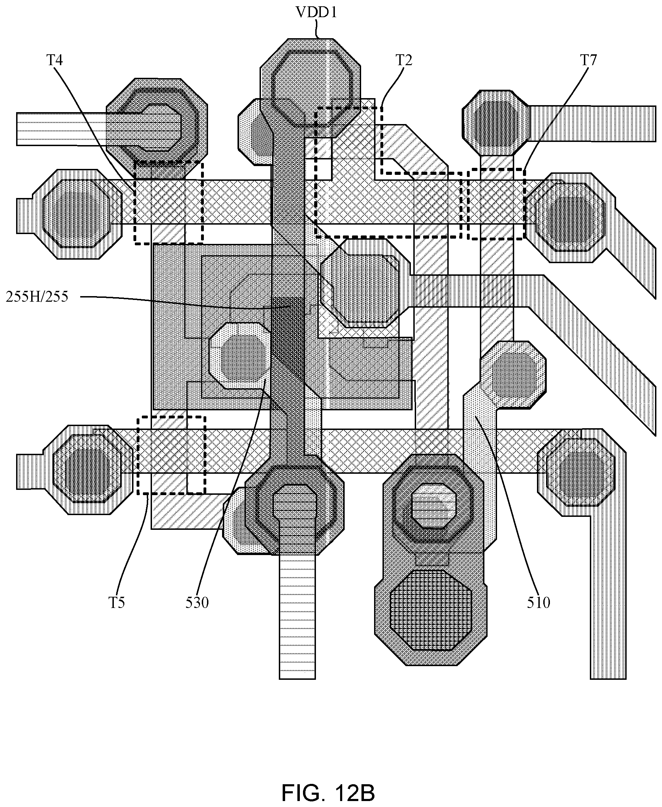

In some examples, referring to FIG. 12B, the eighth metal line segment 255H of the first power signal line VDD1 is connected to the third bridge pattern 530 located under the light-emitting device 232 of the third sub-pixel 230R through a via hole, so that the first-type power signal is transmitted to the first plate Cst1 of the capacitor Cst and the active layer T5-P of the first light-emitting control transistor T5 in the third sub-pixel 230R through the third bridge pattern 530.

In some embodiments, referring to FIG. 11B, at least one signal line further includes a second power signal line VDD2, and the second power signal line VDD2 extends in the column direction Y; a second power signal line VDD2 is electrically connected to first plates Cst1 of capacitors Cst of first sub-pixel 230B in a column of first pixel units 220.

The second power signal line VDD2 extends in the column direction Y, which means that the main pattern of the second power signal line VDD2 tends to extend in a certain column direction Y. The pattern of the second power signal line VDD2 may be a straight line pattern or a substantially straight line pattern.

The second power signal line VDD2 is used to transmit the first-type power signal. The second power signal line VDD2 is electrically connected to the first plate Cst1 of the capacitor Cst of the first sub-pixel 230B, thereby transmitting the first-type power signal to the first plate Cst1 of the first sub-pixel 230B.

Referring to FIG. 11B, the metal lines 256 of the second power signal line VDD2 are located in the second source-drain metal layer SD2, and an orthographic projection of the metal line 256 of the second power signal line VDD2 on the substrate 210 is at least partially located within the orthographic projection of the light-emitting device 232 of first sub-pixel 230B on the substrate 210; the transparent connection lines 266 of the second power signal line VDD2 are located in the second transparent wiring layer 272, and the transparent connection line 266 of the second power signal line VDD2 266 is connected to the metal line 256 of the second power signal line VDD2 through a via hole. The light-emitting device 232 of the first sub-pixel 230B is not shown in FIG. 11B, and may be reference to FIG. 5C.

In some examples, an entirety of the orthographic projection of the metal line 256 of the second power signal line VDD2 on the substrate 210 is within the orthographic projection of the light-emitting device 232 of the first sub-pixel 230B on the substrate 210. In this case, the orthographic projection of the transparent connection line 266 of the second power signal line VDD2 on the substrate 210 partially overlaps with the orthographic projection of the light-emitting device 232 of the first sub-pixel 230B on the substrate 210.

In some other examples, part of the orthographic projection of the metal line 256 of the second power signal line VDD2 on the substrate 210 is located within the orthographic projection of the light-emitting device 232 of the first sub-pixel 230B on the substrate 210.

In some other examples, the orthographic projection of the metal line 256 of the second power signal line VDD2 on the substrate 210 is at least partially located within the orthographic projection of the anode AND-B of the first sub-pixel 230B on the substrate 210.

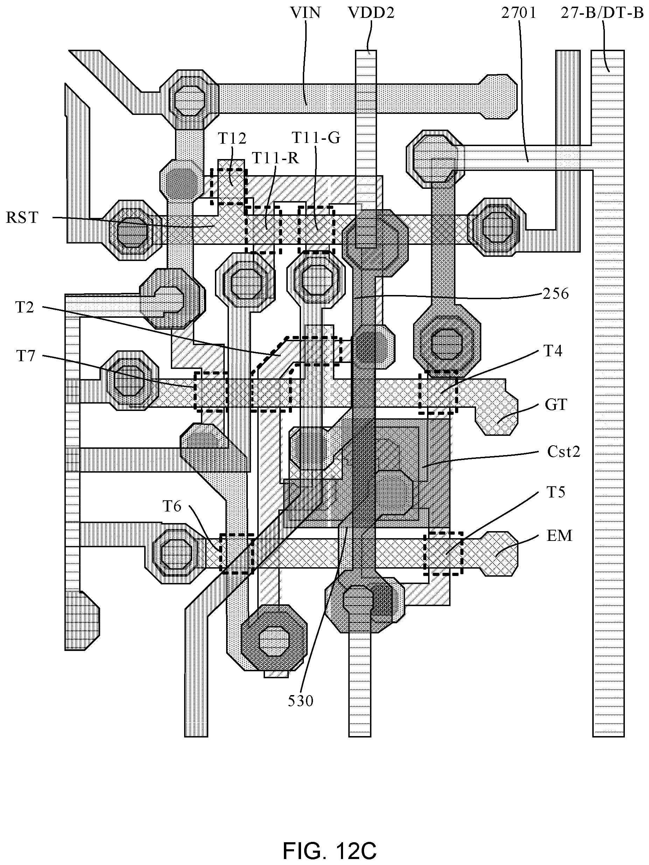

In some examples, referring to FIG. 12C, the metal line 256 of the second power signal line VDD2 is connected to the third bridge pattern 530 located under the light-emitting device 232 of the first sub-pixel 230B through a via hole, so that the first-type power signal is transmitted to the first plate Cst1 of the capacitor Cst and the active layer T5-P of the first light-emitting control transistor T5 in the first sub-pixel 230B through the third bridge pattern 530.

The reset signal line RST, the scan signal line GT, the light-emitting control signal line EM, the first power signal line VDD1 and the second power signal line VDD2 in the display panel 200 have been described above. In addition to the above signal lines, the display panel 200 further includes data lines DT. In some embodiments, referring to FIG. 11B, the display panel 200 further includes a plurality of data lines DT, and the plurality of data lines DT each extend in the column direction Y

The data line DT extends in the column direction Y, which means that the main pattern of the data line DT tends to extend in a certain column direction Y. The pattern of the data line DT may be a straight line pattern or a substantially straight line pattern.

Referring to FIG. 11B, orthographic projections of portions of the plurality of data lines DT located in the first display region A1 on the substrate 210 are located outside the orthographic projection of the light-emitting device 232 of any sub-pixel 230 on the substrate 210.

Therefore, the data lines DT do not occupy the space under the light-emitting devices 232, thereby increasing the space occupied by the pixel driving circuits 231 under the light-emitting devices 232, and preventing the pixel driving circuits 231 under the light-emitting devices 232 from being too compact.

A portion of at least one data line DT located in the first display region A1 is located in the second transparent wiring layer 272. The portion of the data line DT located in the first display region A1 is disposed in the second transparent wiring layer 272. Thus, the portion of the data line DT located in the first display region A1 will not block the light, thereby improving the light transmittance of the first display region A1 of the display panel 200.

Referring to FIG. 7C, the circuit body 2311 of the pixel driving circuit 231 includes a writing transistor T4. In a single first pixel unit 220, the first electrode of the writing transistor T4 of the first sub-pixel 230B, the first electrode of the writing transistor T4 of the second sub-pixel 230G and the first electrode of the writing transistor T4 of the third sub-pixel 230R are respectively connected to different data lines DT. The writing transistor T4 of the first sub-pixel 230B, the first electrode of the writing transistor T4 of the second sub-pixel 230G, and the writing transistor T4 of the third sub-pixel 230R are not shown in FIG. 7C, and may be reference to FIG. 5D.

The data line DT is used to transmit a data signal. In each sub-pixel 230, the first electrode of the writing transistor T4 is electrically connected to the data line DT, so that the data signal may be transmitted to the first electrode of the writing transistor T4. In a single first pixel unit 220, multiple sub-pixels 230 are respectively connected to different data lines DT, the voltages of data signals in different data lines DT may be different, so that the light-emitting devices 232 in different sub-pixels 230 may have different grayscales.

In addition, in some of the above embodiments, in a single first pixel unit 220, the first reset transistors T11 and the second reset transistors T12 in the plurality of sub-pixels 230 are turned on simultaneously, so that the pixel driving circuits 231 in the plurality of sub-pixels 230 are in a reset period at the same time. The compensation transistors T2, the writing transistors T4 and the third reset transistors T7 are turned on simultaneously, so that the pixel driving circuits 231 in the plurality of sub-pixels 230 are in the data refresh and compensation period t2 at the same time. In the data refresh and compensation period t2, the data signal is written in to the control electrode of the driving transistor T3 via the writing transistor T4 and the compensation transistor T2, so that the data signal is written into the pixel driving circuits 231 in a first pixel unit 220 at the same time. The first light-emitting control transistor T5 and the second light-emitting control transistor T6 are turned on simultaneously, so that the pixel driving circuits 231 in the plurality of sub-pixels 230 are in the light-emitting period t3 at the same time. In summary, in a first pixel unit 220, the plurality of sub-pixels 230 emit light at the same time.

In some embodiments, referring to FIG. 7C, a portion of at least one data line DT located in the first display region A1 is a transparent line segment 27.

The transparent line segment 27 is located in the second transparent wiring layer 272. In addition to the transparent line segment 27, the second transparent wiring layer 272 further includes a transparent connection pattern 2701; the transparent connection pattern 2701 extends generally in the row direction X; an end of the transparent connection pattern 2701 is connected to the transparent line segment 27, and the other end of the transparent connection pattern 2701 is electrically connected to the active layer T4-P of the writing transistor T4.

In some examples, referring to FIG. 9A, the first source-drain metal layer SD1 further includes fourth bridge patterns 540. Both the first transparent wiring layer 271 and the second source-drain metal layer SD2 are provided with transfer patterns therein. The end of the transparent connection pattern 2701 away from the transparent line segment 27 is connected to the transfer pattern via hole in the second source-drain metal layer SD2 through a via hole, and the transfer pattern in the second source-drain metal layer SD2 is connected to the transfer pattern in the first transparent wiring layer 271 through a via hole. The transfer pattern in the first transparent wiring layer 271 is connected to the fourth bridge pattern 540 through a via hole, and the fourth bridge pattern 540 is connected to the active layer T4-P of the writing transistor T4 through a via hole, so that the data signal is transmitted to the first electrode of the writing transistor T4. By arranging the fourth bridge pattern 540 and a plurality of transfer patterns between the transparent connection pattern 2701 and the active layer T4-P of the writing transistor T4, a depth of the via hole may be reduced. The deeper the via hole, the greater the impedance. Thus, the impedance may be reduced in some examples of the present disclosure.

In some examples, the portion of each data line DT located in the first display region A1 is located in the second transparent wiring layer 272, that is, each data line DT includes a transparent line segment 27.

Referring to FIG. 11B, in a same column of first pixel units 220, an orthographic projection of a transparent line segment 27-B of the data line DT-B electrically connected to the writing transistor T4 in the first sub-pixel 230B on the substrate 210 is located on a side of the orthographic projection of the circuit body 2311-B of the first sub-pixel 230B on the substrate 210 away from the orthographic projection of the circuit body 2311-G of the second sub-pixel 230G on the substrate 210.

The orthographic projection of the light-emitting device 232 of the second sub-pixel 230G on the substrate 210 and the orthographic projection of the light-emitting device 232 of the third sub-pixel 230R on the substrate 210 are located between the orthographic projection of transparent line segment 27-G of the data line DT-G electrically connected to the writing transistor T4 in the second sub-pixel 230G on the substrate 210 and the orthographic projection of transparent line segment 27-R of the data line DT-R electrically connected to the writing transistor T4 in the third sub-pixel 230R on the substrate 210.

The transparent line segment 27-G electrically connected to the second sub-pixel 230G and the transparent line segment 27-R electrically connected to the third sub-pixel 230G are respectively arranged in two sides of the column where the second sub-pixel 230G and the third sub-pixel 230G are located.

In some examples, referring to FIGS. 11A and 11B, the transparent line segment 27-R, the transparent line segment 27-G, and the transparent line segment 27-B are sequentially arranged in the first designated direction C1.

In some other examples, the transparent line segment 27-G, the transparent line segment 27-R, and the transparent line segment 27-B are sequentially arranged in the first designated direction C1.

In some embodiments, referring to FIG. 5D, in a single first pixel unit 220, the third reset transistor T7, the compensation transistor T2 and the writing transistor T4 in the first sub-pixel 230B are sequentially away from the circuit body 2311-G of the second sub-pixel 230G. That is, the third reset transistor T7, the compensation transistor T2 and the writing transistor T4 in the first sub-pixel 230B are sequentially away from the column where the second sub-pixel 230G and the third sub-pixel 230R are located, so that the transparent line segment 27-B electrically connected to the first sub-pixel 230B is located on a side of the first sub-pixel 230B away from the column where the second sub-pixel 230G and the third sub-pixel 230R are located.

In some embodiments, referring to FIG. 5D, in a single first pixel unit 220, the writing transistor T4, the compensation transistor T2 and the third reset transistor T7 in the second sub-pixel 230G are sequentially arranged in a first set direction; the writing transistor T4, the compensation transistor T2 and the third reset transistor T7 in the third sub-pixel 230R are sequentially arranged in an opposite direction of the first set direction.

Referring to FIG. 11B and combined with FIG. 5D, the transparent line segment 27 is electrically connected to the active layer T4-P of the writing transistor T4. For the second sub-pixel 230G and the third sub-pixel 230R, in one sub-pixel 230, the writing transistor T4 is located on a side of the compensation transistor T2 away from the first sub-pixel 230B; in the other sub-pixel 230, the writing transistor T4 is located on a side of the compensation transistor T2 proximate to the first sub-pixel 230B. Therefore, the transparent line segment 27-G electrically connected to the second sub-pixel 230G and the transparent line segment 27-R of the third sub-pixel 230R may be respectively arranged on two sides of the column where the second sub-pixel 230G and the third sub-pixel 230R are located, which may facilitate the connection between the transparent line segment 27-R and the writing transistor T4 of the third sub-pixel 230R and facilitate the connection between the transparent line segment 27-G and the writing transistor T4 of the second sub-pixel 230G.

In some examples, referring to FIG. 11B, the first set direction D is opposite to the first designated direction C1. In this case, the transparent line segment 27-R electrically connected to the third sub-pixel 230R, the transparent line segment 27-G electrically connected to the second sub-pixel 230G, and the transparent line segment 27-B electrically connected to the first sub-pixel 230B are sequentially arranged in the first designated direction C1.

In some other examples, the first set direction D is the same as the first designated direction C1, the transparent line segment 27-G electrically connected to the second sub-pixel 230G, the transparent line segment 27-R electrically connected to the third sub-pixel 230R, and the transparent line segment 27-B electrically connected to the first sub-pixel 230B are sequentially arranged in the first designated direction C1.

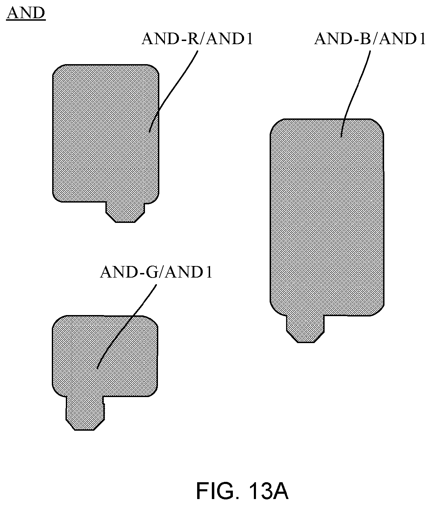

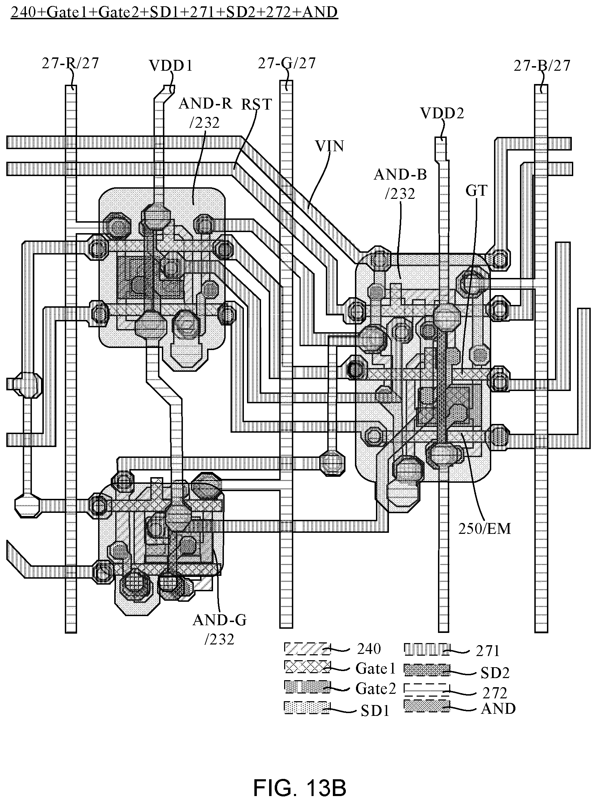

Referring to FIGS. 13A and 13B, the display panel 200 further includes an anode layer AND. The anode layer AND includes a plurality of anodes AND1, such as the anode AND-B of the first sub-pixel 230B, the anode AND-G of the second sub-pixel 230G, and the anode AND-R of the third sub-pixel 230R.

In some embodiments, referring to FIG. 2B, in addition to the first display region A1, the display panel 200 further includes a second display region A2; the first display region A1 is provided with first pixel units 220 therein; the second display region A2 is provided with a plurality of second pixel units 290 therein, and the plurality of second pixel units 290 are arranged in a plurality of rows and a plurality of columns; the second pixel unit 290 includes a plurality of sub-pixels 291. The plurality of sub-pixels 291 include a first sub-pixel 291B, a second sub-pixel 291G and a third sub-pixel 291R.

The second display region A2 is located on at least one side of the first display region A1. In some examples, the second display region A2 may be disposed on one or more sides of the first display region A1. In some other examples, the second display region A2 may be disposed around the first display region A1. It will be noted that in FIG. 2B, a region framed by the smaller dotted box is the first display region A1, and the larger dotted box is located outside the smaller dotted box, a region between the smaller dotted box and the larger dotted box is the second display region A2, and the first display region A1 and the second display region A2 together constitute the display region AA.

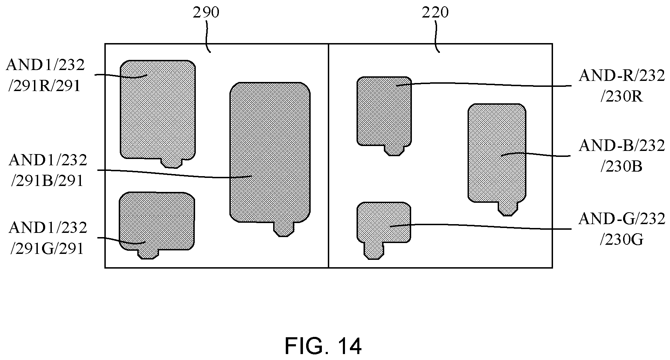

Referring to FIG. 14, the sub-pixel 291 of the second pixel unit 290 includes a light-emitting device 232. An area of the light-emitting device 232 of the first sub-pixel 291B of the second pixel unit 290 is greater than an area of the light-emitting device 232 of the second sub-pixel 291G of the second pixel unit 290, and is greater than an area of the light-emitting device 232 of the third sub-pixel 291R of the second pixel unit 290.

The light-emitting device 232 includes an AND1. In some examples, an area of the anode AND1 of the first sub-pixel 291B of the second pixel unit 290 is greater than an area of the anode AND1 of the second sub-pixel 291G of the second pixel unit 290, and is greater than an area of the anode AND1 of the third sub-pixel 291R of the second pixel unit 290.

In some embodiments, the area of the light-emitting device 232 of the sub-pixel 230 in the first display region A1 is 0.4 to 0.6 times the area of the light-emitting device 232 of the sub-pixel 291 of the same color in the second display region A2.

In some examples, in the second display region A2, for the second pixel unit 290, the first sub-pixel 291B may be a blue sub-pixel, the second sub-pixel 291G may be a green sub-pixel, and the third sub-pixel 291R may be a red sub-pixel.

It can be seen from the above, in some examples, in the first display region A1, for the first pixel unit 220, the first sub-pixel 230B is a blue sub-pixel, the second sub-pixel 230G is a green sub-pixel, and the third sub-pixel 230R is a red sub-pixel.

In some examples, the area of the light-emitting device 232 of the first sub-pixel 230B of the first pixel unit 220 is 0.4 to 0.6 times the area of the light-emitting device 232 of the first sub-pixel 291B of the second pixel unit 290, so as to avoid a low light transmittance of the first display region A1 caused by a fact that the area of the light-emitting device 232 of the first sub-pixel 230B of the first pixel unit 220 is too large (e.g., greater than 0.6 times the area of the light-emitting device 232 of the first sub-pixel 291B). Furthermore, it may also be possible to prevent the coupling from occurring between structures caused by a fact that the structure of the pixel driving circuit 231 of the light-emitting device 232 of the first sub-pixel 230B of the first pixel unit 220 is too compact, which due to a small area occupied by the pixel driving circuit 231 under the light-emitting device 232 of the first sub-pixel 230B of the first pixel unit 220 caused by a fact that the area of the light-emitting device 232 of the first sub-pixel 230B of the first pixel unit 220 is too small (e.g., less than 0.4 times the area of the light-emitting device 232 of the first sub-pixel 291B).

For example, the area of the light-emitting device 232 of the first sub-pixel 230B of the first pixel unit 220 is 0.5 times the area of the light-emitting device 232 of the first sub-pixel 291B of the second pixel unit 290.

Referring to FIG. 14, the area of the light-emitting device 232 of the second sub-pixel 230G of the first pixel unit 220 is 0.4 to 0.6 times the area of the light-emitting device 232 of the second sub-pixel 291G of the second pixel unit 290, which may avoid a low light transmittance of the first display region A1 caused by a fact that the area of the light-emitting device 232 of the second sub-pixel 230G of the first pixel unit 220 is too large (e.g., greater than 0.6 times the area of the light-emitting device 232 of the second sub-pixel 291G). Furthermore, it may also be possible to prevent the coupling from occurring between structures caused by a fact that the structure of the circuit body 2311-G of the second sub-pixel 230G of the first pixel unit 220 is too compact, which due to a small area occupied by the circuit body 2311-G of the second sub-pixel 230G under the light-emitting device 232 of the second sub-pixel 230G of the first pixel unit 220 caused by a fact that the area of the light-emitting device 232 of the second sub-pixel 230G of the first pixel unit 220 is too small (e.g., less than 0.4 times the area of the light-emitting device 232 of the second sub-pixel 291G).

For example, the area of the light-emitting device 232 of the second sub-pixel 230G of the first pixel unit 220 is 0.5 times the area of the light-emitting device 232 of the second sub-pixel 291G of the second pixel unit 290.

Referring to FIG. 14, the area of the light-emitting device 232 of the third sub-pixel 230R of the first pixel unit 220 is 0.4 to 0.6 times the area of the light-emitting device 232 of the third sub-pixel 291R of the second pixel unit 290. In this way, it may be possible to avoid a low light transmittance of the first display region A1 caused by a fact that the area of the light-emitting device 232 of the third sub-pixel 230R of the first pixel unit 220 is too large (e.g., greater than 0.6 times the area of the light-emitting device 232 of the third sub-pixel 291R). Furthermore, it may also be possible to prevent the coupling from occurring between structures caused by a fact that the structure of the circuit body 2311-R of the third sub-pixel 230R is too compact, which due to a small area occupied by the circuit body 2311-R of the third sub-pixel 230R under the light-emitting device 232 of the third sub-pixel 230R of the first pixel unit 220 caused by a fact that the area of the light-emitting device 232 of the third sub-pixel 230R of the first pixel unit 220 is too small (e.g., less than 0.4 times the area of the light-emitting device 232 of the third sub-pixel 291R).

For example, the area of the light-emitting device 232 of the third sub-pixel 230R of the first pixel unit 220 is 0.5 times the area of the light-emitting device 232 of the third sub-pixel 291R of the second pixel unit 290.

In some examples, the density of the sub-pixels in the first display region A1 is equal to the density of the sub-pixels in the second display region A2. It will be noted that the density of the sub-pixels in the first display region A1 refers to the number of sub-pixels 230 per unit area in the first display region A1; the density of the sub-pixels in the second display region A2 refers to the number of sub-pixels 291 per unit area in the second display region A2.

Although the area of the light-emitting device 232 of the sub-pixel 291 in the second display region A2 is greater than the area of the light-emitting device 232 of the sub-pixel 230 of the same color in the first display region A1, the density of the sub-pixels in the first display region A1 is equal to the density of the sub-pixels in the second display region A2. Therefore, the display difference between the first display region A1 and the second display region A2 may be reduced.

In addition, the light transmittance of the first display region A1 is greater than the light transmittance of the second display region A2, thereby ensuring that the sensor 300 may sense sufficient light.

The structure of the light-emitting device 232 of the sub-pixel 291 is the same as the structure of the light-emitting device 232 of the sub-pixel 230, and will not be repeated here. It will be understood that among the cathode CTD1, light-emitting layer EL and anode AND1 of a sub-pixel 291, if the area of the cathode CTD1 is the largest, the area of the light-emitting device 232 of the sub-pixel 291 is the area of the cathode CTD1; if the area of the anode AND1 is the largest, the area of the light-emitting device 232 of the sub-pixel 291 is the area of the anode AND1; and if the area of the light-emitting layer EL is the largest, the area of the light-emitting device 232 of the sub-pixel 291 is the area of the light-emitting layer EL.

The display apparatus 100 provided in some embodiments of the present disclosure includes the display panel 200 provided in any of the embodiments. Therefore, the display apparatus 100 provided in some embodiments of the present disclosure has all the beneficial effects achieved by the display panel 200 provided by some embodiments above, which will not be repeated here.

The protection scope of the present disclosure shall be determined by the protection scope of the claims.

## Claims

1. A display panel (200), comprising:
a substrate (210); and
a plurality of first pixel units (220) located on a side of the substrate (210) and arranged in a plurality of rows and a plurality of columns; wherein a first pixel unit (220) includes a plurality of sub-pixels (230), a sub-pixel (230) includes a pixel driving circuit (231) and a light-emitting device (232); the light-emitting device (232) is located on a side of the pixel driving circuit (231) away from the substrate (210) and is electrically connected to the pixel driving circuit (231); the pixel driving circuit (231) includes a first reset transistor (T11);
the plurality of sub-pixels (230) include a first sub-pixel (230B), a second sub-pixel (230G) and a third sub-pixel (230R); an area of a light-emitting device (232) of the first sub-pixel (230B) is greater than an area of a light-emitting device (232) of the second sub-pixel (230G) and greater than an area of a light-emitting device (232) of the third sub-pixel (230R); and
**characterized in that**
an orthographic projection of a first reset transistor (T11-G) of the second sub-pixel (230G) and/or a first reset transistor (T11-R) of the third sub-pixel (230R) on the substrate (210) is located within an orthographic projection of the light-emitting device (232) of the first sub-pixel (230B)on the substrate (210).

2. The display panel (200) according to claim 1, wherein
orthographic projections of the first reset transistor (T11-B) of the first sub-pixel (230B), the first reset transistor (T11-G) of the second sub-pixel (230G) and the first reset transistor (T11-R) of the third sub-pixel (230R) on the substrate (210) are all located within the orthographic projection of the light-emitting device (232) of the first sub-pixel (230B) on the substrate (210); and/or
at least two of the first reset transistor (T11-B) of the first sub-pixel (230B), the first reset transistor (T11-G) of the second sub-pixel (230G), and the first reset transistor (T11-R) of the third sub-pixel (230R) are a same transistor.

3. The display panel (200) according to any one of claims 1 to 2, wherein
the pixel driving circuit (231) further includes a second reset transistor (T12); a second reset transistor (T12) of the first sub-pixel (230B), a second reset transistor (T12) of the second sub-pixel (230G) and a second reset transistor (T12) of the third sub-pixel (230R) are a same transistor; an orthographic projection of the second reset transistor (T12) on the substrate (210) is located within the orthographic projection of the light-emitting device (232) of the first sub-pixel (230B) on the substrate (210); the second reset transistor (T12) is connected to any first reset transistor (T11) in series;
the display panel (200) further comprises a reset signal line (RST) and an initialization signal line (VIN); wherein a control electrode of each first reset transistor (T11) and a control electrode of the second reset transistor (T12) are all electrically connected to the reset signal line (RST); a first electrode of the second reset transistor (T12) is electrically connected to the initialization signal line (VIN), and a second electrode of the second reset transistor (T12) is electrically connected to a first electrode of each first reset transistor (T11); and
the pixel driving circuit (231) further includes a driving transistor (T3), and a control electrode of the driving transistor (T3) of each pixel driving circuit (231) is electrically connected to a second electrode of each first reset transistor (T11).

4. The display panel (200) according to claim 3, wherein
the light-emitting device (232) of the second sub-pixel (230G) and the light-emitting device (232) of the third sub-pixel (230R) are arranged spaced apart in a column direction (Y); the light-emitting device (232) of the first sub-pixel (230B) is located in a column adjacent to a column where the light-emitting device (232) of the second sub-pixel (230G) and the light-emitting device (232) of the third sub-pixel (230R) are located, and the light-emitting device (232) of the first sub-pixel (230B) spans a gap region between the light-emitting device (232) of the second sub-pixel (230G) and the light-emitting device (232) of the third sub-pixel (230R);
the pixel driving circuit (231) further includes a circuit body (2311), the circuit body (2311) includes the driving transistor (T3); an orthographic projection of a circuit body (2311-B) of the first sub-pixel (230B) on the substrate (210) is located within the orthographic projection of the light-emitting device (232) of the first sub-pixel (230B) on the substrate (210), an orthographic projection of a circuit body (2311-G) of the second sub-pixel (230G) on the substrate (210) is located within an orthographic projection of the light-emitting device (232) of the second sub-pixel (230G) on the substrate (210), and an orthographic projection of a circuit body (2311-R) of the third sub-pixel (230R) on the substrate (210) is within an orthographic projection of the light-emitting device (232) of the third sub-pixel (230R) on the substrate (210); and
the second reset transistor (T12), the first reset transistor (T11-R) of the third sub-pixel (230R) and the first reset transistor (T11-G) of the second sub-pixel (230G) are located on a side of the first reset transistor (T11-B) of the first sub-pixel (230B) proximate to the circuit body (2311-R) of the third sub-pixel (230R), and are arranged in sequence away from the circuit body (2311-R) of the third sub-pixel (230R).

5. The display panel (200) according to claim 4, wherein
the reset signal line (RST) extends in a row direction (X), and the reset signal line (RST) is electrically connected to control electrodes of second reset transistors (T12) and control electrodes of first reset transistors (T11) in a row of first pixel units (220);
the initialization signal line (VIN) extends in the row direction (X), and the initialization signal line (VIN) is electrically connected to first electrodes of the second reset transistors (T12) in the row of first pixel units (220);
orthographic projections of the second reset transistor (T12) and each first reset transistor (T11) on the substrate (210) are located between an orthographic projection of the initialization signal line (VIN) electrically connected to the second reset transistor (T12) on the substrate (210) and the orthographic projection of the circuit body (2311-B) of the first sub-pixel (230B) on the substrate (210); an orthographic projection of the reset signal line (RST) on the substrate (210) is located between the orthographic projection of the initialization signal line (VIN) on the substrate (210) and the orthographic projection of the circuit body (2311-B) of the first sub-pixel (230B) on the substrate (210).

6. The display panel (200) according to claim 4 or 5, wherein
the substrate (210) includes a first display region (A1), and the plurality of first pixel units (220) are located in the first display region (A1);
the display panel (200) further comprises a plurality of signal lines located between the substrate (210) and the light-emitting device (232); wherein
a portion of at least one signal line located in the first display region (A1) includes a metal line (250) and a transparent connection line (260) that are electrically connected to each other; at least part of an orthographic projection of the metal line (250) on the substrate (210) is located within an orthographic projection of the light-emitting device (232) on the substrate (210).

7. The display panel (200) according to claim 6, comprising:
a first gate metal layer (Gate1) and a first transparent wiring layer (271) both located between the substrate (210) and the light-emitting device (232), the first transparent wiring layer (271) being located on a side of the first gate metal layer (Gate1) away from the substrate (210); wherein
the at least one signal line includes the reset signal line (RST), the reset signal line (RST) extends in the row direction (X), and the reset signal line (RST) is electrically connected to control electrodes of second reset transistors (T12) and control electrodes of first reset transistors (T11) in a row of first pixel units (220);
a metal line (251) of the reset signal line (RST) is located in the first gate metal layer (Gate1), and at least part of an orthographic projection of the metal line (251) of the reset signal line (RST) on the substrate (210) is located within the orthographic projection of the light-emitting device (232) of the first sub-pixel (230B) on the substrate (210); and
a transparent connection line (261) of the reset signal line (RST) is located in the first transparent line layer (271); an orthographic projection of the transparent connection line (261) of the reset signal line (RST) on the substrate (210) is located outside the orthographic projection of the light-emitting device (232) of the second sub-pixel (230G) on the substrate (210), and outside the orthographic projection of the light-emitting device (232) of the third sub-pixel (230R) on the substrate (210); the transparent connection line (261) of the reset signal line (RST) is connected to the metal line (251) of the reset signal line (RST) through a via hole.

8. The display panel (200) according to claim 7, wherein
the circuit body (2311) of the pixel driving circuit (231) further includes a writing transistor (T4), a compensation transistor (T2) and a third reset transistor (T7); wherein
the at least one signal line further includes a scan signal line (GT), and the scan signal line (GT) is connected to control electrodes of writing transistors (T4), control electrodes of compensation transistors (T2) and control electrodes of third reset transistors (T7) of all sub-pixels (230) in the row of first pixel units (220);
a metal line (252) of the scan signal line (GT) is located in the first gate metal layer (Gate1), and at least part of an orthographic projection of the metal line (252) of the scan signal line (GT) on the substrate (210) is located within an orthographic projection of the light-emitting device (232) on the substrate (210);
a transparent connection line (262) of the scan signal line (GT) is located in the first transparent wiring layer (271), and the transparent connection line (262) of the scan signal line (GT) is connected to the metal line (252) of the scan signal line (GT) through a via hole; and/or
the circuit body (2311) of the pixel driving circuit (231) further includes a first light-emitting control transistor (T5) and a second light-emitting control transistor (T6); wherein
the at least one signal line further includes a light-emitting control signal line (EM), and the light-emitting control signal line (EM) is connected to control electrodes of first light-emitting control transistors (T5) and control electrodes of second light-emitting control transistors (T6) of all the sub-pixels (230) in the row of first pixel units (220);
a metal line (253) of the light-emitting control signal line (EM) is located in the first gate metal layer (Gate1), and at least part of an orthographic projection of the metal line (253) of the light-emitting control signal line (EM) on the substrate (210) is located within the orthographic projection of the light-emitting device (232) on the substrate (210); and
a transparent connection line (263) of the light-emitting control signal line (EM) is located in the first transparent wiring layer (271), and the transparent connection line (263) of the light-emitting control signal line (EM) is connected to the metal line (253) of the light-emitting control signal line (EM) through a via hole.

9. The display panel (200) according to any one of claims 6 to 8, comprising a first source-drain metal layer (SD1) and a first transparent wiring layer (271) both located between the substrate (210) and the light-emitting device (232), the first transparent wiring layer (271) being located on a side of the first source-drain metal layer (SD1) away from the substrate (210); wherein
the at least one signal line includes an initialization signal line (VIN), the initialization signal line (VIN) is electrically connected to first electrodes of second reset transistors (T12) in a row of first pixel units (220);
a metal line (254) of the initialization signal line (VIN) is located in the first source-drain metal layer (SD1), and at least part of an orthographic projection of the metal line (254) of the initialization signal line (VIN) on the substrate (210) is located within the orthographic projection of the light-emitting device (232) of the first sub-pixel (230B) on the substrate (210);
a transparent connection line (264) of the initialization signal line (VIN) is located in the first transparent wiring layer (271); an orthographic projection of the transparent connection line (264) of the initialization signal line (VIN) on the substrate (210) is located outside the orthographic projection of the light-emitting device (232) of the second sub-pixel (230G) on the substrate (210) and outside the orthographic projection of the light-emitting device (232) of the third sub-pixel (230R) on the substrate (210); the transparent connection line (264) of the initialization signal line (VIN) is connected to the metal line (254) of the initialization signal line (VIN) through a via hole.

10. The display panel (200) according to any one of claims 6 to 9, comprising a second gate metal layer (Gate1), a second source-drain metal layer (SD2) and a second transparent wiring layer (272) that are located between the substrate (210) and the light-emitting device (232); the second source-drain metal layer (SD2) being located on a side of the second gate metal layer (Gate1) away from the substrate (210), and the second transparent wiring layer (272) being located on a side of the second source-drain metal layer (SD2) away from the second gate metal layer (Gate1); wherein
the circuit body (2311) of the pixel driving circuit (231) further includes a capacitor (Cst), and a first plate (Cst1) of the capacitor (Cst) is located in the second gate metal layer (Gate1);
the at least one signal line includes a first power signal line (VDD1), the first power signal line (VDD1) extends in the column direction (Y), and the first power signal line (VDD1) is connected to first plates (Cst1) of capacitors (Cst) of second sub-pixels (230G) and first plates of capacitors (Cst) of third sub-pixels (230R) in a column of first pixel units (220);
metal lines (255) of the first power signal line (VDD1) are located in the second source-drain metal layer (SD2), and at least part of orthographic projections of the metal lines (255) of the first power signal line (VDD1) on the substrate (210) is located within the orthographic projections of the light-emitting device (232) of the second sub-pixel (230G) and the light-emitting device (232) of the third sub-pixel (230R) on the substrate (210);
a transparent connection line (265) of the first power signal line (VDD1) is located in the second transparent wiring layer (272), and the transparent connection line (265) of the first power signal line (VDD1) is connected to the metal lines (255) of the first power signal line (VDD1) through via holes.

11. The display panel (200) according to claim 10, wherein
the at least one signal line further includes a second power signal line (VDD2), the second power signal line (VDD2) extends in the column direction (Y), and the second power signal lines (VDD2) is connected to first plates (Cst1) of capacitors (Cst) of first sub-pixels (230B) in the column of first pixel units (220);
a metal line (256) of the second power signal line (VDD2) is located in the second source-drain metal layer (SD2), and an orthographic projection of the metal line (256) of the second power signal line (VDD2) on the substrate (210) is at least partially located within the orthographic projection of the light-emitting device (232) of the first sub-pixel (230B) on the substrate (210);
a transparent connection line (266) of the second power signal line (VDD2) is located in the second transparent wiring layer (272), and the transparent connection line (266) of the second power signal line (VDD2) is connected to the metal line (256) of the second power signal line (VDD2) through a via hole.

12. The display panel (200) according to claim 10 or 11, further comprising:
a plurality of data lines (DT) each extending in the column direction (Y), wherein orthographic projections of portions of the plurality of data lines (DT) located in the first display region (A1) on the substrate (210) are located outside an orthographic projection of a light-emitting device (232) of any sub-pixel on the substrate (210), a portion of at least one data line (DT) located in the first display region (A1) is located in the second transparent wiring layer (272); and
the circuit body (2311) of the pixel driving circuit (231) further includes a writing transistor (T4); in the first pixel unit (220), a first electrode of a writing transistor (T4) of the first sub-pixel (230B), a first electrode of a writing transistor (T4) of the second sub-pixel (230G), and a first electrode of a writing transistor (T4) of the third sub-pixel (230R) are respectively connected to different data lines (DT).

13. The display panel (200) according to claim 12, wherein
the portion of the at least one data line (DT) located in the first display region (A1) is a transparent line segment (27); in a same column of first pixel units (220), an orthographic projection of a transparent line segment (27-B) of a data line (DT-B) electrically connected to a writing transistor (T4) of a first sub-pixel (230B) on the substrate (210) is located on a side of an orthographic projection of a circuit body (2311-B) of the first sub-pixel (230B) on the substrate (210) away form an orthographic projection of a circuit body (2311-G) of a second sub-pixel (230G) on the substrate (210), and an orthographic projection of a light-emitting device (232) of the second sub-pixel (230G) on the substrate (210) and an orthographic projection of a light-emitting device (232) of a third sub-pixel (230R) on the substrate (210) are located between an orthographic projection of a transparent line segment (27-G) of a data line (DT-G) electrically connected to a writing transistor (T4) of the second sub-pixel (230G) on the substrate (210) and an orthographic projection of a transparent line segment (27-R) of a data line (DT-R) electrically connected to a writing transistor (T4) of the third sub-pixel (230R) on the substrate (210); or
the portion of the at least one data line (DT) located in the first display region (A1) is a transparent line segment (27); in a same column of first pixel units (220), an orthographic projection of a transparent line segment (27-B) of a data line (DT-B) electrically connected to a writing transistor (T4) of a first sub-pixel (230B) on the substrate (210) is located on a side of an orthographic projection of a circuit body (2311-B) of the first sub-pixel (230B) on the substrate (210) away form an orthographic projection of a circuit body (2311-G) of a second sub-pixel (230G) on the substrate (210), and an orthographic projection of a light-emitting device (232) of the second sub-pixel (230G) on the substrate (210) and an orthographic projection of a light-emitting device (232) of a third sub-pixel (230R) on the substrate (210) are located between an orthographic projection of a transparent line segment (27-G) of a data line (DT-G) electrically connected to a writing transistor (T4) of the second sub-pixel (230G) on the substrate (210) and an orthographic projection of a transparent line segment (27-R) of a data line (DT-R) electrically connected to a writing transistor (T4) of the third sub-pixel (230R) on the substrate (210); the circuit body (2311) of the pixel drive circuit (231) further includes a compensation transistor (T2) and a third reset transistor (T7); wherein
in the first pixel unit (220), a third reset transistor (T7), a compensation transistor (T2) and a writing transistor (T4) of the first sub-pixel (230B) are sequentially away from a circuit body (2311-G) of the second sub-pixel (230G); a writing transistor (T4), a compensation transistor (T2) and a third reset transistor (T7) of the second sub-pixel (230G) are sequentially arranged in a first set direction (D); a writing transistor (T4), a compensation transistor (T2) and a third reset transistor (T7) of the third sub-pixel (230R) are sequentially arranged in an opposite direction of the first set direction (D).

14. The display panel (200) according to any one of claims 1 to 13, wherein
the light-emitting device (232) includes an anode (AND1), a light-emitting layer (EL) and a cathode (CTD1), the anode (AND1) is electrically connected to the pixel driving circuit (231), the light-emitting layer (EL) is located on a side of the anode (AND1) away from the substrate (210), and the cathode (CTD1) is located on a side of the anode (AND1) away from the substrate (210); wherein
the orthographic projection of the first reset transistor (T11-G) of the second sub-pixel (230G) and/or the first reset transistor (T11-R) of the third sub-pixel (230R) on the substrate (210) is located within an orthographic projection of an anode (AND-B) of the first sub-pixel (230B) on the substrate (210); and/or
the display panel (200) comprises: a first display region (A1) and a second display region (A2), the first display region (A1) being provided with the first pixel units (220); wherein
the second display region (A2) is provided with a plurality of second pixel units (290), the plurality of second pixel units (290) are arranged in a plurality of rows and a plurality of columns; a second pixel unit (290) includes a plurality of sub-pixels (291), and density of sub-pixels (230) in the first display region (A1) is equal to density of sub-pixels (291) in the second display region (A2);
an area of a light-emitting device (232) of a sub-pixel (230) in the first display region (A1) is 0.4 to 0.6 times an area of a light-emitting device (232) of a sub-pixel (291) of a same color in the second display region (A2).

15. A display apparatus (100), comprising:
the display panel (200) according to any one of claims 1 to 14.

## Patentansprüche

1. Anzeigetafel (200), umfassend:
ein Substrat (210); und
eine Vielzahl von ersten Pixeleinheiten (220), die sich auf einer Seite des Substrats (210) befinden und in einer Vielzahl von Zeilen und einer Vielzahl von Spalten angeordnet sind; wobei eine erste Pixeleinheit (220) eine Vielzahl von Subpixeln (230) einschließt, ein Subpixel (230) eine Pixeltreiberschaltung (231) und eine lichtemittierende Vorrichtung (232) einschließt; wobei die lichtemittierende Vorrichtung (232) auf einer von dem Substrat (210) entfernten Seite der Pixeltreiberschaltung (231) angeordnet ist und elektrisch mit der Pixeltreiberschaltung (231) verbunden ist; wobei die Pixeltreiberschaltung (231) einen ersten Rücksetztransistor (T11) einschließt;
wobei die Vielzahl von Subpixeln (230) ein erstes Subpixel (230B), ein zweites Subpixel (230G) und ein drittes Subpixel (230R) einschließt; wobei eine Fläche einer lichtemittierenden Vorrichtung (232) des ersten Subpixels (230B) größer ist als eine Fläche einer lichtemittierenden Vorrichtung (232) des zweiten Subpixels (230G) und größer ist als eine Fläche einer lichtemittierenden Vorrichtung (232) des dritten Subpixels (230R); und
**dadurch gekennzeichnet, dass**
sich eine orthographische Projektion eines ersten Rücksetztransistors (T11-G) des zweiten Subpixels (230G) und/oder eines ersten Rücksetztransistors (T11-R) des dritten Subpixels (230R) auf dem Substrat (210) innerhalb einer orthographischen Projektion der lichtemittierenden Vorrichtung (232) des ersten Subpixels (230B) auf dem Substrat (210) befindet.

2. Anzeigetafel (200) nach Anspruch 1, wobei
orthographische Projektionen des ersten Rücksetztransistors (T11-B) des ersten Subpixels (230B), des ersten Rücksetztransistors (T11-G) des zweiten Subpixels (230G) und des ersten Rücksetztransistors (T11-R) des dritten Subpixels (230R) auf dem Substrat (210) sich alle innerhalb der orthographischen Projektion der lichtemittierenden Vorrichtung (232) des ersten Subpixels (230B) auf dem Substrat (210) befinden; und/oder
mindestens zwei von dem ersten Rücksetztransistor (T11-B) des ersten Subpixels (230B), dem ersten Rücksetztransistor (T11-G) des zweiten Subpixels (230G) und dem ersten Rücksetztransistor (T11-R) des dritten Subpixels (230R) derselbe Transistor sind.

3. Anzeigetafel (200) nach einem der Ansprüche 1 bis 2, wobei
die Pixeltreiberschaltung (231) weiter einen zweiten Rücksetztransistor (T12) einschließt; ein zweiter Rücksetztransistor (T12) des ersten Subpixels (230B), ein zweiter Rücksetztransistor (T12) des zweiten Subpixels (230G) und ein zweiter Rücksetztransistor (T12) des dritten Subpixels (230R) derselbe Transistor sind; sich eine orthographische Projektion des zweiten Rücksetztransistors (T12) auf dem Substrat (210) innerhalb der orthographischen Projektion der lichtemittierenden Vorrichtung (232) des ersten Subpixels (230B) auf dem Substrat (210) befindet; der zweite Rücksetztransistor (T12) mit einem beliebigen ersten Rücksetztransistor (T11) in Reihe geschaltet ist;
die Anzeigetafel (200) weiter eine Rücksetzsignalleitung (RST) und eine Initialisierungssignalleitung (VIN) umfasst; wobei eine Steuerelektrode jedes ersten Rücksetztransistors (T11) und eine Steuerelektrode des zweiten Rücksetztransistors (T12) alle elektrisch mit der Rücksetzsignalleitung (RST) verbunden sind; eine erste Elektrode des zweiten Rücksetztransistors (T12) elektrisch mit der Initialisierungssignalleitung (VIN) verbunden ist, und eine zweite Elektrode des zweiten Rücksetztransistors (T12) elektrisch mit einer ersten Elektrode jedes ersten Rücksetztransistors (T11) verbunden ist; und
die Pixeltreiberschaltung (231) weiter einen Treibertransistor (T3) einschließt, und eine Steuerelektrode des Treibertransistors (T3) jeder Pixeltreiberschaltung (231) elektrisch mit einer zweiten Elektrode jedes ersten Rücksetztransistors (T11) verbunden ist.

4. Anzeigetafel (200) nach Anspruch 3, wobei
die lichtemittierende Vorrichtung (232) des zweiten Subpixels (230G) und die lichtemittierende Vorrichtung (232) des dritten Subpixels (230R) in einer Spaltenrichtung (Y) beabstandet angeordnet sind; wobei sich die lichtemittierende Vorrichtung (232) des ersten Subpixels (230B) in einer Spalte befindet, angrenzend an eine Spalte, in der sich die lichtemittierende Vorrichtung (232) des zweiten Subpixels (230G) und die lichtemittierende Vorrichtung (232) des dritten Subpixels (230R) befinden, und die lichtemittierende Vorrichtung (232) des ersten Subpixels (230B) einen Spaltbereich zwischen der lichtemittierenden Vorrichtung (232) des zweiten Subpixels (230G) und der lichtemittierenden Vorrichtung (232) des dritten Subpixels (230R) überspannt;
die Pixeltreiberschaltung (231) weiter einen Schaltungskörper (2311) einschließt, wobei der Schaltungskörper (2311) den Treibertransistor (T3) einschließt; wobei sich eine orthographische Projektion eines Schaltungskörpers (2311-B) des ersten Subpixels (230B) auf dem Substrat (210) innerhalb der orthographischen Projektion der lichtemittierenden Vorrichtung (232) des ersten Subpixels (230B) auf dem Substrat (210) befindet, wobei sich eine orthographische Projektion eines Schaltungskörpers (2311-G) des zweiten Subpixels (230G) auf dem Substrat (210) innerhalb einer orthographischen Projektion der lichtemittierenden Vorrichtung (232) des zweiten Subpixels (230G) auf dem Substrat (210) befindet, und sich eine orthographische Projektion eines Schaltungskörpers (2311-R) des dritten Subpixels (230R) auf dem Substrat (210) innerhalb einer orthographischen Projektion der lichtemittierenden Vorrichtung (232) des dritten Subpixels (230R) auf dem Substrat (210) befindet; und
wobei sich der zweite Rücksetztransistor (T12), der erste Rücksetztransistor (T11-R) des dritten Subpixels (230R) und der erste Rücksetztransistor (T11-G) des zweiten Subpixels (230G) auf einer Seite des ersten Rücksetztransistors (T11-B) des ersten Subpixels (230B) in der Nähe des Schaltungskörpers (2311-R) des dritten Subpixels (230R) befinden und in Folge weg von dem Schaltungskörper (2311-R) des dritten Subpixels (230R) angeordnet sind.

5. Anzeigetafel (200) nach Anspruch 4, wobei
sich die Rücksetzsignalleitung (RST) in einer Zeilenrichtung (X) erstreckt und die Rücksetzsignalleitung (RST) elektrisch mit Steuerelektroden von zweiten Rücksetztransistoren (T12) und Steuerelektroden von ersten Rücksetztransistoren (T11) in einer Zeile von ersten Pixeleinheiten (220) verbunden ist;
sich die Initialisierungssignalleitung (VIN) in der Zeilenrichtung (X) erstreckt und die Initialisierungssignalleitung (VIN) elektrisch mit ersten Elektroden der zweiten Rücksetztransistoren (T12) in der Zeile der ersten Pixeleinheiten (220) verbunden ist;
sich orthographische Projektionen des zweiten Rücksetztransistors (T12) und jedes ersten Rücksetztransistors (T11) auf dem Substrat (210) zwischen einer orthographischen Projektion der Initialisierungssignalleitung (VIN), die elektrisch mit dem zweiten Rücksetztransistor (T12) auf dem Substrat (210) verbunden ist, und der orthographischen Projektion des Schaltungskörpers (2311-B) des ersten Subpixels (230B) auf dem Substrat (210) befinden; sich eine orthographische Projektion der Rücksetzsignalleitung (RST) auf dem Substrat (210) zwischen der orthographischen Projektion der Initialisierungssignalleitung (VIN) auf dem Substrat (210) und der orthographischen Projektion des Schaltungskörpers (2311-B) des ersten Subpixels (230B) auf dem Substrat (210) befindet.

6. Anzeigetafel (200) nach Anspruch 4 oder 5, wobei
das Substrat (210) einen ersten Anzeigebereich (A1) einschließt, und die Vielzahl von ersten Pixeleinheiten (220) in dem ersten Anzeigebereich (A1) angeordnet ist;
die Anzeigetafel (200) weiter eine Vielzahl von Signalleitungen umfasst, die sich zwischen dem Substrat (210) und der lichtemittierenden Vorrichtung (232) befinden; wobei
ein Abschnitt von mindestens einer Signalleitung, die sich in dem ersten Anzeigebereich (A1) befindet, eine Metallleitung (250) und eine transparente Verbindungsleitung (260) einschließt, die elektrisch miteinander verbunden sind; wobei sich mindestens ein Teil einer orthographischen Projektion der Metallleitung (250) auf dem Substrat (210) innerhalb einer orthographischen Projektion der lichtemittierenden Vorrichtung (232) auf dem Substrat (210) befindet.

7. Anzeigetafel (200) nach Anspruch 6, umfassend:
eine erste Gate-Metallschicht (Gate1) und eine erste transparente Verdrahtungsschicht (271), die sich beide zwischen dem Substrat (210) und der lichtemittierenden Vorrichtung (232) befinden, wobei die erste transparente Verdrahtungsschicht (271) auf einer vom Substrat (210) entfernten Seite der ersten Gate-Metallschicht (Gate1) angeordnet ist; wobei
die mindestens eine Signalleitung die Rücksetzsignalleitung (RST) einschließt, die Rücksetzsignalleitung (RST) sich in der Zeilenrichtung (X) erstreckt und die Rücksetzsignalleitung (RST) elektrisch mit Steuerelektroden von zweiten Rücksetztransistoren (T12) und Steuerelektroden von ersten Rücksetztransistoren (T11) in einer Zeile von ersten Pixeleinheiten (220) verbunden ist;
wobei sich eine Metallleitung (251) der Rücksetzsignalleitung (RST) in der ersten Gate-Metallschicht (Gate1) befindet und sich mindestens ein Teil einer orthographischen Projektion der Metallleitung (251) der Rücksetzsignalleitung (RST) auf dem Substrat (210) innerhalb der orthographischen Projektion der lichtemittierenden Vorrichtung (232) des ersten Subpixels (230B) auf dem Substrat (210) befindet; und
wobei sich eine transparente Verbindungsleitung (261) der Rücksetzsignalleitung (RST) in der ersten transparenten Leitungsschicht (271) befindet; sich eine orthographische Projektion der transparenten Verbindungsleitung (261) der Rücksetzsignalleitung (RST) auf dem Substrat (210) außerhalb der orthographischen Projektion der lichtemittierenden Vorrichtung (232) des zweiten Subpixels (230G) auf dem Substrat (210) und außerhalb der orthographischen Projektion der lichtemittierenden Vorrichtung (232) des dritten Subpixels (230R) auf dem Substrat (210) befindet; wobei die transparente Verbindungsleitung (261) der Rücksetzsignalleitung (RST) durch ein Durchgangsloch mit der Metallleitung (251) der Rücksetzsignalleitung (RST) verbunden ist.

8. Anzeigetafel (200) nach Anspruch 7, wobei
der Schaltungskörper (2311) der Pixeltreiberschaltung (231) weiter einen Schreibtransistor (T4), einen Kompensationstransistor (T2) und einen dritten Rücksetztransistor (T7) einschließt; wobei
die mindestens eine Signalleitung weiter mindestens eine Abtastsignalleitung (GT) einschließt und die Abtastsignalleitung (GT) mit Steuerelektroden von Schreibtransistoren (T4), Steuerelektroden von Kompensationstransistoren (T2) und Steuerelektroden von dritten Rücksetztransistoren (T7) aller Subpixel (230) in der Zeile von ersten Pixeleinheiten (220) verbunden ist;
wobei sich eine Metallleitung (252) der Abtastsignalleitung (GT) in der ersten Gate-Metallschicht (Gate1) befindet und sich mindestens ein Teil einer orthographischen Projektion der Metallleitung (252) der Abtastsignalleitung (GT) auf dem Substrat (210) innerhalb einer orthographischen Projektion der lichtemittierenden Vorrichtung (232) auf dem Substrat (210) befindet;
wobei sich eine transparente Verbindungsleitung (262) der Abtastsignalleitung (GT) in der ersten transparenten Verdrahtungsschicht (271) befindet und die transparente Verbindungsleitung (262) der Abtastsignalleitung (GT) durch ein Durchgangsloch mit der Metallleitung (252) der Abtastsignalleitung (GT) verbunden ist; und/oder
wobei der Schaltungskörper (2311) der Pixeltreiberschaltung (231) weiter einen ersten lichtemittierenden Steuertransistor (T5) und einen zweiten lichtemittierenden Steuertransistor (T6) einschließt; wobei
die mindestens eine Signalleitung weiter eine lichtemittierende Steuersignalleitung (EM) einschließt und die lichtemittierende Steuersignalleitung (EM) mit Steuerelektroden von ersten lichtemittierenden Steuertransistoren (T5) und Steuerelektroden von zweiten lichtemittierenden Steuertransistoren (T6) aller Subpixel (230) in der Zeile von ersten Pixeleinheiten (220) verbunden ist;
wobei sich eine Metallleitung (253) der lichtemittierenden Steuersignalleitung (EM) in der ersten Gate-Metallschicht (Gate1) befindet und sich mindestens ein Teil einer orthographischen Projektion der Metallleitung (253) der lichtemittierenden Steuersignalleitung (EM) auf dem Substrat (210) innerhalb der orthographischen Projektion der lichtemittierenden Vorrichtung (232) auf dem Substrat (210) befindet; und
wobei sich eine transparente Verbindungsleitung (263) der lichtemittierenden Steuersignalleitung (EM) in der ersten transparenten Verdrahtungsschicht (271) befindet und die transparente Verbindungsleitung (263) der lichtemittierenden Steuersignalleitung (EM) durch ein Durchgangsloch mit der Metallleitung (253) der lichtemittierenden Steuersignalleitung (EM) verbunden ist.

9. Anzeigetafel (200) nach einem der Ansprüche 6 bis 8, umfassend eine erste Source-Drain-Metallschicht (SD1) und eine erste transparente Verdrahtungsschicht (271), die sich beide zwischen dem Substrat (210) und der lichtemittierenden Vorrichtung (232) befinden, wobei die erste transparente Verdrahtungsschicht (271) auf einer vom Substrat (210) entfernten Seite der ersten Source-Drain-Metallschicht (SD1) angeordnet ist; wobei
die mindestens eine Signalleitung eine Initialisierungssignalleitung (VIN) einschließt, wobei die Initialisierungssignalleitung (VIN) elektrisch mit ersten Elektroden von zweiten Rücksetztransistoren (T12) in einer Zeile von ersten Pixeleinheiten (220) verbunden ist;
wobei sich eine Metallleitung (254) der Initialisierungssignalleitung (VIN) in der ersten Source-Drain-Metallschicht (SD1) befindet und sich mindestens ein Teil einer orthographischen Projektion der Metallleitung (254) der Initialisierungssignalleitung (VIN) auf dem Substrat (210) innerhalb der orthographischen Projektion der lichtemittierenden Vorrichtung (232) des ersten Subpixels (230B) auf dem Substrat (210) befindet;
wobei sich eine transparente Verbindungsleitung (264) der Initialisierungssignalleitung (VIN) in der ersten transparenten Verdrahtungsschicht (271) befindet; sich eine orthographische Projektion der transparenten Verbindungsleitung (264) der Initialisierungssignalleitung (VIN) auf dem Substrat (210) außerhalb der orthographischen Projektion der lichtemittierenden Vorrichtung (232) des zweiten Subpixels (230G) auf dem Substrat (210) und außerhalb der orthographischen Projektion der lichtemittierenden Vorrichtung (232) des dritten Subpixels (230R) auf dem Substrat (210) befindet; wobei die transparente Verbindungsleitung (264) der Initialisierungssignalleitung (VIN) durch ein Durchgangsloch mit der Metallleitung (254) der Initialisierungssignalleitung (VIN) verbunden ist.

10. Anzeigetafel (200) nach einem der Ansprüche 6 bis 9, umfassend eine zweite Gate-Metallschicht (Gate1), eine zweite Source-Drain-Metallschicht (SD2) und eine zweite transparente Verdrahtungsschicht (272), die sich zwischen dem Substrat (210) und der lichtemittierenden Vorrichtung (232) befinden; wobei sich die zweite Source-Drain-Metallschicht (SD2) auf einer von dem Substrat (210) entfernten Seite der zweiten Gate-Metallschicht (Gate1) befindet und die zweite transparente Verdrahtungsschicht (272) sich auf einer von der zweiten Gate-Metallschicht (Gate1) entfernten Seite der zweiten Source-Drain-Metallschicht (SD2) befindet; wobei
der Schaltungskörper (2311) der Pixeltreiberschaltung (231) weiter einen Kondensator (Cst) einschließt und eine erste Platte (Cst1) des Kondensators (Cst) sich in der zweiten Gate-Metallschicht (Gate1) befindet;
wobei die mindestens eine Signalleitung eine erste Leistungssignalleitung (VDD1) einschließt, die erste Leistungssignalleitung (VDD1) sich in der Spaltenrichtung (Y) erstreckt und die erste Leistungssignalleitung (VDD1) mit ersten Platten (Cst1) von Kondensatoren (Cst) von zweiten Subpixeln (230G) und ersten Platten von Kondensatoren (Cst) von dritten Subpixeln (230R) in einer Spalte von ersten Pixeleinheiten (220) verbunden ist;
wobei sich Metallleitungen (255) der ersten Leistungssignalleitung (VDD1) in der zweiten Source-Drain-Metallschicht (SD2) befinden und sich mindestens ein Teil der orthographischen Projektionen der Metallleitungen (255) der ersten Leistungssignalleitung (VDD1) auf dem Substrat (210) innerhalb der orthographischen Projektionen der lichtemittierenden Vorrichtung (232) des zweiten Subpixels (230G) und der lichtemittierenden Vorrichtung (232) des dritten Subpixels (230R) auf dem Substrat (210) befindet;
wobei sich eine transparente Verbindungsleitung (265) der ersten Leistungssignalleitung (VDD1) in der zweiten transparenten Verdrahtungsschicht (272) befindet und die transparente Verbindungsleitung (265) der ersten Leistungssignalleitung (VDD1) durch Durchgangslöcher mit den Metallleitungen (255) der ersten Leistungssignalleitung (VDD1) verbunden ist.

11. Anzeigetafel (200) nach Anspruch 10, wobei
die mindestens eine Signalleitung weiter eine zweite Leistungssignalleitung (VDD2) einschließt, die zweite Leistungssignalleitung (VDD2) sich in der Spaltenrichtung (Y) erstreckt und die zweite Leistungssignalleitung (VDD2) mit ersten Platten (Cst1) von Kondensatoren (Cst) von ersten Subpixeln (230B) in der Spalte von ersten Pixeleinheiten (220) verbunden ist;
wobei sich eine Metallleitung (256) der zweiten Leistungssignalleitung (VDD2) in der zweiten Source-Drain-Metallschicht (SD2) befindet und eine orthographische Projektion der Metallleitung (256) der zweiten Leistungssignalleitung (VDD2) auf dem Substrat (210) sich mindestens teilweise innerhalb der orthographischen Projektion der lichtemittierenden Vorrichtung (232) des ersten Subpixels (230B) auf dem Substrat (210) befindet;
wobei sich eine transparente Verbindungsleitung (266) der zweiten Leistungssignalleitung (VDD2) in der zweiten transparenten Verdrahtungsschicht (272) befindet und die transparente Verbindungsleitung (266) der zweiten Leistungssignalleitung (VDD2) durch ein Durchgangsloch mit der Metallleitung (256) der zweiten Leistungssignalleitung (VDD2) verbunden ist.

12. Anzeigetafel (200) nach Anspruch 10 oder 11, weiter umfassend:
eine Vielzahl von Datenleitungen (DT), die sich jeweils in der Spaltenrichtung (Y) erstrecken, wobei sich orthographische Projektionen von Abschnitten der Vielzahl von Datenleitungen (DT), die sich in dem ersten Anzeigebereich (A1) auf dem Substrat (210) befindet, außerhalb einer orthographischen Projektion einer lichtemittierenden Vorrichtung (232) eines beliebigen Subpixels auf dem Substrat (210) befinden, ein Abschnitt von mindestens einer Datenleitung (DT), die sich in dem ersten Anzeigebereich (A1) befindet, sich in der zweiten transparenten Verdrahtungsschicht (272) befindet; und
wobei der Schaltungskörper (2311) der Pixeltreiberschaltung (231) weiter einen Schreibtransistor (T4) einschließt; wobei in der ersten Pixeleinheit (220) eine erste Elektrode eines Schreibtransistors (T4) des ersten Subpixels (230B), eine erste Elektrode eines Schreibtransistors (T4) des zweiten Subpixels (230G) und eine erste Elektrode eines Schreibtransistors (T4) des dritten Subpixels (230R) jeweils mit unterschiedlichen Datenleitungen (DT) verbunden sind.

13. Anzeigetafel (200) nach Anspruch 12, wobei
der Abschnitt der mindestens einen Datenleitung (DT), der sich in dem ersten Anzeigebereich (A1) befindet, ein transparentes Leitungssegment (27) ist; in einer gleichen Spalte der ersten Pixeleinheiten (220) eine orthographische Projektion eines transparenten Leitungssegments (27-B) einer Datenleitung (DT-B), die elektrisch mit einem Schreibtransistor (T4) eines ersten Subpixels (230B) auf dem Substrat (210) verbunden ist, sich auf einer Seite einer orthographischen Projektion eines Schaltungskörpers (2311-B) des ersten Subpixels (230B) auf dem Substrat (210) entfernt von einer orthographischen Projektion eines Schaltkreiskörpers (2311-G) eines zweiten Subpixels (230G) auf dem Substrat (210) befindet, und wobei sich eine orthographische Projektion einer lichtemittierenden Vorrichtung (232) des zweiten Subpixels (230G) auf dem Substrat (210) und eine orthographische Projektion einer lichtemittierenden Vorrichtung (232) eines dritten Subpixels (230R) auf dem Substrat (210) zwischen einer orthographischen Projektion eines transparenten Leitungssegments (27-G) einer Datenleitung (DT-G), die elektrisch mit einem Schreibtransistor (T4) des zweiten Subpixels (230G) auf dem Substrat (210) verbunden ist, und einer orthographischen Projektion eines transparenten Leitungssegments (27-R) einer Datenleitung (DT-R), die elektrisch mit einem Schreibtransistor (T4) des dritten Subpixels (230R) auf dem Substrat (210) verbunden ist, befinden; oder
wobei der Abschnitt der mindestens einen Datenleitung (DT), der sich in dem ersten Anzeigebereich (A1) befindet, ein transparentes Leitungssegment (27) ist; wobei sich in einer gleichen Spalte von ersten Pixeleinheiten (220) eine orthographische Projektion eines transparenten Leitungssegments (27-B) einer Datenleitung (DT-B), die elektrisch mit einem Schreibtransistor (T4) eines ersten Subpixels (230B) auf dem Substrat (210) verbunden ist, auf einer Seite einer orthographischen Projektion eines Schaltungskörpers (2311-B) des ersten Subpixels (230B) auf dem Substrat (210) entfernt von einer orthographischen Projektion eines Schaltungskörpers (2311-G) eines zweiten Subpixels (230G) auf dem Substrat (210) befindet, und wobei sich eine orthographische Projektion einer lichtemittierenden Vorrichtung (232) des zweiten Subpixels (230G) auf dem Substrat (210) und eine orthographische Projektion einer lichtemittierenden Vorrichtung (232) eines dritten Subpixels (230R) auf dem Substrat (210) zwischen einer orthographischen Projektion eines transparenten Leitungssegments (27-G) einer Datenleitung (DT-G), die elektrisch mit einem Schreibtransistor (T4) des zweiten Subpixels (230G) auf dem Substrat (210) verbunden ist, und einer orthographischen Projektion eines transparenten Zeilensegments (27-R) einer Datenleitung (DT-R), die elektrisch mit einem Schreibtransistor (T4) des dritten Subpixels (230R) auf dem Substrat (210) verbunden ist, befinden; wobei der Schaltungskörper (2311) der Pixeltreiberschaltung (231) weiter einen Kompensationstransistor (T2) und einen dritten Rücksetztransistor (T7) einschließt; wobei
in der ersten Pixeleinheit (220) ein dritter Rücksetztransistor (T7), ein Kompensationstransistor (T2) und ein Schreibtransistor (T4) des ersten Subpixels (230B) nacheinander von einem Schaltungskörper (2311-G) des zweiten Subpixels (230G) entfernt sind; wobei ein Schreibtransistor (T4), ein Kompensationstransistor (T2) und ein dritter Rücksetztransistor (T7) des zweiten Subpixels (230G) nacheinander in einer ersten Einstellrichtung (D) angeordnet sind; wobei ein Schreibtransistor (T4), ein Kompensationstransistor (T2) und ein dritter Rücksetztransistor (T7) des dritten Subpixels (230R) nacheinander in einer entgegengesetzten Richtung der ersten Einstellrichtung (D) angeordnet sind.

14. Anzeigetafel (200) nach einem der Ansprüche 1 bis 13, wobei
die lichtemittierende Vorrichtung (232) eine Anode (AND1), eine lichtemittierende Schicht (EL) und eine Kathode (CTD1) einschließt, die Anode (AND1) elektrisch mit der Pixeltreiberschaltung (231) verbunden ist, die lichtemittierende Schicht (EL) auf einer vom Substrat (210) entfernten Seite der Anode (AND1) angeordnet ist und die Kathode (CTD1) auf einer vom Substrat (210) entfernten Seite der Anode (AND1) angeordnet ist; wobei
sich die orthographische Projektion des ersten Rücksetztransistors (T11-G) des zweiten Subpixels (230G) und/oder des ersten Rücksetztransistors (T11-R) des dritten Subpixels (230R) auf dem Substrat (210) innerhalb einer orthographischen Projektion einer Anode (AND-B) des ersten Subpixels (230B) auf dem Substrat (210) befindet; und/oder
wobei die Anzeigetafel (200) umfasst: einen ersten Anzeigebereich (A1) und einen zweiten Anzeigebereich (A2), wobei der erste Anzeigebereich (A1) mit den ersten Pixeleinheiten (220) bereitgestellt ist; wobei
der zweite Anzeigebereich (A2) mit einer Vielzahl von zweiten Pixeleinheiten (290) bereitgestellt ist, wobei die Vielzahl von zweiten Pixeleinheiten (290) in einer Vielzahl von Zeilen und einer Vielzahl von Spalten angeordnet ist; wobei eine zweite Pixeleinheit (290) eine Vielzahl von Subpixeln (291) einschließt und die Dichte von Subpixeln (230) in dem ersten Anzeigebereich (A1) gleich der Dichte von Subpixeln (291) in dem zweiten Anzeigebereich (A2) ist;
wobei eine Fläche einer lichtemittierenden Vorrichtung (232) eines Subpixels (230) im ersten Anzeigebereich (A1) das 0,4- bis 0,6-fache einer Fläche einer lichtemittierenden Vorrichtung (232) eines Subpixels (291) der gleichen Farbe im zweiten Anzeigebereich (A2) beträgt.

15. Anzeigeeinrichtung (100), umfassend:
die Anzeigetafel (200) nach einem der Ansprüche 1 bis 14.

## Revendications

1. Panneau d'affichage (200), comprenant :
un substrat (210) ; et
une pluralité de premières unités de pixel (220) situées sur un côté du substrat (210) et agencées en une pluralité de rangées et une pluralité de colonnes ; dans lequel une première unité de pixel (220) inclut une pluralité de sous-pixels (230), un sous-pixel (230) inclut un circuit d'attaque de pixel (231) et un dispositif électroluminescent (232) ; le dispositif électroluminescent (232) est situé sur un côté du circuit d'attaque de pixel (231) à distance du substrat (210) et est électriquement connecté au circuit d'attaque de pixel (231) ; le circuit d'attaque de pixel (231) inclut un premier transistor de réinitialisation (T11) ;
la pluralité de sous-pixels (230) inclut un premier sous-pixel (230B), un deuxième sous-pixel (230G) et un troisième sous-pixel (230R) ; une superficie d'un dispositif électroluminescent (232) du premier sous-pixel (230B) est supérieure à une superficie d'un dispositif électroluminescent (232) du deuxième sous-pixel (230G) et supérieure à une superficie d'un dispositif électroluminescent (232) du troisième sous-pixel (230R) ; et
**caractérisé en ce que**
une projection orthographique d'un premier transistor de réinitialisation (T11-G) du deuxième sous-pixel (230G) et/ou d'un premier transistor de réinitialisation (T11-R) du troisième sous-pixel (230R) sur le substrat (210) est située à l'intérieur d'une projection orthographique du dispositif électroluminescent (232) du premier sous-pixel (230B) sur le substrat (210).

2. Panneau d'affichage (200) selon la revendication 1, dans lequel
des projections orthographiques du premier transistor de réinitialisation (T11-B) du premier sous-pixel (230B), du premier transistor de réinitialisation (T11-G) du deuxième sous-pixel (230G) et du premier transistor de réinitialisation (T11-R) du troisième sous-pixel (230R) sur le substrat (210) sont toutes situées à l'intérieur de la projection orthographique du dispositif électroluminescent (232) du premier sous-pixel (230B) sur le substrat (210) ; et/ou
au moins deux parmi le premier transistor de réinitialisation (T11-B) du premier sous-pixel (230B), le premier transistor de réinitialisation (T11-G) du deuxième sous-pixel (230G), et le premier transistor de réinitialisation (T11-R) du troisième sous-pixel (230R) sont un même transistor.

3. Panneau d'affichage (200) selon l'une quelconque des revendications 1 à 2, dans lequel
le circuit d'attaque de pixel (231) inclut en outre un deuxième transistor de réinitialisation (T12) ; un deuxième transistor de réinitialisation (T12) du premier sous-pixel (230B), un deuxième transistor de réinitialisation (T12) du deuxième sous-pixel (230G) et un deuxième transistor de réinitialisation (T12) du troisième sous-pixel (230R) sont un même transistor ;
une projection orthographique du deuxième transistor de réinitialisation (T12) sur le substrat (210) est située à l'intérieur de la projection orthographique du dispositif électroluminescent (232) du premier sous-pixel (230B) sur le substrat (210) ; le deuxième transistor de réinitialisation (T12) est connecté à n'importe quel premier transistor de réinitialisation (T11) en série ;
le panneau d'affichage (200) comprend en outre une ligne de signal de réinitialisation (RST) et une ligne de signal d'initialisation (VIN) ; dans lequel une électrode de commande de chaque premier transistor de réinitialisation (T11) et une électrode de commande du deuxième transistor de réinitialisation (T12) sont toutes électriquement connectées à la ligne de signal de réinitialisation (RST) ;
une première électrode du deuxième transistor de réinitialisation (T12) est connectée électriquement à la ligne de signal d'initialisation (VIN), et une seconde électrode du deuxième transistor de réinitialisation (T12) est connectée électriquement à une première électrode de chaque premier transistor de réinitialisation (T11) ; et
le circuit d'attaque de pixel (231) inclut en outre un transistor d'attaque (T3), et une électrode de commande du transistor d'attaque (T3) de chaque circuit d'attaque de pixel (231) est électriquement connectée à une seconde électrode de chaque premier transistor de réinitialisation (T11).

4. Panneau d'affichage (200) selon la revendication 3, dans lequel
le dispositif électroluminescent (232) du deuxième sous-pixel (230G) et le dispositif électroluminescent (232) du troisième sous-pixel (230R) sont agencés espacés dans une direction de colonne (Y) ; le dispositif électroluminescent (232) du premier sous-pixel (230B) est situé dans une colonne adjacente à une colonne où le dispositif électroluminescent (232) du deuxième sous-pixel (230G) et le dispositif électroluminescent (232) du troisième sous-pixel (230R) sont situés, et le dispositif électroluminescent (232) du premier sous-pixel (230B) couvre une région d'espace entre le dispositif électroluminescent (232) du deuxième sous-pixel (230G) et le dispositif électroluminescent (232) du troisième sous-pixel (230R) ;
le circuit d'attaque de pixel (231) inclut en outre un corps de circuit (2311), le corps de circuit (2311) inclut le transistor d'attaque (T3) ; une projection orthographique d'un corps de circuit (2311-B) du premier sous-pixel (230B) sur le substrat (210) est située à l'intérieur de la projection orthographique du dispositif électroluminescent (232) du premier sous-pixel (230B) sur le substrat (210), une projection orthographique d'un corps de circuit (2311-G) du deuxième sous-pixel (230G) sur le substrat (210) est située à l'intérieur d'une projection orthographique du dispositif électroluminescent (232) du deuxième sous-pixel (230G) sur le substrat (210), et une projection orthographique d'un corps de circuit (2311-R) du troisième sous-pixel (230R) sur le substrat (210) est à l'intérieur d'une projection orthographique du dispositif électroluminescent (232) du troisième sous-pixel (230R) sur le substrat (210) ; et
le deuxième transistor de réinitialisation (T12), le premier transistor de réinitialisation (T11-R) du troisième sous-pixel (230R) et le premier transistor de réinitialisation (T11-G) du deuxième sous-pixel (230G) sont situés sur un côté du premier transistor de réinitialisation (T11-B) du premier sous-pixel (230B) à proximité du corps de circuit (2311-R) du troisième sous-pixel (230R), et sont agencés en séquence à distance du corps de circuit (2311-R) du troisième sous-pixel (230R).

5. Panneau d'affichage (200) selon la revendication 4, dans lequel
la ligne de signal de réinitialisation (RST) s'étend dans une direction de rangée (X), et la ligne de signal de réinitialisation (RST) est électriquement connectée à des électrodes de commande de deuxièmes transistors de réinitialisation (T12) et à des électrodes de commande de premiers transistors de réinitialisation (T11) dans une rangée de premières unités de pixel (220) ;
la ligne de signal d'initialisation (VIN) s'étend dans la direction de rangée (X), et la ligne de signal d'initialisation (VIN) est électriquement connectée à des premières électrodes des deuxièmes transistors de réinitialisation (T12) dans la rangée de premières unités de pixel (220) ;
des projections orthographiques du deuxième transistor de réinitialisation (T12) et de chaque premier transistor de réinitialisation (T11) sur le substrat (210) sont situées entre une projection orthographique de la ligne de signal d'initialisation (VIN) connectée électriquement au deuxième transistor de réinitialisation (T12) sur le substrat (210) et la projection orthographique du corps de circuit (2311-B) du premier sous-pixel (230B) sur le substrat (210) ;
une projection orthographique de la ligne de signal de réinitialisation (RST) sur le substrat (210) est située entre la projection orthographique de la ligne de signal d'initialisation (VIN) sur le substrat (210) et la projection orthographique du corps de circuit (2311-B) du premier sous-pixel (230B) sur le substrat (210).

6. Panneau d'affichage (200) selon la revendication 4 ou 5, dans lequel
le substrat (210) inclut une première région d'affichage (A1), et la pluralité de premières unités de pixel (220) sont situées dans la première région d'affichage (A1) ;
le panneau d'affichage (200) comprend en outre une pluralité de lignes de signal situées entre le substrat (210) et le dispositif électroluminescent (232) ; dans lequel
une partie d'au moins une ligne de signal située dans la première région d'affichage (A1) inclut une ligne métallique (250) et une ligne de connexion transparente (260) qui sont électriquement connectées l'une à l'autre ; au moins une partie d'une projection orthographique de la ligne métallique (250) sur le substrat (210) est située à l'intérieur d'une projection orthographique du dispositif électroluminescent (232) sur le substrat (210).

7. Panneau d'affichage (200) selon la revendication 6, comprenant :
une première couche métallique de grille (Gate1) et une première couche de câblage transparente (271) toutes deux situées entre le substrat (210) et le dispositif électroluminescent (232), la première couche de câblage transparente (271) étant située sur un côté de la première couche métallique de grille (Gate1) à distance du substrat (210) ; dans lequel
l'au moins une ligne de signal inclut la ligne de signal de réinitialisation (RST), la ligne de signal de réinitialisation (RST) s'étend dans la direction de rangée (X), et la ligne de signal de réinitialisation (RST) est électriquement connectée à des électrodes de commande de deuxièmes transistors de réinitialisation (T12) et à des électrodes de commande de premiers transistors de réinitialisation (T11) dans une rangée de premières unités de pixel (220) ;
une ligne métallique (251) de la ligne de signal de réinitialisation (RST) est située dans la première couche métallique de grille (Gate1), et au moins une partie d'une projection orthographique de la ligne métallique (251) de la ligne de signal de réinitialisation (RST) sur le substrat (210) est située à l'intérieur de la projection orthographique du dispositif électroluminescent (232) du premier sous-pixel (230B) sur le substrat (210) ; et
une ligne de connexion transparente (261) de la ligne de signal de réinitialisation (RST) est située dans la première couche de ligne transparente (271) ; une projection orthographique de la ligne de connexion transparente (261) de la ligne de signal de réinitialisation (RST) sur le substrat (210) est située à l'extérieur de la projection orthographique du dispositif électroluminescent (232) du deuxième sous-pixel (230G) sur le substrat (210), et à l'extérieur de la projection orthographique du dispositif électroluminescent (232) du troisième sous-pixel (230R) sur le substrat (210) ; la ligne de connexion transparente (261) de la ligne de signal de réinitialisation (RST) est connectée à la ligne métallique (251) de la ligne de signal de réinitialisation (RST) par l'intermédiaire d'un trou d'interconnexion.

8. Panneau d'affichage (200) selon la revendication 7, dans lequel
le corps de circuit (2311) du circuit d'attaque de pixel (231) inclut en outre un transistor d'écriture (T4), un transistor de compensation (T2) et un troisième transistor de réinitialisation (T7) ; dans lequel
l'au moins une ligne de signal inclut en outre une ligne de signal de balayage (GT), et la ligne de signal de balayage (GT) est connectée à des électrodes de commande de transistors d'écriture (T4), à des électrodes de commande de transistors de compensation (T2) et à des électrodes de commande de troisièmes transistors de réinitialisation (T7) de tous les sous-pixels (230) dans la rangée de premières unités de pixel (220) ;
une ligne métallique (252) de la ligne de signal de balayage (GT) est située dans la première couche métallique de grille (Gate1), et au moins une partie d'une projection orthographique de la ligne métallique (252) de la ligne de signal de balayage (GT) sur le substrat (210) est située à l'intérieur d'une projection orthographique du dispositif électroluminescent (232) sur le substrat (210) ;
une ligne de connexion transparente (262) de la ligne de signal de balayage (GT) est située dans la première couche de câblage transparente (271), et la ligne de connexion transparente (262) de la ligne de signal de balayage (GT) est connectée à la ligne métallique (252) de la ligne de signal de balayage (GT) par l'intermédiaire d'un trou d'interconnexion ; et/ou
le corps de circuit (2311) du circuit d'attaque de pixel (231) inclut en outre un premier transistor de commande d'émission de lumière (T5) et un deuxième transistor de commande d'émission de lumière (T6) ; dans lequel
l'au moins une ligne de signal inclut en outre une ligne de signal de commande d'émission de lumière (EM), et la ligne de signal de commande d'émission de lumière (EM) est connectée à des électrodes de commande de premiers transistors de commande d'émission de lumière (T5) et à des électrodes de commande de deuxièmes transistors de commande d'émission de lumière (T6) de tous les sous-pixels (230) dans la rangée de premières unités de pixel (220) ;
une ligne métallique (253) de la ligne de signal de commande d'émission de lumière (EM) est située dans la première couche métallique de grille (Gate1), et au moins une partie d'une projection orthographique de la ligne métallique (253) de la ligne de signal de commande d'émission de lumière (EM) sur le substrat (210) est située à l'intérieur de la projection orthographique du dispositif électroluminescent (232) sur le substrat (210) ; et
une ligne de connexion transparente (263) de la ligne de signal de commande d'émission de lumière (EM) est située dans la première couche de câblage transparente (271), et la ligne de connexion transparente (263) de la ligne de signal de commande d'émission de lumière (EM) est connectée à la ligne métallique (253) de la ligne de signal de commande d'émission de lumière (EM) par l'intermédiaire d'un trou d'interconnexion.

9. Panneau d'affichage (200) selon l'une quelconque des revendications 6 à 8, comprenant une première couche métallique source-drain (SD1) et une première couche de câblage transparente (271) toutes deux situées entre le substrat (210) et le dispositif électroluminescent (232), la première couche de câblage transparente (271) étant située sur un côté de la première couche métallique source-drain (SD1) à distance du substrat (210) ; dans lequel
l'au moins une ligne de signal inclut une ligne de signal d'initialisation (VIN), la ligne de signal d'initialisation (VIN) est connectée électriquement à des premières électrodes de deuxièmes transistors de réinitialisation (T12) dans une rangée de premières unités de pixel (220) ;
une ligne métallique (254) de la ligne de signal d'initialisation (VIN) est située dans la première couche métallique source-drain (SD1), et au moins une partie d'une projection orthographique de la ligne métallique (254) de la ligne de signal d'initialisation (VIN) sur le substrat (210) est située à l'intérieur de la projection orthographique du dispositif électroluminescent (232) du premier sous-pixel (230B) sur le substrat (210) ;
une ligne de connexion transparente (264) de la ligne de signal d'initialisation (VIN) est située dans la première couche de câblage transparente (271) ; une projection orthographique de la ligne de connexion transparente (264) de la ligne de signal d'initialisation (VIN) sur le substrat (210) est située à l'extérieur de la projection orthographique du dispositif électroluminescent (232) du deuxième sous-pixel (230G) sur le substrat (210) et à l'extérieur de la projection orthographique du dispositif électroluminescent (232) du troisième sous-pixel (230R) sur le substrat (210) ; la ligne de connexion transparente (264) de la ligne de signal d'initialisation (VIN) est connectée à la ligne métallique (254) de la ligne de signal d'initialisation (VIN) par l'intermédiaire d'un trou d'interconnexion.

10. Panneau d'affichage (200) selon l'une quelconque des revendications 6 à 9, comprenant une seconde couche métallique de grille (Gate1), une seconde couche métallique source-drain (SD2) et une seconde couche de câblage transparente (272) situées entre le substrat (210) et le dispositif électroluminescent (232) ; la seconde couche métallique source-drain (SD2) étant située sur un côté de la seconde couche métallique de grille (Gate1) à distance du substrat (210), et la seconde couche de câblage transparente (272) étant située sur un côté de la seconde couche métallique source-drain (SD2) à distance de la seconde couche métallique de grille (Gate1) ; dans lequel
le corps de circuit (2311) du circuit d'attaque de pixel (231) inclut en outre un condensateur (Cst), et une première plaque (Cst1) du condensateur (Cst) est située dans la seconde couche métallique de grille (Gate1) ;
l'au moins une ligne de signal inclut une première ligne de signal de puissance (VDD1), la première ligne de signal de puissance (VDD1) s'étend dans la direction de colonne (Y), et la première ligne de signal de puissance (VDD1) est connectée à des premières plaques (Cst1) de condensateurs (Cst) de deuxièmes sous-pixels (230G) et à des premières plaques de condensateurs (Cst) de troisièmes sous-pixels (230R) dans une colonne de premières unités de pixel (220) ;
des lignes métalliques (255) de la première ligne de signal de puissance (VDD1) sont situées dans la seconde couche métallique source-drain (SD2), et au moins une partie de projections orthographiques des lignes métalliques (255) de la première ligne de signal de puissance (VDD1) sur le substrat (210) est située à l'intérieur des projections orthographiques du dispositif électroluminescent (232) du deuxième sous-pixel (230G) et du dispositif électroluminescent (232) du troisième sous-pixel (230R) sur le substrat (210) ;
une ligne de connexion transparente (265) de la première ligne de signal de puissance (VDD1) est située dans la seconde couche de câblage transparente (272), et la ligne de connexion transparente (265) de la première ligne de signal de puissance (VDD1) est connectée aux lignes métalliques (255) de la première ligne de signal de puissance (VDD1) par l'intermédiaire de trous d'interconnexion.

11. Panneau d'affichage (200) selon la revendication 10, dans lequel
l'au moins une ligne de signal inclut en outre une seconde ligne de signal de puissance (VDD2), la seconde ligne de signal de puissance (VDD2) s'étend dans la direction de colonne (Y), et les secondes lignes de signal de puissance (VDD2) sont connectées à des premières plaques (Cst1) de condensateurs (Cst) de premiers sous-pixels (230B) dans la colonne de premières unités de pixel (220) ;
une ligne métallique (256) de la seconde ligne de signal de puissance (VDD2) est située dans la seconde couche métallique source-drain (SD2), et une projection orthographique de la ligne métallique (256) de la seconde ligne de signal de puissance (VDD2) sur le substrat (210) est au moins partiellement située à l'intérieur de la projection orthographique du dispositif électroluminescent (232) du premier sous-pixel (230B) sur le substrat (210) ;
une ligne de connexion transparente (266) de la seconde ligne de signal de puissance (VDD2) est située dans la seconde couche de câblage transparente (272), et la ligne de connexion transparente (266) de la seconde ligne de signal de puissance (VDD2) est connectée à la ligne métallique (256) de la seconde ligne de signal de puissance (VDD2) par l'intermédiaire d'un trou d'interconnexion.

12. Panneau d'affichage (200) selon la revendication 10 ou 11, comprenant en outre :
une pluralité de lignes de données (DT) s'étendant chacune dans la direction de colonne (Y), dans lequel des projections orthographiques de parties de la pluralité de lignes de données (DT) situées dans la première région d'affichage (A1) sur le substrat (210) sont situées à l'extérieur d'une projection orthographique d'un dispositif électroluminescent (232) de n'importe quel sous-pixel sur le substrat (210), une partie d'au moins une ligne de données (DT) située dans la première région d'affichage (A1) est située dans la seconde couche de câblage transparente (272) ; et
le corps de circuit (2311) du circuit d'attaque de pixel (231) inclut en outre un transistor d'écriture (T4) ; dans la première unité de pixel (220), une première électrode d'un transistor d'écriture (T4) du premier sous-pixel (230B), une première électrode d'un transistor d'écriture (T4) du deuxième sous-pixel (230G), et une première électrode d'un transistor d'écriture (T4) du troisième sous-pixel (230R) sont respectivement connectées à différentes lignes de données (DT).

13. Panneau d'affichage (200) selon la revendication 12, dans lequel
la partie de l'au moins une ligne de données (DT) située dans la première région d'affichage (A1) est un segment de ligne transparent (27) ; dans une même colonne de premières unités de pixel (220), une projection orthographique d'un segment de ligne transparent (27-B) d'une ligne de données (DT-B) connectée électriquement à un transistor d'écriture (T4) d'un premier sous-pixel (230B) sur le substrat (210) est située sur un côté d'une projection orthographique d'un corps de circuit (2311-B) du premier sous-pixel (230B) sur le substrat (210) à distance d'une projection orthographique d'un corps de circuit (2311-G) d'un deuxième sous-pixel (230G) sur le substrat (210), et une projection orthographique d'un dispositif électroluminescent (232) du deuxième sous-pixel (230G) sur le substrat (210) et une projection orthographique d'un dispositif électroluminescent (232) d'un troisième sous-pixel (230R) sur le substrat (210) sont situées entre une projection orthographique d'un segment de ligne transparent (27-G) d'une ligne de données (DT-G) connectée électriquement à un transistor d'écriture (T4) du deuxième sous-pixel (230G) sur le substrat (210) et une projection orthographique d'un segment de ligne transparent (27-R) d'une ligne de données (DT-R) connectée électriquement à un transistor d'écriture (T4) du troisième sous-pixel (230R) sur le substrat (210) ; ou
la partie de l'au moins une ligne de données (DT) située dans la première région d'affichage (A1) est un segment de ligne transparent (27) ; dans une même colonne de premières unités de pixel (220), une projection orthographique d'un segment de ligne transparent (27-B) d'une ligne de données (DT-B) connectée électriquement à un transistor d'écriture (T4) d'un premier sous-pixel (230B) sur le substrat (210) est située sur un côté d'une projection orthographique d'un corps de circuit (2311-B) du premier sous-pixel (230B) sur le substrat (210) à distance d'une projection orthographique d'un corps de circuit (2311-G) d'un deuxième sous-pixel (230G) sur le substrat (210), et une projection orthographique d'un dispositif électroluminescent (232) du deuxième sous-pixel (230G) sur le substrat (210) et une projection orthographique d'un dispositif électroluminescent (232) d'un troisième sous-pixel (230R) sur le substrat (210) sont situées entre une projection orthographique d'un segment de ligne transparent (27-G) d'une ligne de données (DT-G) connectée électriquement à un transistor d'écriture (T4) du deuxième sous-pixel (230G) sur le substrat (210) et une projection orthographique d'un segment de ligne transparent (27-R) d'une ligne de données (DT-R) connectée électriquement à un transistor d'écriture (T4) du troisième sous-pixel (230R) sur le substrat (210) ; le corps de circuit (2311) du circuit d'attaque de pixel (231) inclut en outre un transistor de compensation (T2) et un troisième transistor de réinitialisation (T7) ; dans lequel
dans la première unité de pixel (220), un troisième transistor de réinitialisation (T7), un transistor de compensation (T2) et un transistor d'écriture (T4) du premier sous-pixel (230B) sont séquentiellement à distance d'un corps de circuit (2311-G) du deuxième sous-pixel (230G) ;
un transistor d'écriture (T4), un transistor de compensation (T2) et un troisième transistor de réinitialisation (T7) du deuxième sous-pixel (230G) sont agencés séquentiellement dans une première direction de consigne (D) ; un transistor d'écriture (T4), un transistor de compensation (T2) et un troisième transistor de réinitialisation (T7) du troisième sous-pixel (230R) sont agencés séquentiellement dans une direction opposée à la première direction de consigne (D).

14. Panneau d'affichage (200) selon l'une quelconque des revendications 1 à 13, dans lequel
le dispositif électroluminescent (232) inclut une anode (AND1), une couche électroluminescente (EL) et une cathode (CTD1), l'anode (AND1) est électriquement connectée au circuit d'attaque de pixel (231), la couche électroluminescente (EL) est située sur un côté de l'anode (AND1) à distance du substrat (210), et la cathode (CTD1) est située sur un côté de l'anode (AND1) à distance du substrat (210) ; dans lequel
la projection orthographique du premier transistor de réinitialisation (T11-G) du deuxième sous-pixel (230G) et/ou du premier transistor de réinitialisation (T11-R) du troisième sous-pixel (230R) sur le substrat (210) est située à l'intérieur d'une projection orthographique d'une anode (AND-B) du premier sous-pixel (230B) sur le substrat (210) ; et/ou
le panneau d'affichage (200) comprend : une première région d'affichage (A1) et une seconde région d'affichage (A2), la première région d'affichage (A1) étant pourvue des premières unités de pixel (220) ; dans lequel
la seconde région d'affichage (A2) est pourvue d'une pluralité de secondes unités de pixel (290), la pluralité de secondes unités de pixel (290) sont agencées en une pluralité de rangées et une pluralité de colonnes ; une seconde unité de pixel (290) inclut une pluralité de sous-pixels (291), et la densité de sous-pixels (230) dans la première région d'affichage (A1) est égale à la densité de sous-pixels (291) dans la seconde région d'affichage (A2) ;
une superficie d'un dispositif électroluminescent (232) d'un sous-pixel (230) dans la première région d'affichage (A1) est de 0,4 à 0,6 fois une superficie d'un dispositif électroluminescent (232) d'un sous-pixel (291) d'une même couleur dans la seconde région d'affichage (A2).

15. Appareil d'affichage (100), comprenant :
le panneau d'affichage (200) selon l'une quelconque des revendications 1 à 14.
